# EUROPEAN PATENT APPLICATION

(11) **EP 4 325 287 A1**
(43) Date of publication of application: **21.02.2024**
(21) Application number: 22787894.9
(22) Date of filing: 04.03.2022
(51) Int. Cl.: G03B 11/00, H01L 27/146, H04N 5/369, G02B 5/18, G02B 5/20, G02B 5/28, G02B 5/30

(54) **LIGHT DETECTION DEVICE AND ELECTRONIC APPARATUS**

(30) Priority: 15.04.2021 JP 2021069279
(71) Applicant: Sony Semiconductor Solutions Corporation, Atsugi-shi, Kanagawa 243-0014 (JP)
(72) Inventor: YAMAZAKI, Tomohiro, Atsugi-shi, Kanagawa 243-0014 (JP); MIZUTA, Kyohei, Atsugi-shi, Kanagawa 243-0014 (JP)
(74) Representative: Müller Hoffmann & Partner
(86) International application number: PCT/JP2022/009517
(87) International publication number: WO 2022/219966

(57) **Abstract**

Light interference is suppressed. A light detection device includes: a semiconductor layer that has a photoelectric conversion region which photoelectrically converts incident light; and an optical element that has a metal film and an aperture arrangement formed in the metal film, selects specific light, supplies the selected light to the photoelectric conversion region, and is disposed to overlap the photoelectric conversion region in a plan view, wherein the photoelectric conversion region on a side of the optical element has an uneven portion.

## Description

### [Technical Field]

The present technology (technology according to the present disclosure) relates to a light detection device and an electronic device, and more particularly to a light detection device having an optical element such as a wire grid polarizer and an electronic device.

### [Background Art]

An imaging device having a plurality of imaging elements provided with a wire grid polarizer (WGP) is known from, for example, PTL 1. A photoelectric conversion region that is included in a photoelectric conversion unit provided in the imaging element and generates a current on the basis of incident light is constituted by, for example, a charge coupled device (CCD device) or a complementary metal oxide semiconductor (CMOS) image sensor. The wire grid polarizer is disposed on a light incidence surface side of the photoelectric conversion unit, and is constituted by, for example, a plurality of band-shaped light reflection layers, insulating layers, and light absorption layers disposed side by side with spaces therebetween.

### [Citation List]

### [Patent Literature]

[PTL 1]
JP 2012-238632A

### [Summary]

### [Technical Problem]

The wire grid polarizer is made of a metal material with low absorption and high reflection in order to suppress transmission polarization loss. Therefore, the wire grid polarizer has a high light reflectance. An object of the present technology is to provide a light detection device and an electronic device capable of suppressing light interference.

### [Solution to Problem]

According to one aspect of the present technology, there is provided a light detection device including: a semiconductor layer that has a photoelectric conversion region which photoelectrically converts incident light; and an optical element that has a metal film and an aperture arrangement formed in the metal film, selects specific light, supplies the selected light to the photoelectric conversion region, and is disposed to overlap the photoelectric conversion region in a plan view, wherein the photoelectric conversion region on a side of the optical element has an uneven portion.

According to one aspect of the present technology, there is provided an electronic device including the light detection device and an optical system that forms an image based on image light from a subject on the light detection device.

According to another aspect of the present technology, there is provided a light detection device including: a semiconductor layer that has a photoelectric conversion region which converts incident light into signal charges; and an optical element that has a plurality of layers of dielectric materials having different refractive indices, selects specific light according to a film thickness of the dielectric material, supplies the selected light to the photoelectric conversion region, and is disposed to overlap the photoelectric conversion region in a plan view, wherein the photoelectric conversion region on a side of the optical element has an uneven portion.

According to another aspect of the present technology, there is provided an electronic device including the light detection device and an optical system that forms an image based on image light from a subject on the light detection device.

### [Brief Description of Drawings]

[Fig. 1]

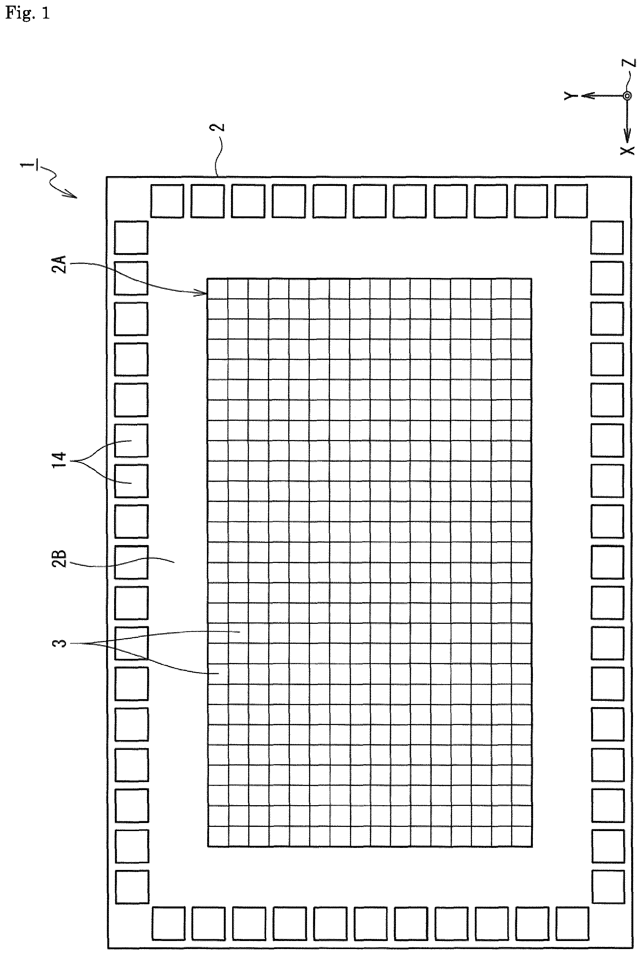

   Fig. 1 is a chip layout diagram showing one configuration example of a light detection device according to a first embodiment of the present technology.
[Fig. 2]

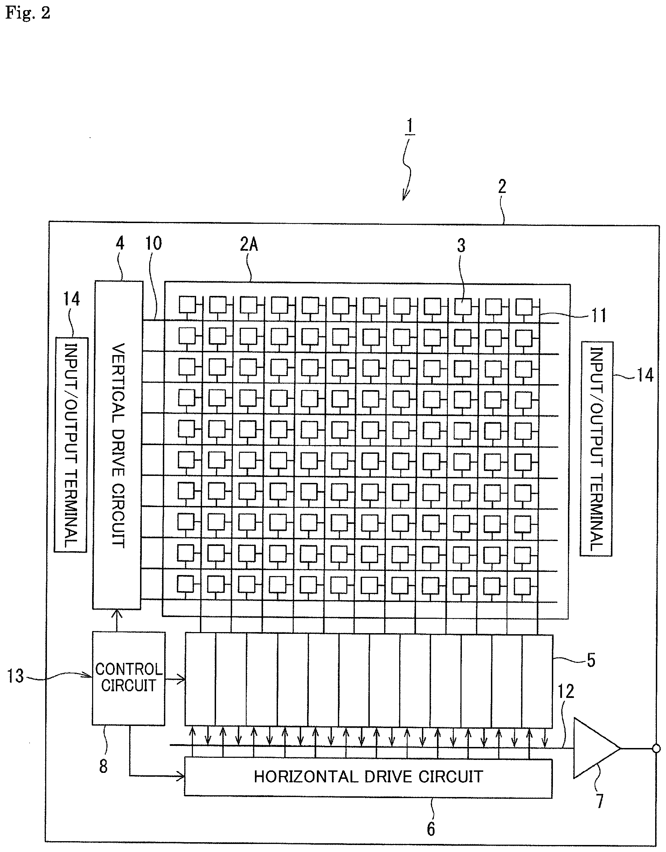

   Fig. 2 is a block diagram showing one configuration example of the light detection device according to the first embodiment of the present technology.
[Fig. 3]

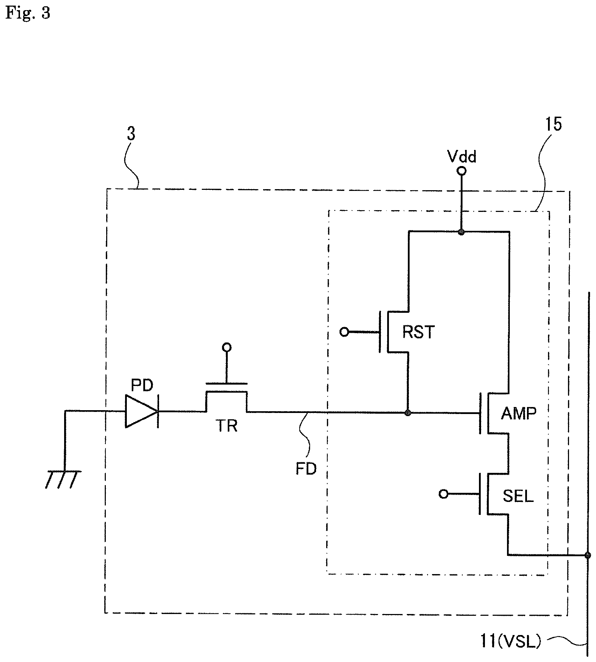

   Fig. 3 is an equivalent circuit diagram of a pixel of the light detection device according to the first embodiment of the present technology.
[Fig. 4]

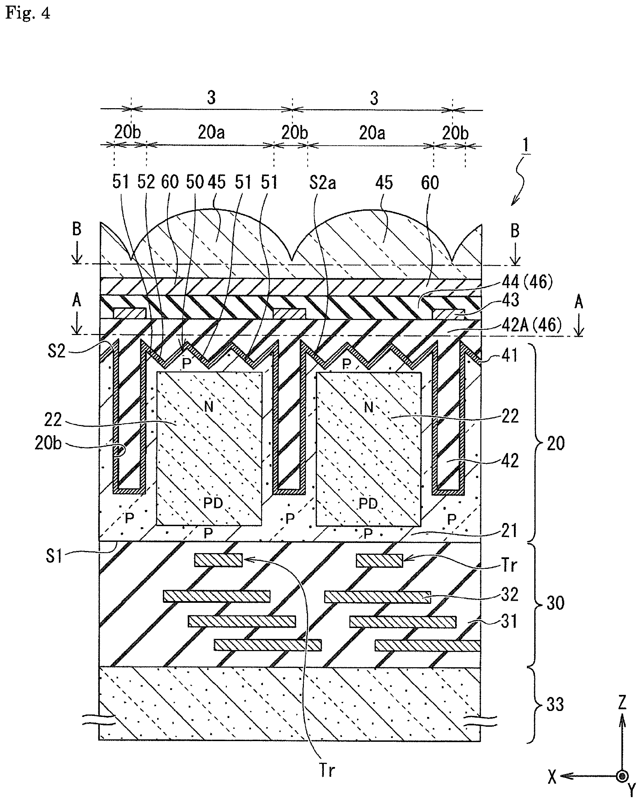

   Fig. 4 is a vertical cross-sectional view showing a cross-sectional structure of the pixel of the light detection device according to the first embodiment of the present technology.
[Fig. 5]

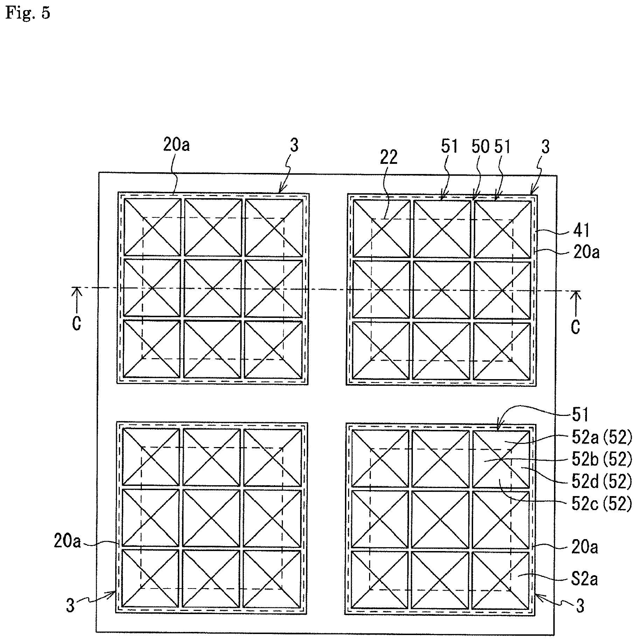

   Fig. 5 is a horizontal cross-sectional view showing an arrangement of four photoelectric conversion regions and a relative relationship between the photoelectric conversion region and an uneven portion along an A-A section line in Fig. 4.
[Fig. 6A]

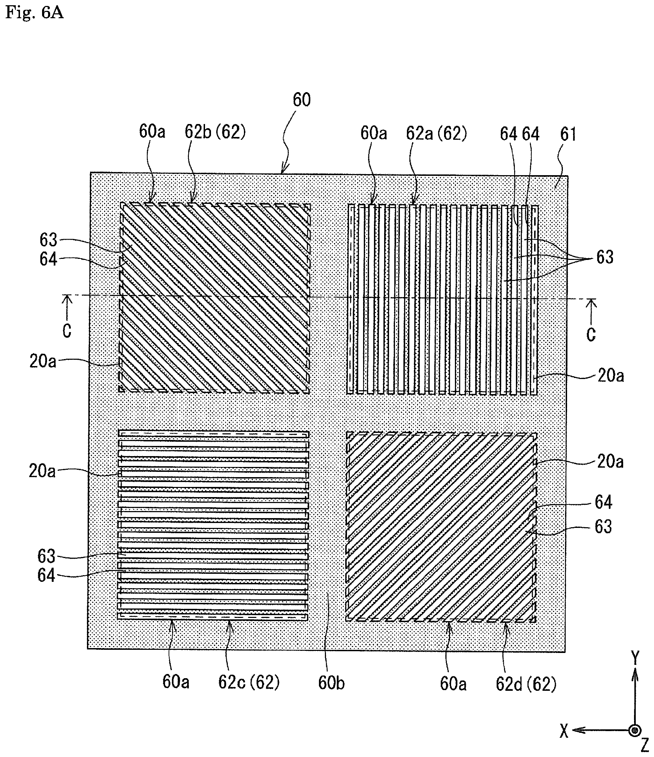

   Fig. 6A is a horizontal cross-sectional view showing an arrangement of four photoelectric conversion regions and a relative relationship between the photoelectric conversion region and a wire grid polarizer along a B-B section line in Fig. 4.
[Fig. 6B]

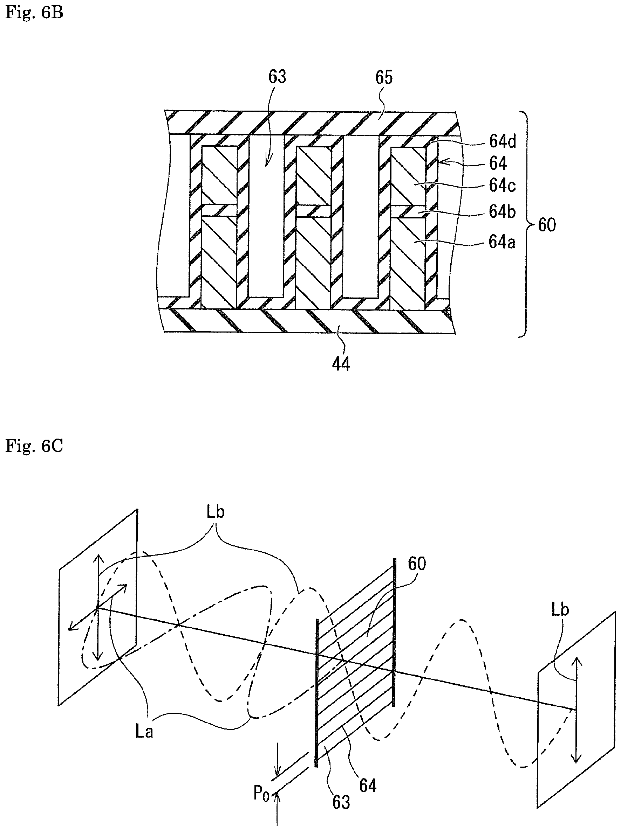

   Fig. 6B is a vertical cross-sectional view of the wire grid polarizer of the light detection device according to the first embodiment of the present technology.
[Fig. 6C]
   Fig. 6C is a conceptual diagram for explaining light passing through the wire grid polarizer of the light detection device according to the first embodiment of the present technology, and the like.
[Fig. 7A]

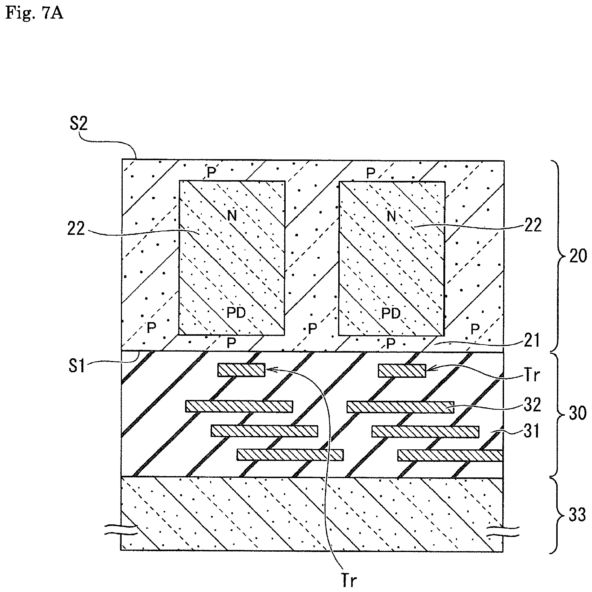

   Fig. 7A is a process cross-sectional view showing a method of manufacturing the light detection device according to the first embodiment of the present technology.
[Fig. 7B]

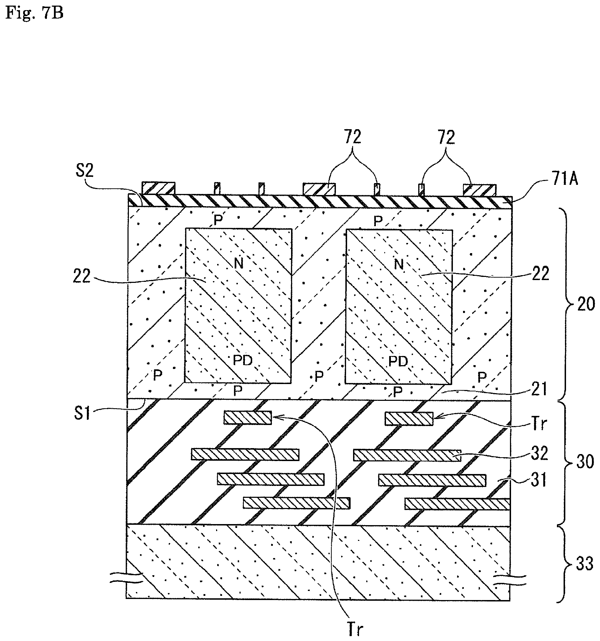

   Fig. 7B is a process cross-sectional view subsequent to Fig. 7A.
[Fig. 7C]

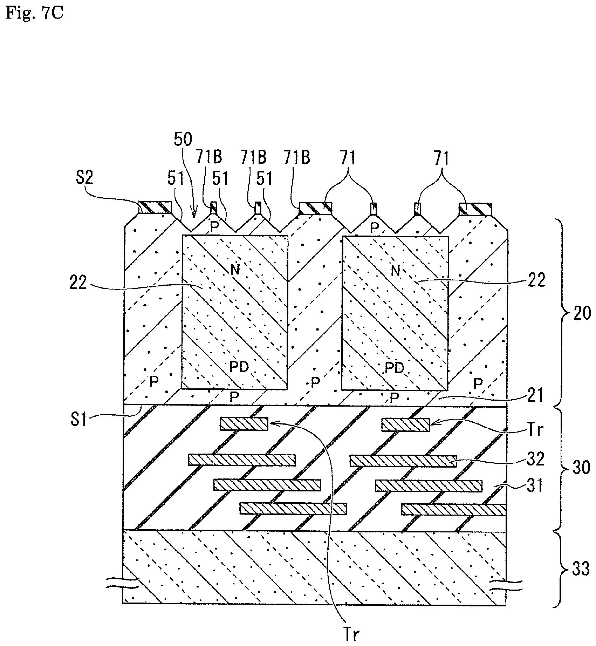

   Fig. 7C is a process cross-sectional view subsequent to Fig. 7B.
[Fig. 7D]

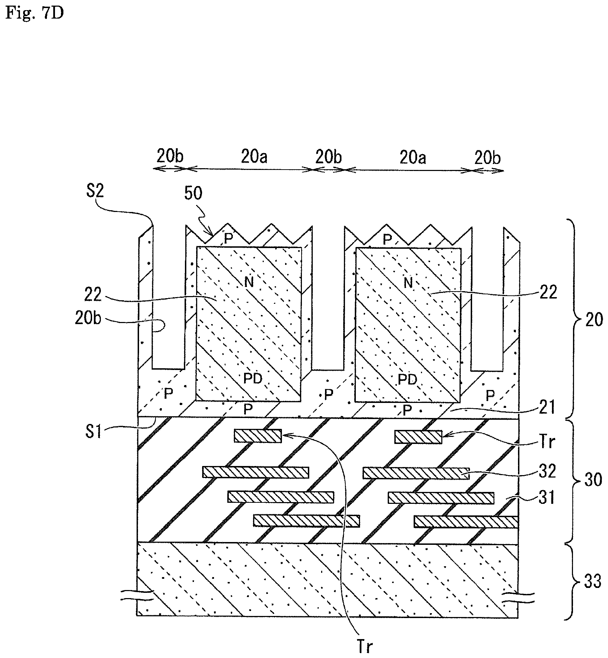

   Fig. 7D is a process cross-sectional view subsequent to Fig. 7C.
[Fig. 7E]

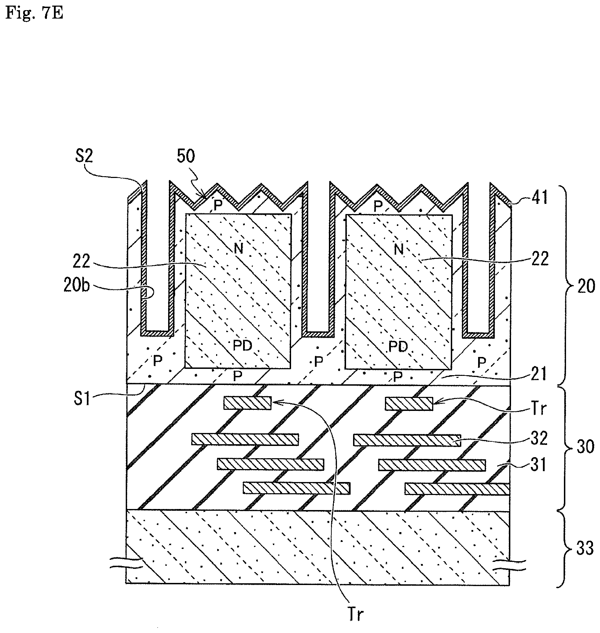

   Fig. 7E is a process cross-sectional view subsequent to Fig. 7D.
[Fig. 7F]

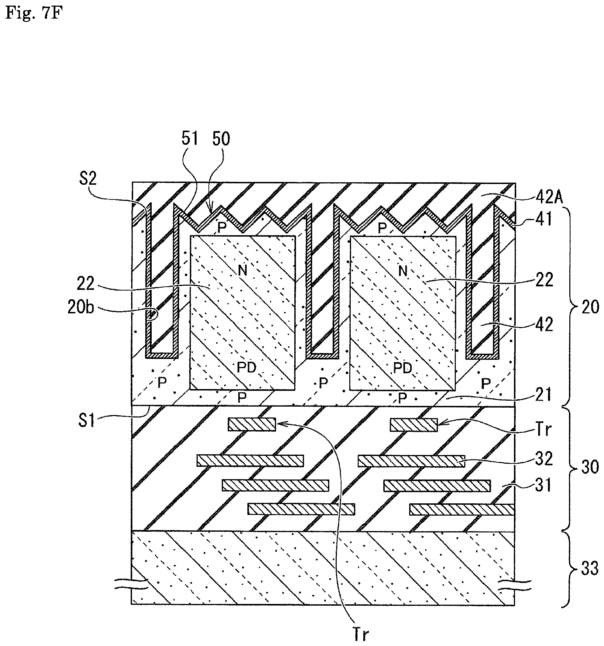

   Fig. 7F is a process cross-sectional view subsequent to Fig. 7E.
[Fig. 7G]

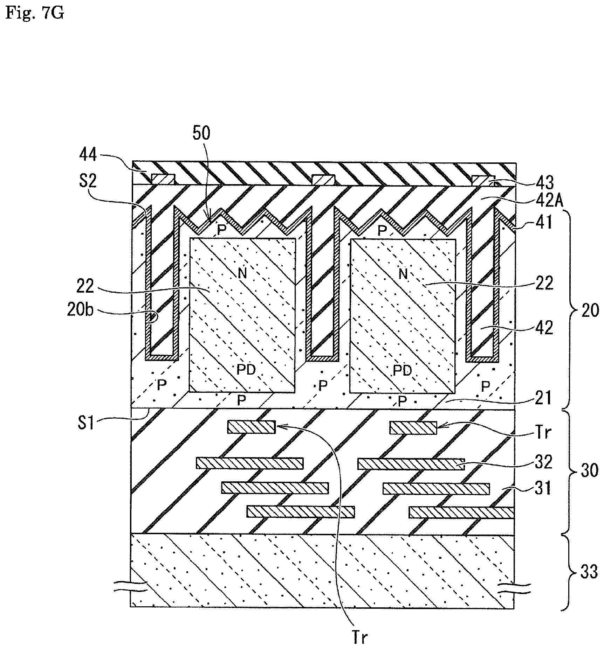

   Fig. 7G is a process cross-sectional view subsequent to Fig. 7F.
[Fig. 7H]

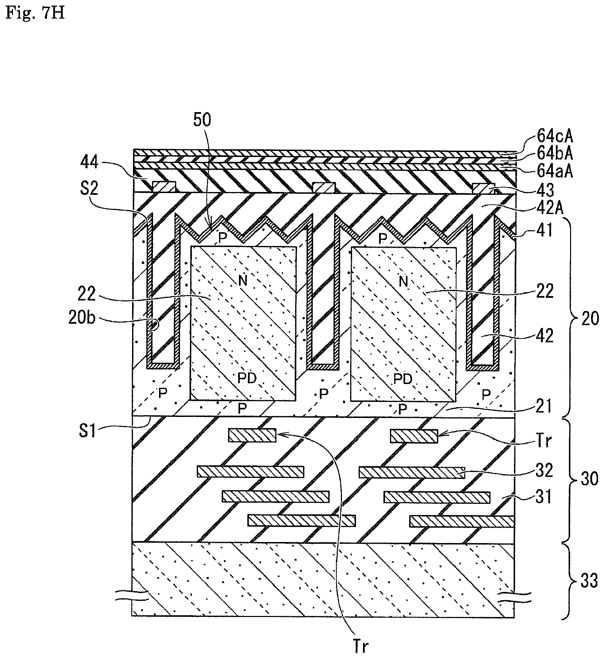

   Fig. 7H is a process cross-sectional view subsequent to Fig. 7G.
[Fig. 7I]

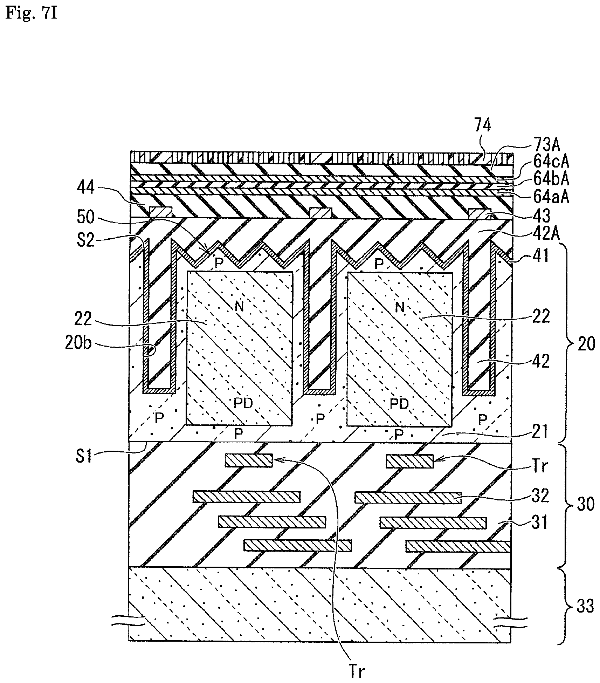

   Fig. 7I is a process cross-sectional view subsequent to Fig. 7H.
[Fig. 7J]

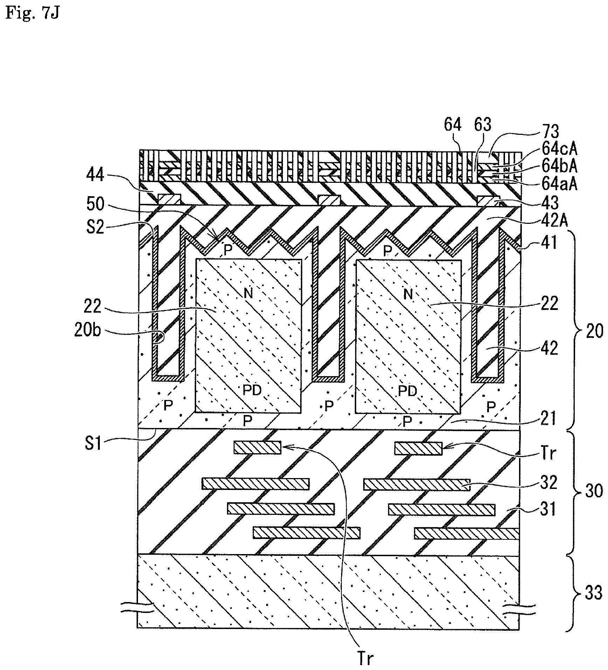

   Fig. 7J is a process cross-sectional view subsequent to Fig. 7I.
[Fig. 7K]

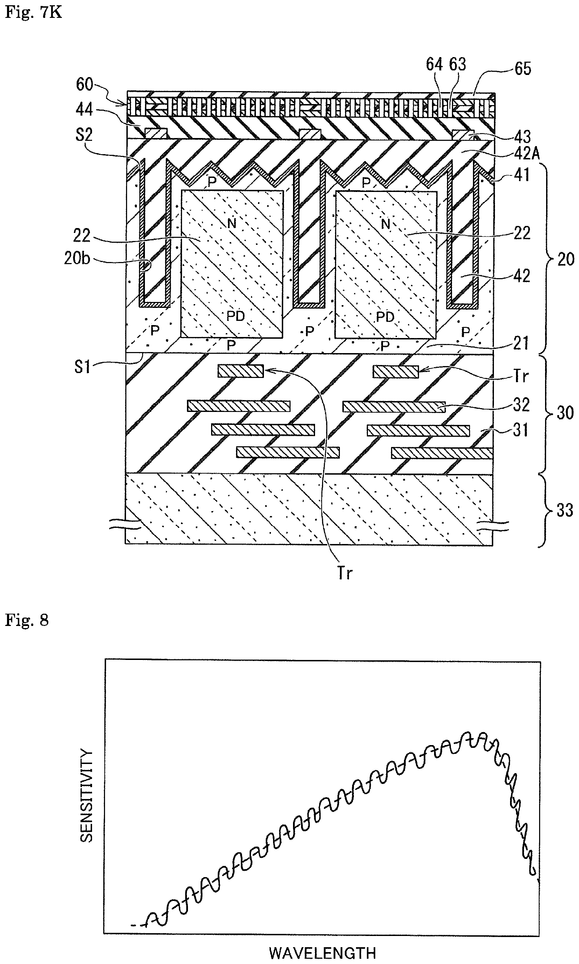

   Fig. 7K is a process cross-sectional view subsequent to Fig. 7J.
[Fig. 8]
   Fig. 8 is a graph showing the sensitivity of silicon to the wavelength of incident light.
[Fig. 9]

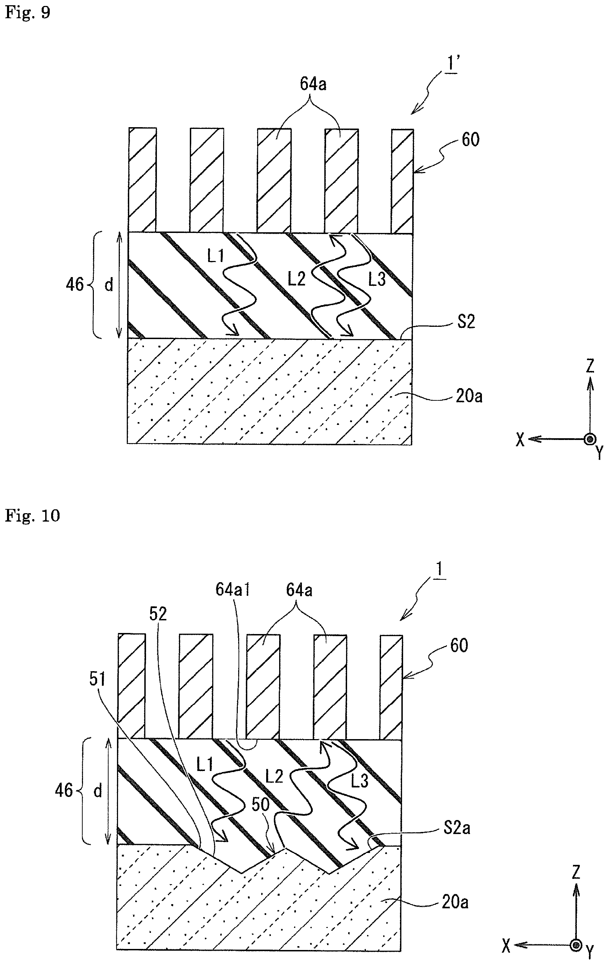

   Fig. 9 is a vertical cross-sectional view showing an enlarged part of a cross section of a pixel for explaining reflection of light in a light detection device of the related art.
[Fig. 10]
   Fig. 10 is a vertical cross-sectional view showing an enlarged part of a cross section of the pixel for explaining reflection of light in the light detection device according to the first embodiment of the present technology.
[Fig. 11]

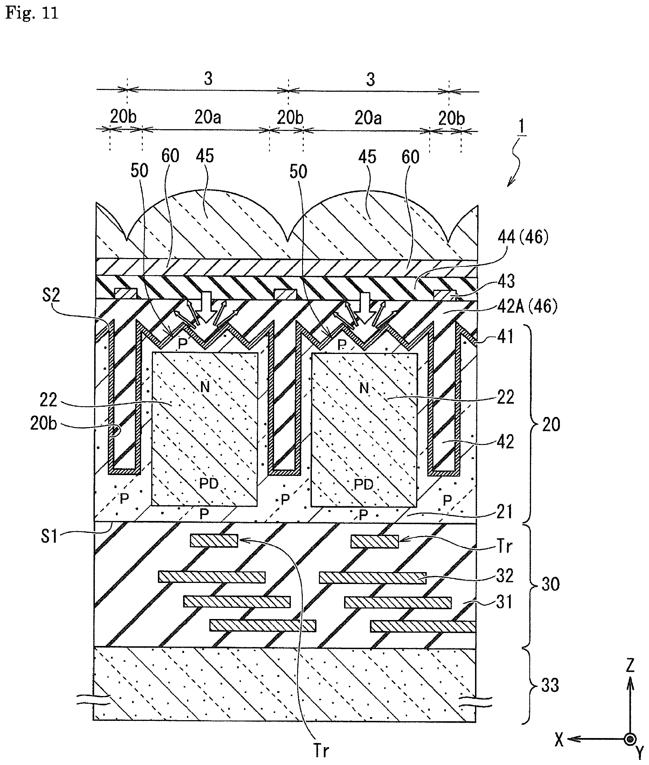

   Fig. 11 is a vertical cross-sectional view of the pixel for explaining reflection of light in the light detection device according to the first embodiment of the present technology.
[Fig. 12]

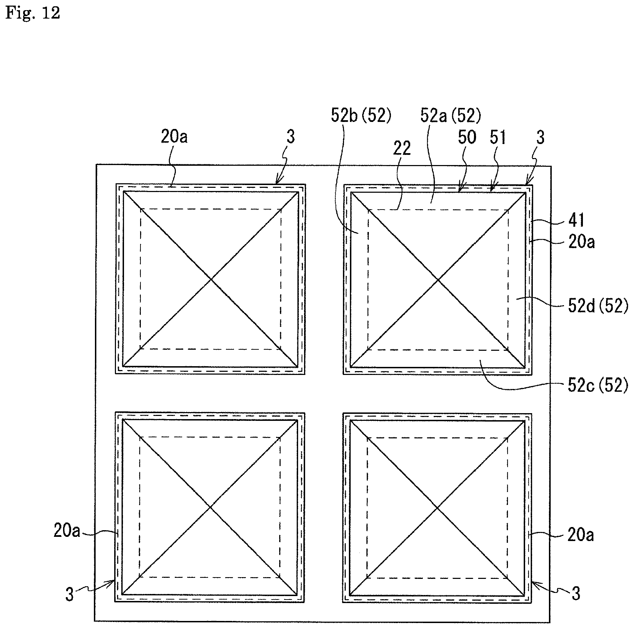

   Fig. 12 is a horizontal cross-sectional view showing a relative relationship between an uneven portion and a photoelectric conversion region included in another light detection device according to the first embodiment of the present technology.
[Fig. 13]

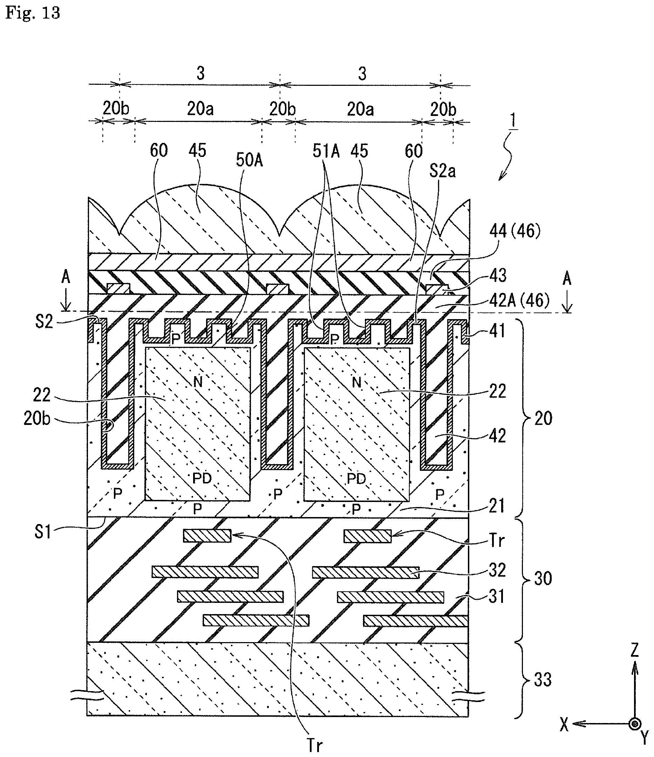

   Fig. 13 is a vertical cross-sectional view showing a cross-sectional structure of a pixel of a light detection device according to a second embodiment of the present technology.
[Fig. 14]

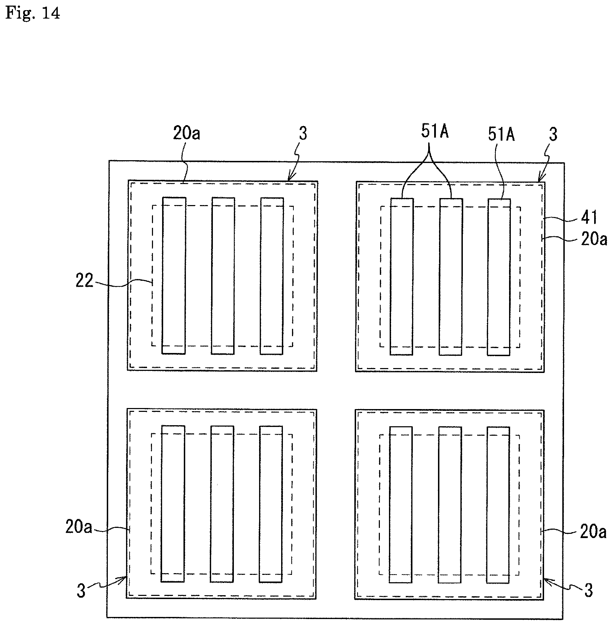

   Fig. 14 is a horizontal cross-sectional view showing an arrangement of four photoelectric conversion regions and a relative relationship between the photoelectric conversion region and an uneven portion along an A-A section line in Fig. 13.
[Fig. 15]

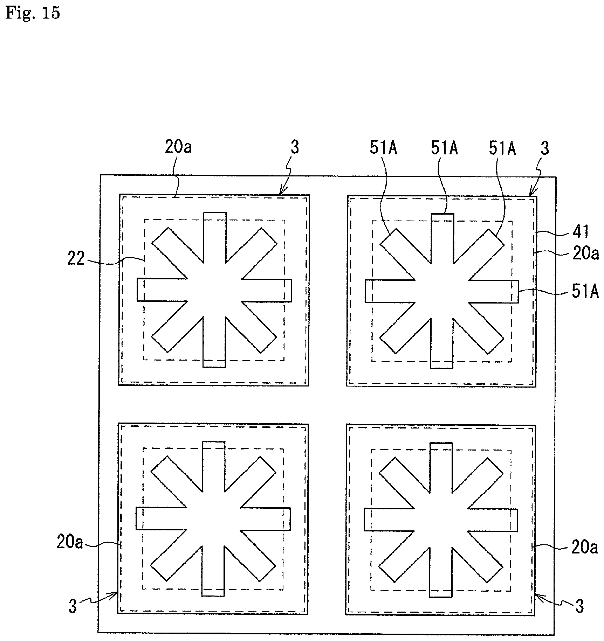

   Fig. 15 is a horizontal cross-sectional view showing a relative relationship between an uneven portion and a photoelectric conversion region included in another light detection device according to the second embodiment of the present technology.
[Fig. 16]

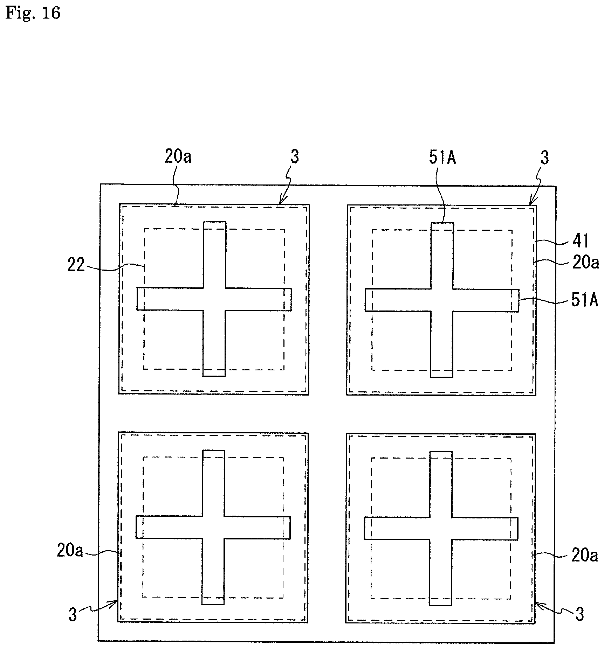

   Fig. 16 is a cross-sectional view showing a relative relationship between an uneven portion and a photoelectric conversion region included in still another light detection device according to the second embodiment of the present technology.
[Fig. 17]

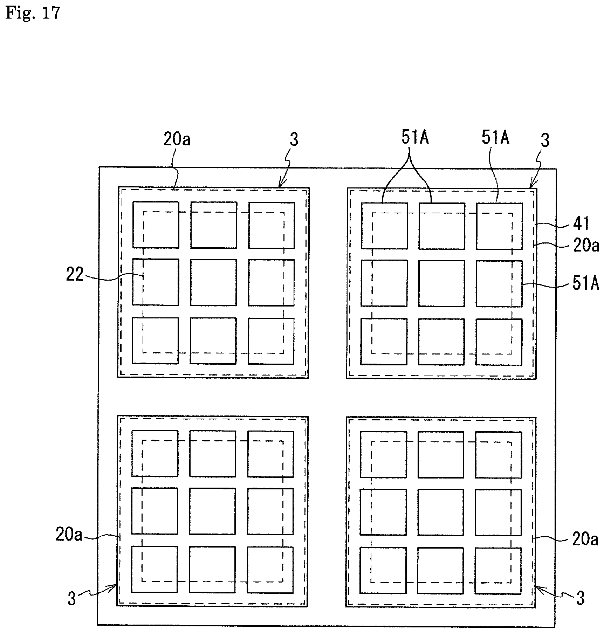

   Fig. 17 is a horizontal cross-sectional view showing a relative relationship between an uneven portion and a photoelectric conversion region included in further still another light detection device according to the second embodiment of the present technology.
[Fig. 18]

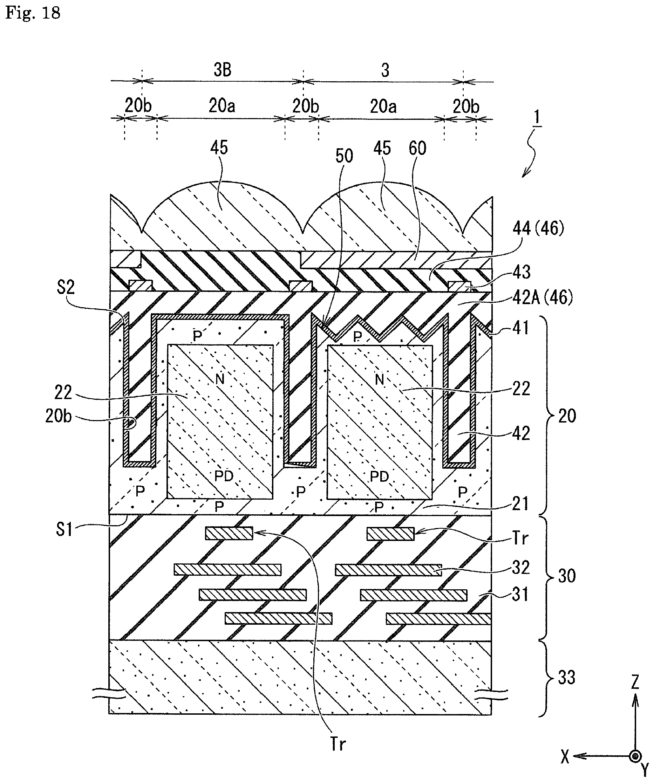

   Fig. 18 is a vertical cross-sectional view showing a cross-sectional structure of a pixel of a light detection device according to a third embodiment of the present technology.
[Fig. 19]

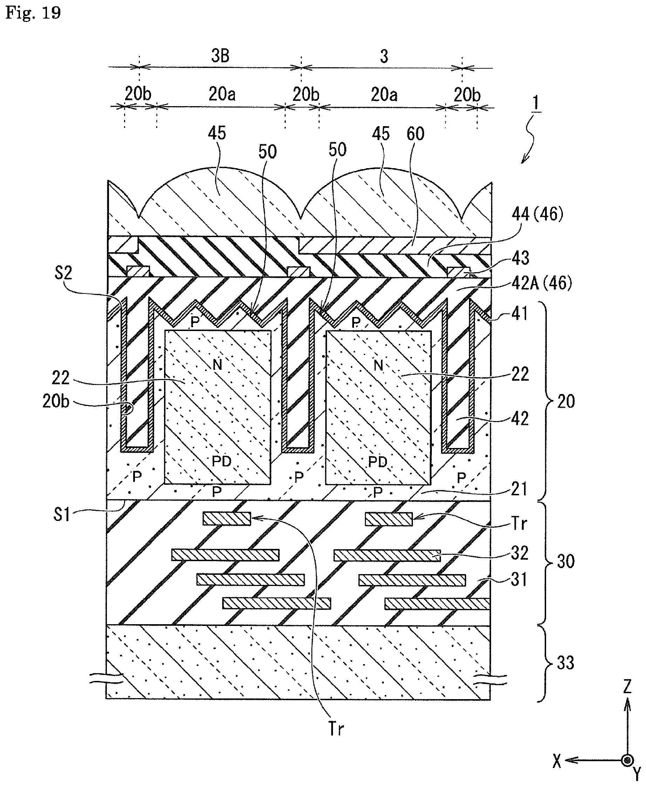

   Fig. 19 is a vertical cross-sectional view showing a cross-sectional structure of a pixel of another light detection device according to a third embodiment of the present technology.
[Fig. 20]

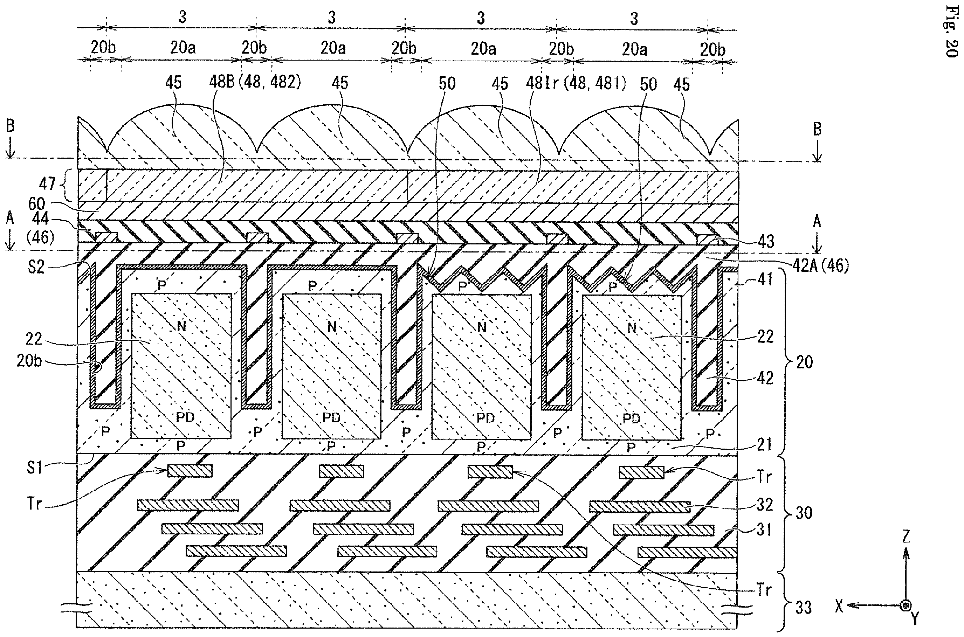

   Fig. 20 is a vertical cross-sectional view showing a cross-sectional structure of a pixel of a light detection device according to a fourth embodiment of the present technology.
[Fig. 21]

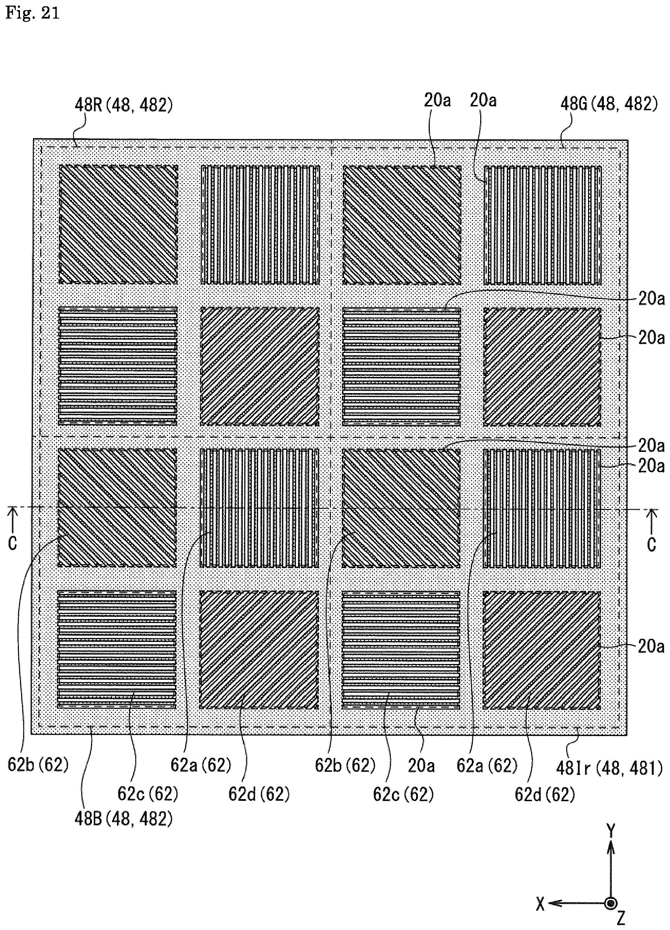

   Fig. 21 is a horizontal cross-sectional view showing an arrangement of four color filters and a relative relationship between the color filter, a photoelectric conversion region, and a wire grid polarizer along a B-B section line in Fig. 20.
[Fig. 22]

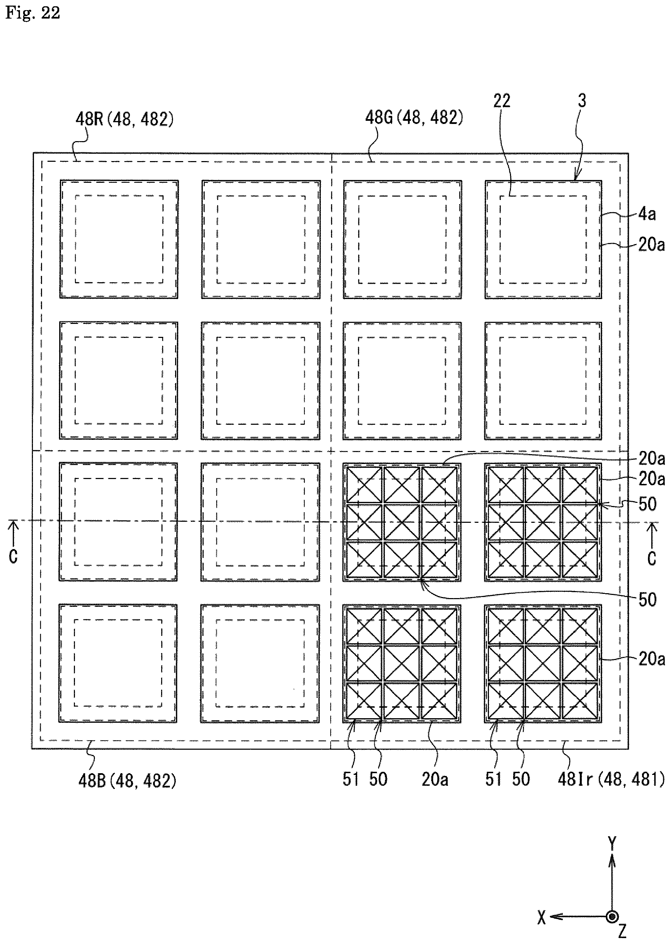

   Fig. 22 is a horizontal cross-sectional view showing an arrangement of four color filters and a relative relationship between the color filter, a photoelectric conversion region, and an uneven portion along an A-A section line in Fig. 20.
[Fig. 23A]

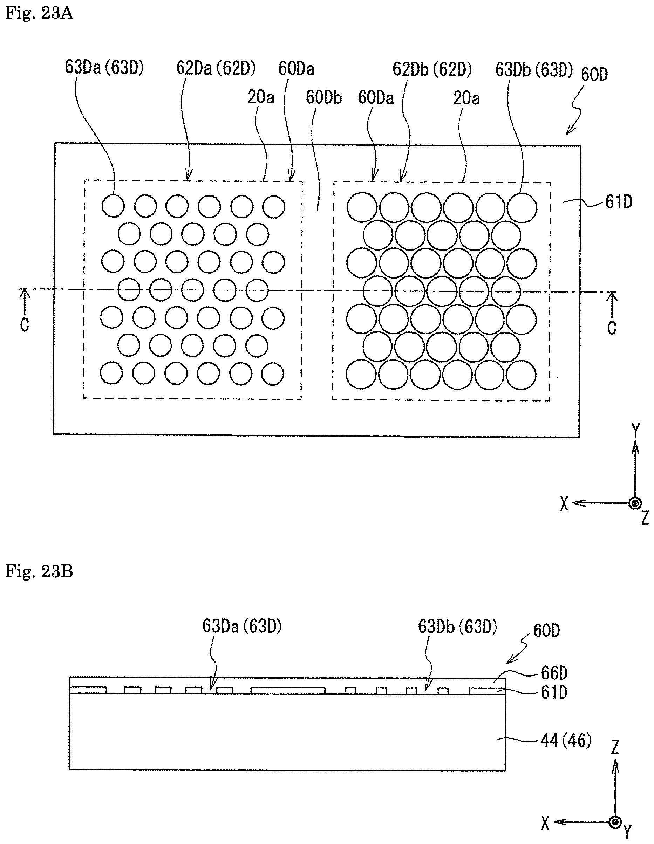

   Fig. 23A is a plan view of a plasmon filter included in a light detection device according to a fifth embodiment of the present technology.
[Fig. 23B]
   Fig. 23B is a vertical cross-sectional view showing a cross-sectional structure of the plasmon filter along a C-C section line in Fig. 23A.
[Fig. 24]

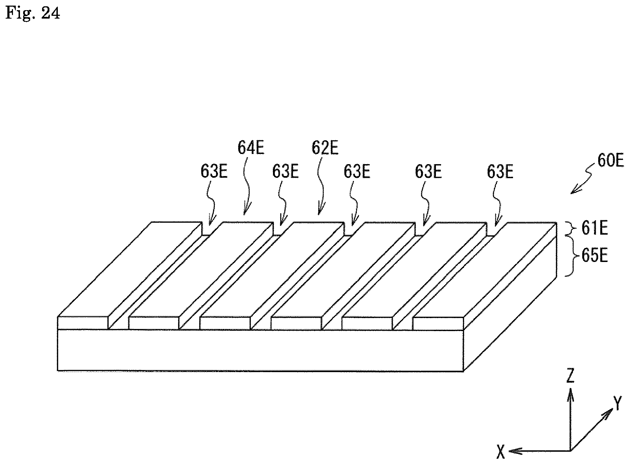

   Fig. 24 is a perspective view of a GMR color filter included in a light detection device according to a sixth embodiment of the present technology.
[Fig. 25]

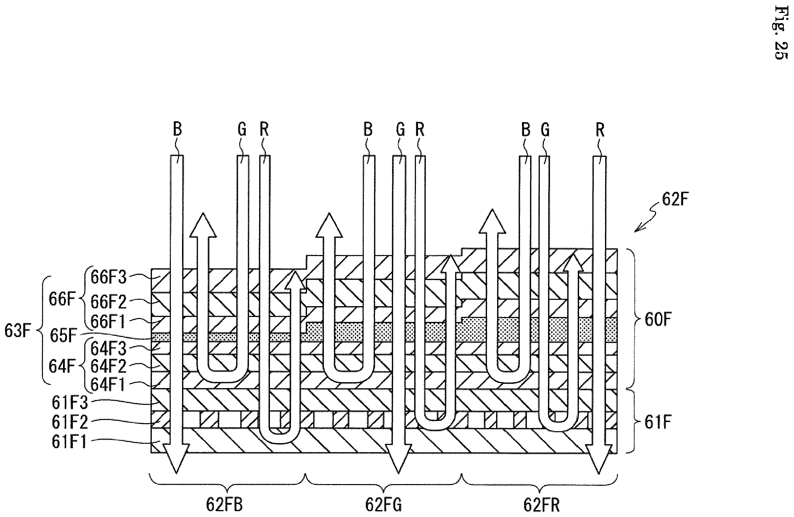

   Fig. 25 is a cross-sectional view of a dielectric multilayer film color filter included in a light detection device according to a seventh embodiment of the present technology.
[Fig. 26]

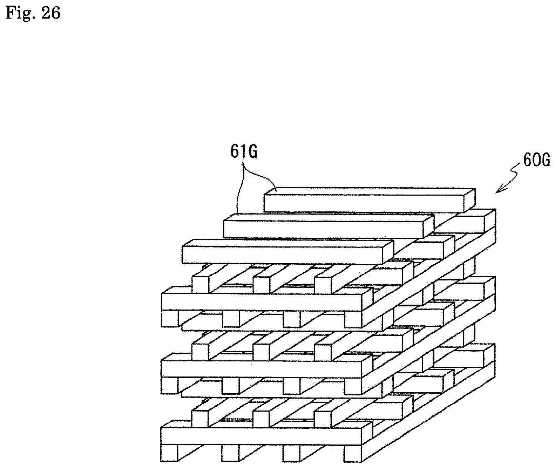

   Fig. 26 is a perspective view of a photonic crystal color filter included in a light detection device according to an eighth embodiment of the present technology.
[Fig. 27]

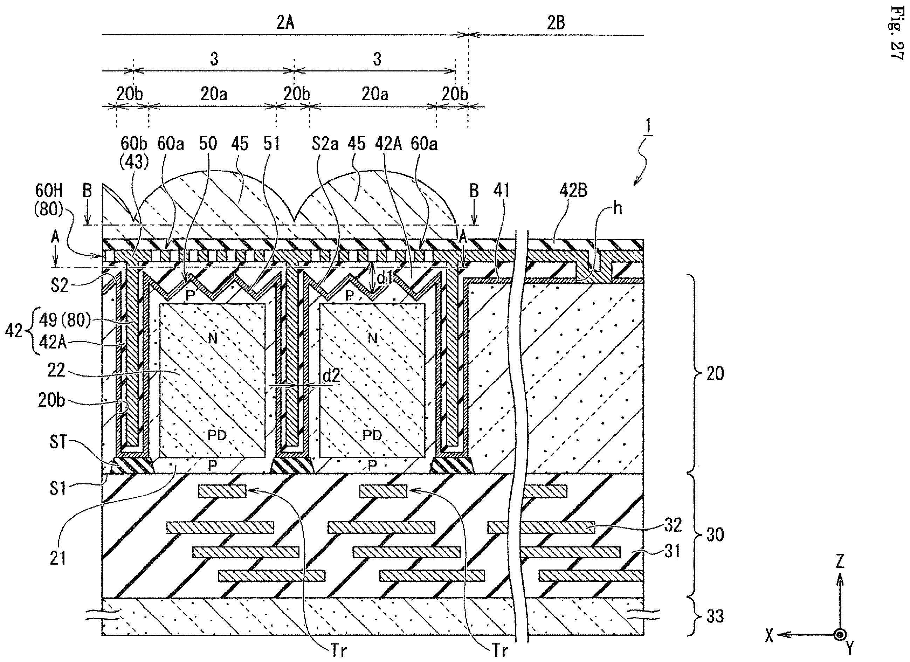

   Fig. 27 is a vertical cross-sectional view showing a cross-sectional structure of a part of a light detection device according to a ninth embodiment of the present technology.
[Fig. 28A]

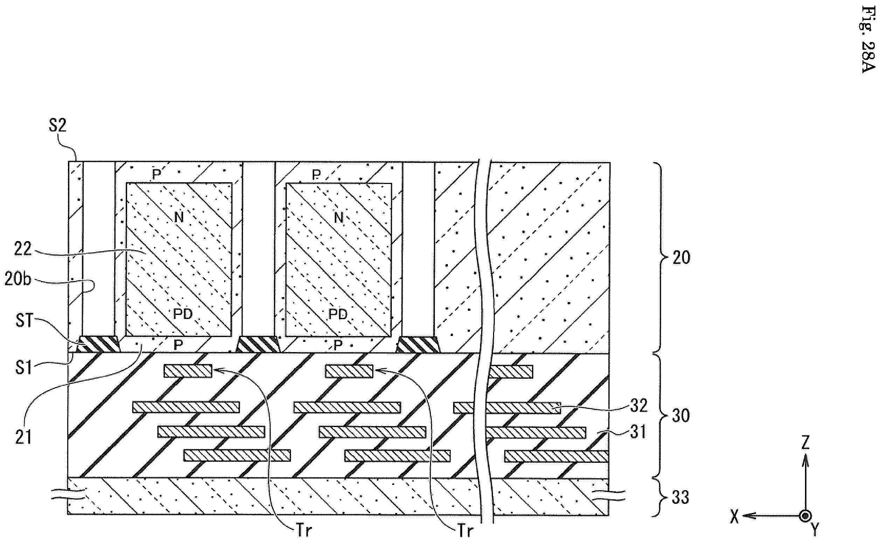

   Fig. 28A is a process cross-sectional view showing a method of manufacturing the light detection device according to the ninth embodiment of the present technology.
[Fig. 28B]

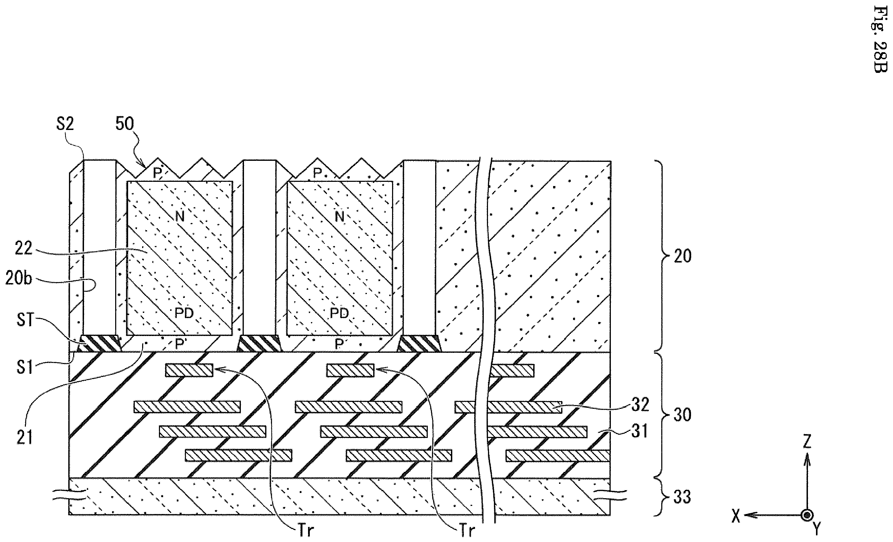

   Fig. 28B is a process cross-sectional view subsequent to Fig. 28A.
[Fig. 28C]

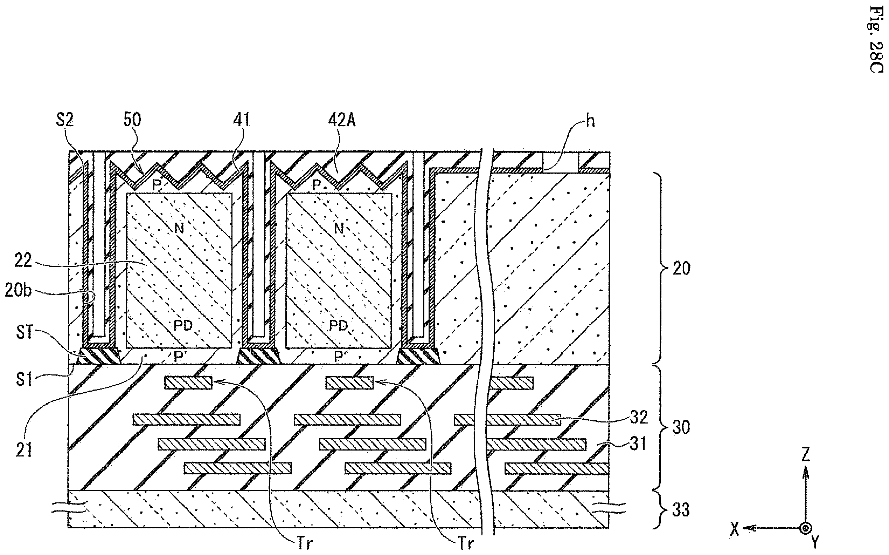

   Fig. 28C is a process cross-sectional view subsequent to Fig. 28B.
[Fig. 28D]

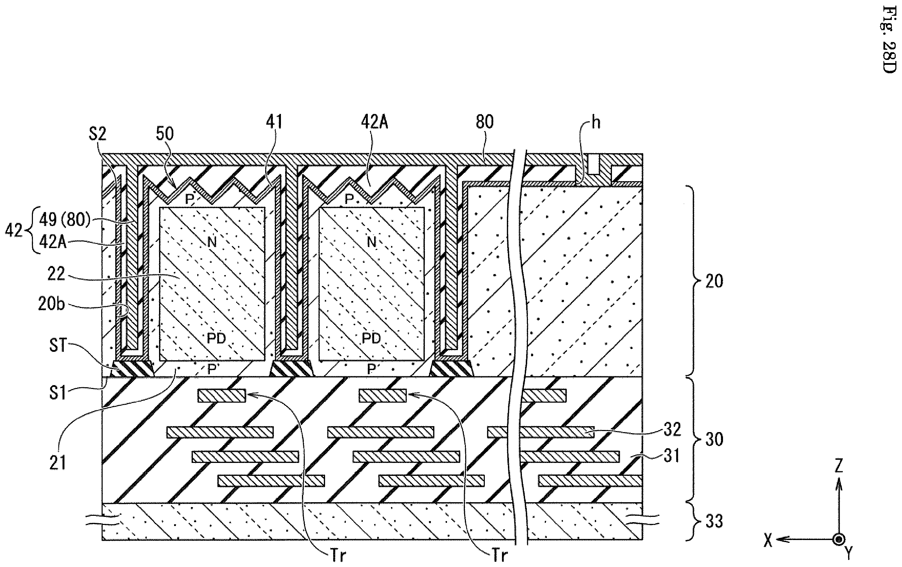

   Fig. 28D is a process cross-sectional view subsequent to Fig. 28C.
[Fig. 28E]

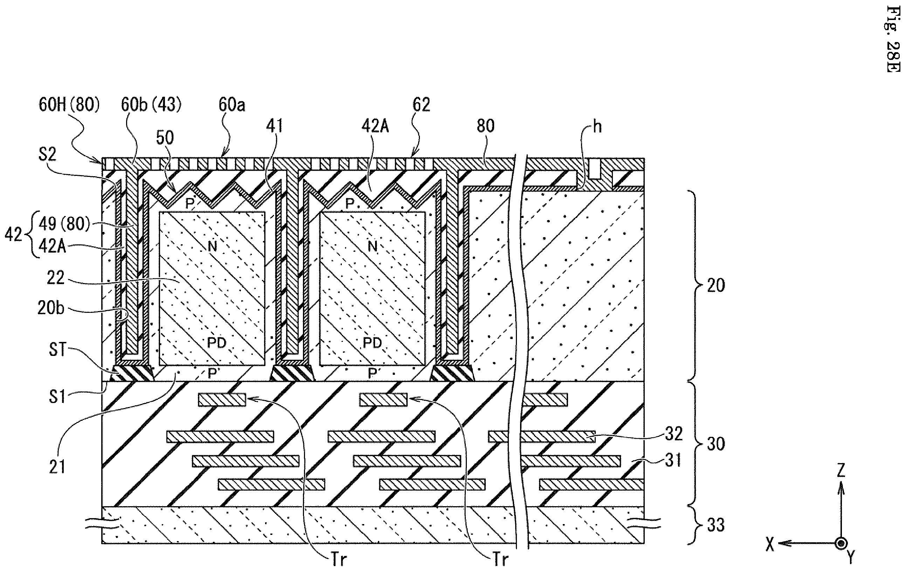

   Fig. 28E is a process cross-sectional view subsequent to Fig. 28D.
[Fig. 29]

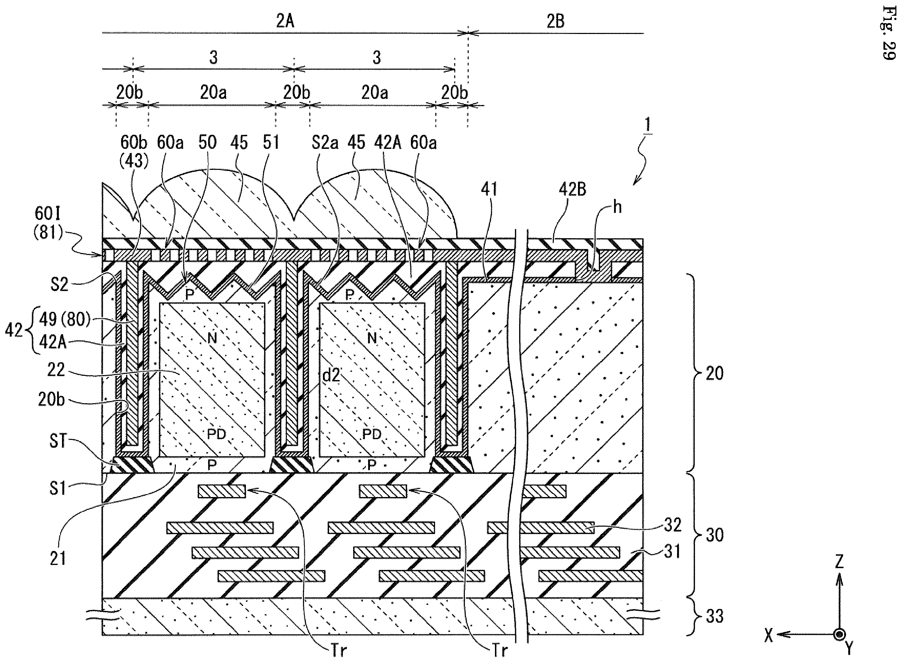

   Fig. 29 is a vertical cross-sectional view showing a cross-sectional structure of a part of a light detection device according to Modification Example 1 of the ninth embodiment of the present technology.
[Fig. 30]

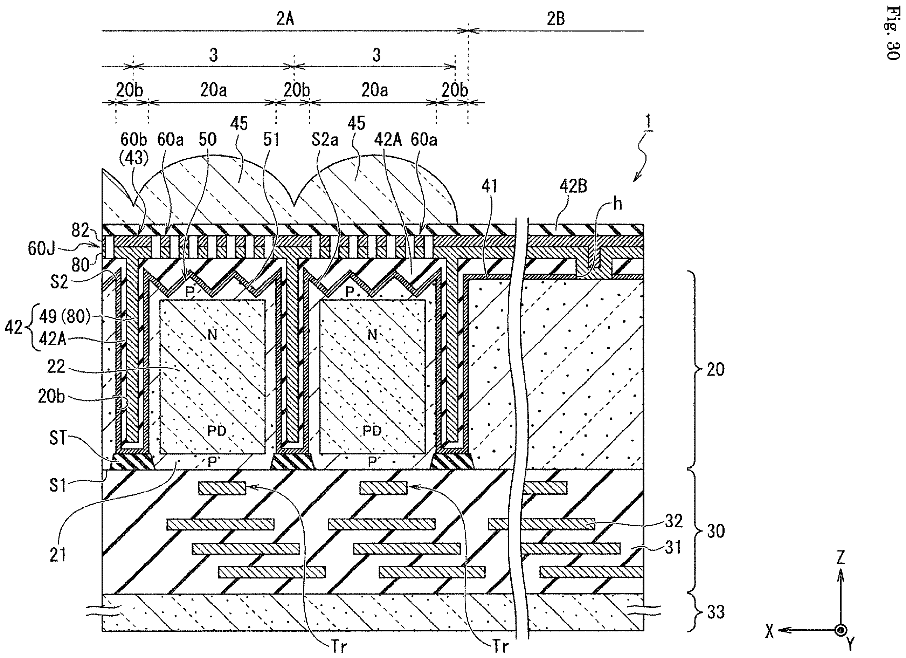

   Fig. 30 is a vertical cross-sectional view showing a cross-sectional structure of a part of a light detection device according to Modification Example 3 of the ninth embodiment of the present technology.
[Fig. 31]

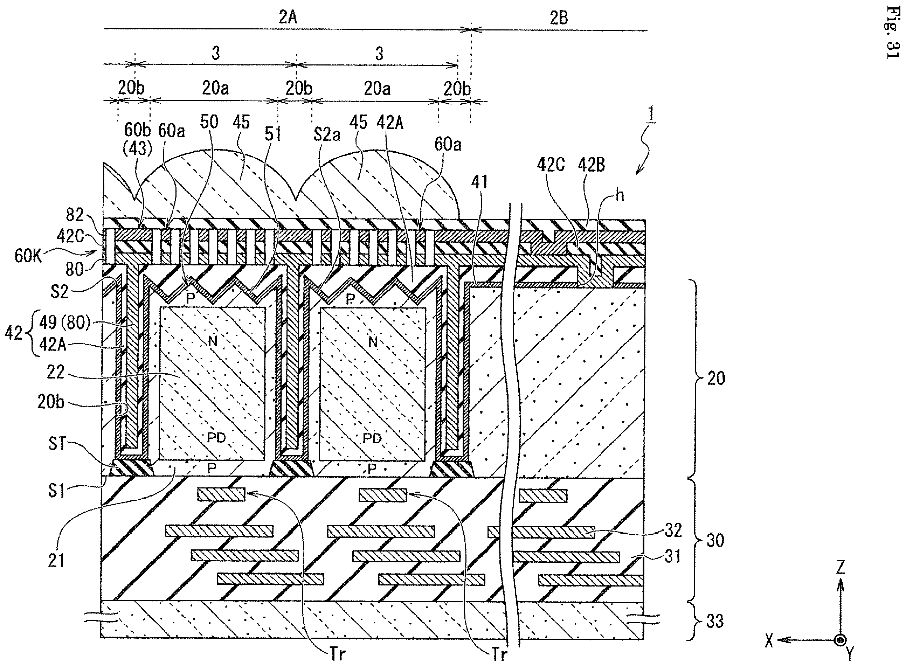

   Fig. 31 is a vertical cross-sectional view showing a cross-sectional structure of a part of a light detection device according to Modification Example 4 of the ninth embodiment of the present technology.
[Fig. 32]

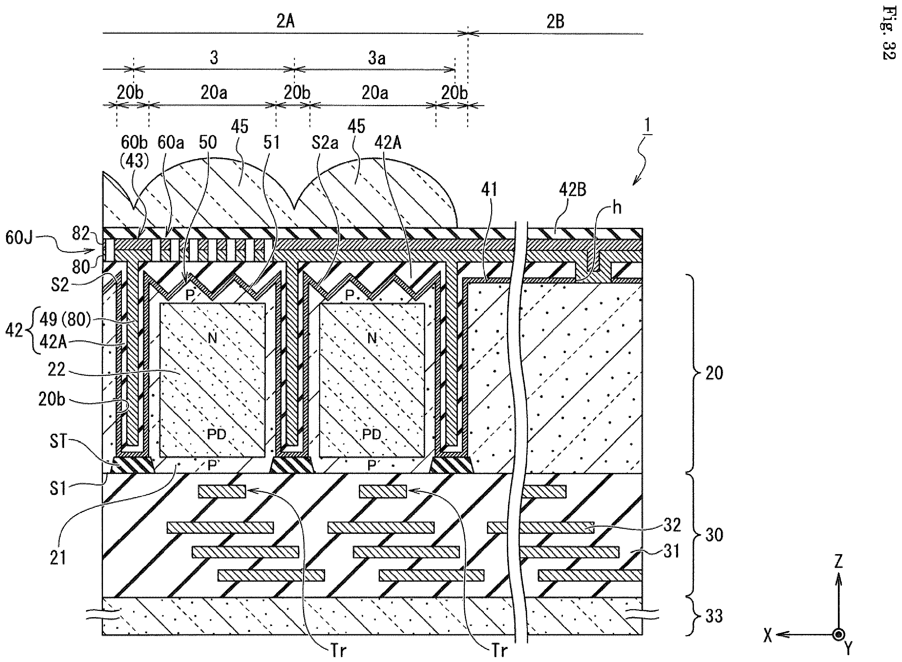

   Fig. 32 is a vertical cross-sectional view showing a cross-sectional structure of a part of a light detection device according to Modification Example 5 of the ninth embodiment of the present technology.
[Fig. 33]

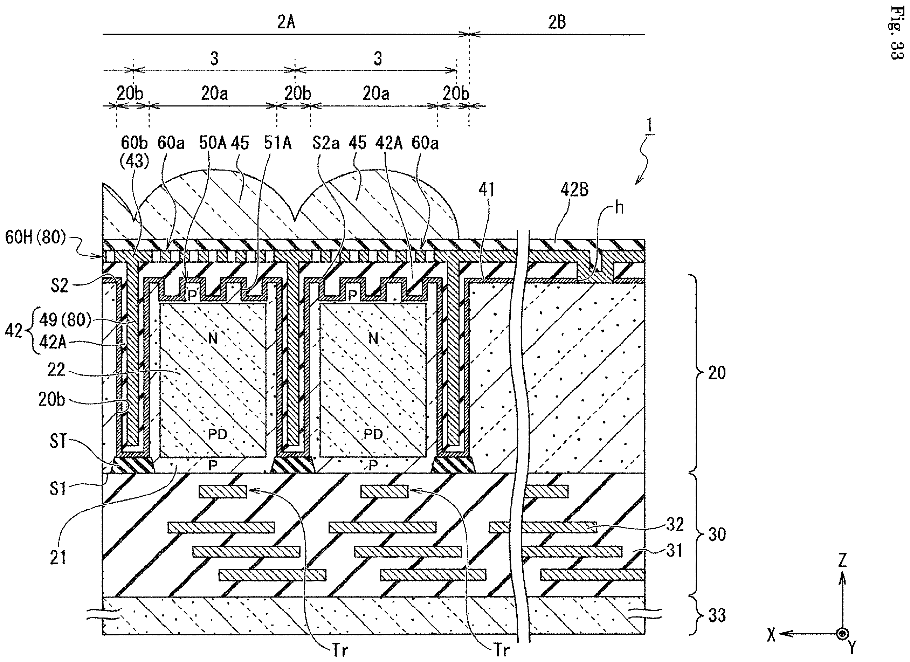

   Fig. 33 is a vertical cross-sectional view showing a cross-sectional structure of a part of a light detection device according to Modification Example 6 of the ninth embodiment of the present technology.
[Fig. 34]

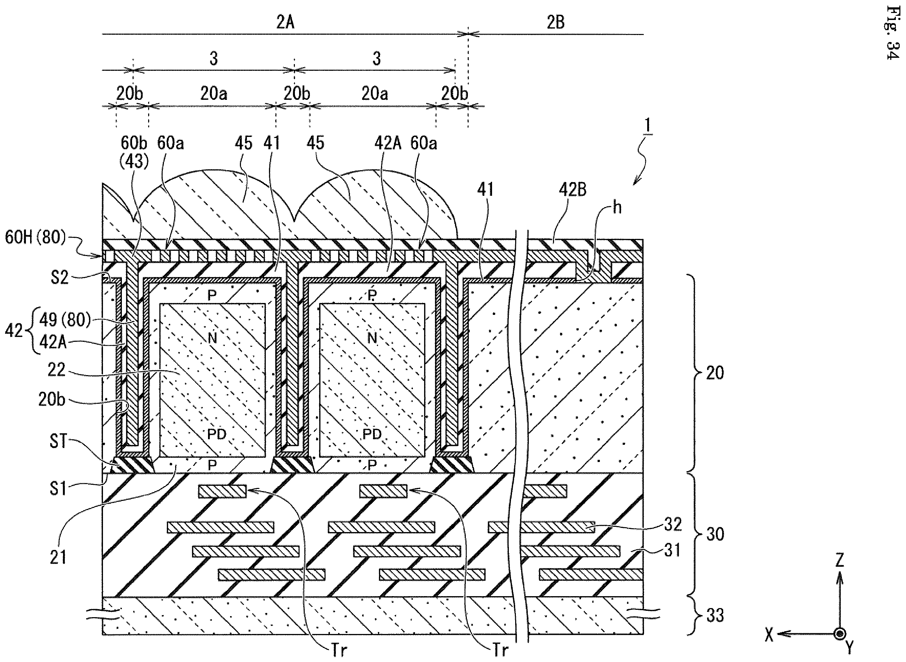

   Fig. 34 is a vertical cross-sectional view showing a cross-sectional structure of a part of a light detection device according to Modification Example 7 of the ninth embodiment of the present technology.
[Fig. 35]

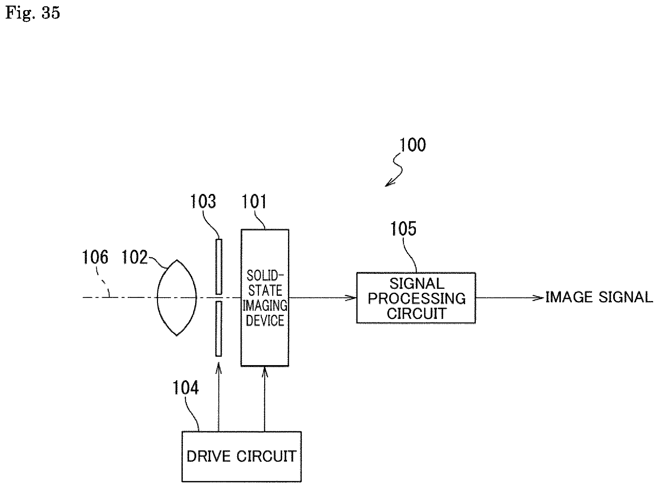

   Fig. 35 is a diagram showing a schematic configuration of an electronic device according to a tenth embodiment of the present technology.
[Fig. 36]

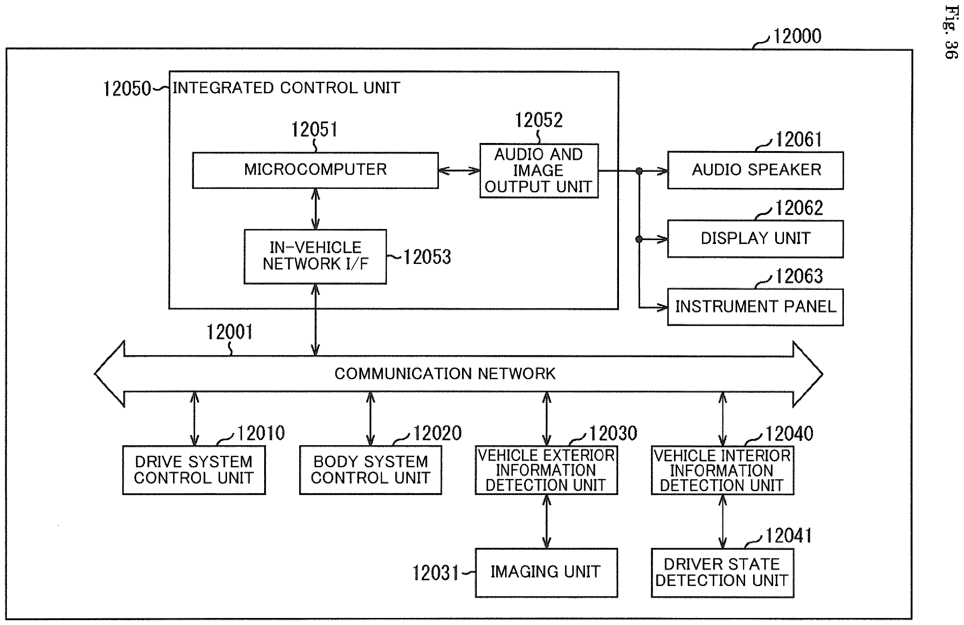

   Fig. 36 is a block diagram showing an example of a schematic configuration of a vehicle control system.
[Fig. 37]

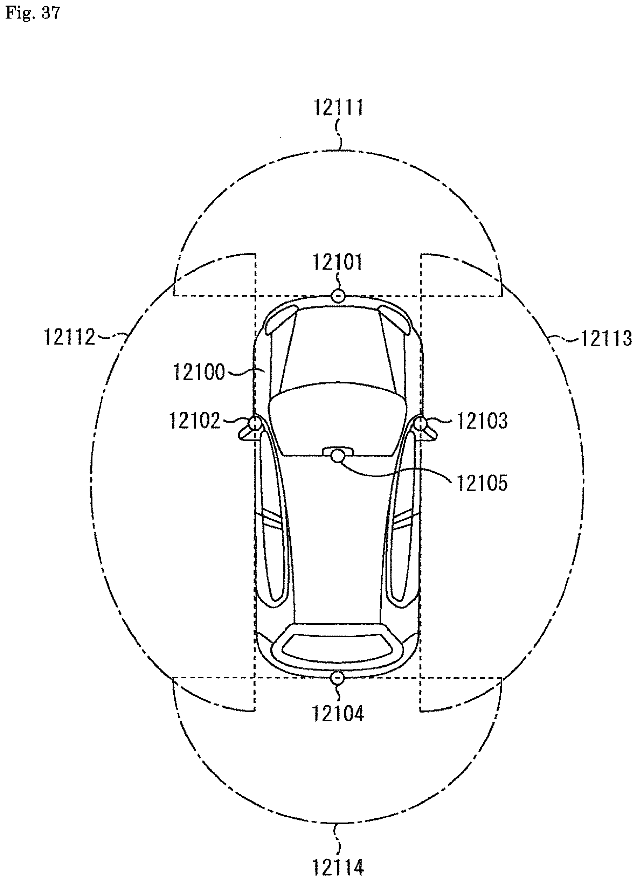

   Fig. 37 is an explanatory diagram showing an example of installation positions of a vehicle exterior information detection unit and an imaging unit.
[Fig. 38]

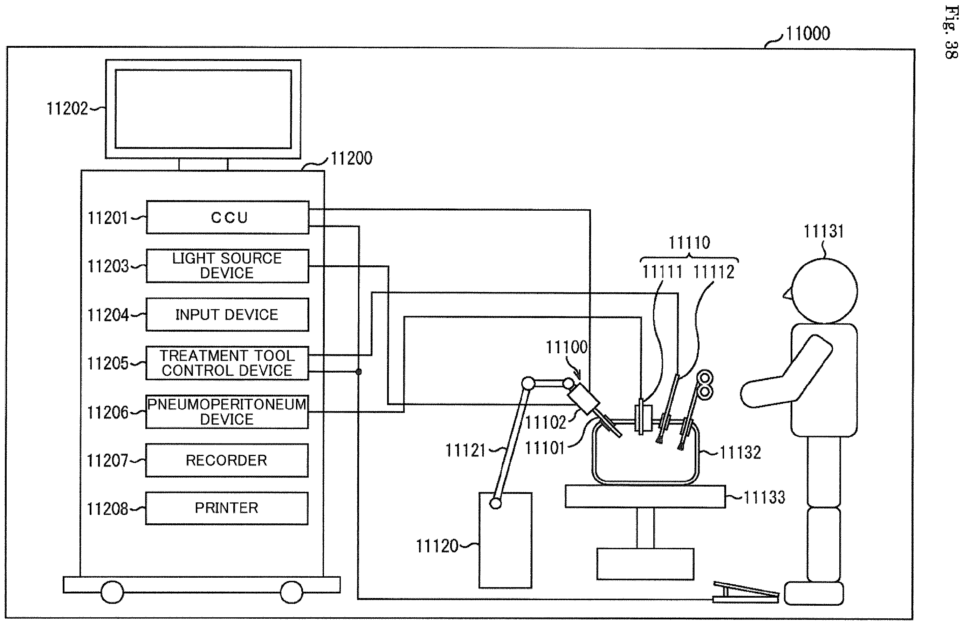

   Fig. 38 is a diagram showing an example of a schematic configuration of an endoscopic surgery system.
[Fig. 39]

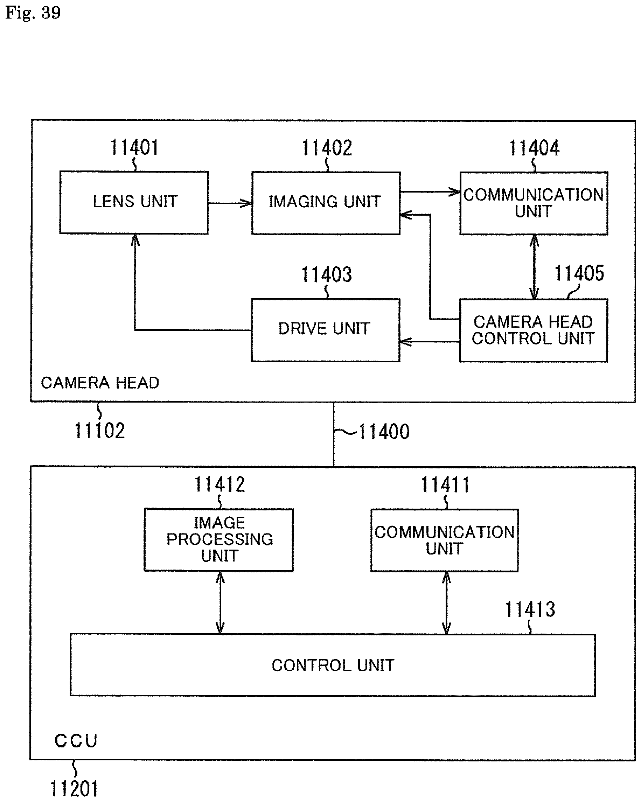

   Fig. 39 is a block diagram showing an example of a functional configuration of a camera head and a CCU.

### [Description of Embodiments]

Hereinafter, preferable embodiments for implementing the present technology will be described with reference to the drawings. The embodiments which will be described below show examples of representative embodiments of the present technology, and the scope of the present technology should not be narrowly interpreted on the basis of this.

In the following description of the drawings, the same or similar portions are denoted by the same or similar reference signs. However, it should be noted that the drawings are schematic, and the relationships between thicknesses and planar dimensions, ratios of thicknesses of layers, and the like are different from actual ones. Therefore, specific thicknesses and dimensions should be determined in consideration of the following descriptions. In addition, it goes without saying that the drawings include parts where dimensional relationships and ratios are different from each other between the drawings.

Further, first to tenth embodiments shown below are examples of devices and methods for embodying the technical idea of the present technology, and the technical idea of the present technology is not meant to specify that materials, shapes, structures, arrangements, and the like of component parts are those described below. The technical idea of the present technology can be variously modified within the technical scope described in the claims.

Description will be given in the following order.
1. First embodiment
2. Second embodiment
3. Third embodiment
4. Fourth embodiment
5. Fifth embodiment
6. Sixth embodiment
7. Seventh embodiment
8. Eighth embodiment
9. Ninth embodiment
10. Tenth embodiment

### [First embodiment]

In a first embodiment, an example in which the present technology is applied to a light detection device that is a back surface irradiation type complementary metal oxide semiconductor (CMOS) image sensor will be described.

### «Overall configuration of light detection device»

First, the overall configuration of the light detection device 1 will be described. As shown in Fig. 1, the light detection device 1 according to the first embodiment of the present technology mainly includes a semiconductor chip 2 having a rectangular shape in a two-dimensional planar shape in a plan view. That is, the light detection device 1 is mounted on the semiconductor chip 2. As shown in Fig. 35, this light detection device 1 takes in image light (incident light 106) from a subject through an optical system (an optical lens) 102, converts the amount of the incident light 106 formed as an image on an imaging surface into an electric signal for each pixel, and outputs the electric signal as a pixel signal.

As shown in Fig. 1, a semiconductor chip 2 on which the light detection device 1 is mounted has a rectangular pixel region 2A provided in the center and a peripheral region 2B provided outside the pixel region 2A to surround the pixel region 2Ain a two-dimensional plane including an X direction and a Y direction that intersect with each other.

The pixel region 2A is a light reception surface that receives light condensed by the optical system 102 shown in Fig. 35, for example. In the pixel region 2A, a plurality of pixels 3 are disposed in a matrix in the two-dimensional plane including the X direction and the Y direction. In other words, the pixels 3 are disposed repeatedly in each of the X direction and the Y direction that intersect with each other in the two-dimensional plane. In addition, in the present embodiment, the X direction and the Y direction are orthogonal to each other as an example. A direction orthogonal to both the X direction and the Y direction is a Z direction (a thickness direction).

As shown in Fig. 1, a plurality of bonding pads 14 are disposed in the peripheral region 2B. The plurality of bonding pads 14 are arranged, for example, along each of four sides in the two-dimensional plane of the semiconductor chip 2. Each of the plurality of bonding pads 14 is an input/output terminal used when the semiconductor chip 2 is electrically connected to an external device.

### <Logic circuit>

As shown in Fig. 2, the semiconductor chip 2 includes a logic circuit 13 including a vertical drive circuit 4, a column signal processing circuit 5, a horizontal drive circuit 6, an output circuit 7, a control circuit 8, and the like. The logic circuit 13 is constituted by a complementary MOS (CMOS) circuit having, for example, an n-channel conductivity type metal oxide semiconductor field effect transistor (MOSFET) and a p-channel conductivity type MOSFET as field effect transistors.

The vertical drive circuit 4 is constituted by a shift register, for example. The vertical drive circuit 4 sequentially selects desired pixel drive lines 10, supplies pulses for driving the pixels 3 to the selected pixel drive lines 10, and drives the pixels 3 in units of rows. That is, the vertical drive circuit 4 selectively scans the pixels 3 in the pixel region 2A sequentially in a vertical direction in units of rows and supplies pixel signals from the pixels 3 based on signal charges generated according to the amount of light received by photoelectric conversion elements of the pixels 3 to the column signal processing circuits 5 through vertical signal lines 11.

For example, the column signal processing circuit 5 is disposed for each of the columns of the pixels 3 to perform signal processing such as noise removal on signals output from a row of the pixels 3 for each of the columns of the pixels. For example, the column signal processing circuit 5 performs signal processing such as correlated double sampling (CDS) for removing pixel-specific fixed pattern noise and analog-digital (AD) conversion. A horizontal selection switch (not shown) is connected between an output stage of the column signal processing circuit 5 and a horizontal signal line 12.

The horizontal drive circuit 6 is constituted by a shift register, for example. The horizontal drive circuit 6 sequentially outputs a horizontal scanning pulse to the column signal processing circuits 5 and thus selects each of the column signal processing circuits 5 in order, and outputs the pixel signals subjected to signal processing from each of the column signal processing circuits 5 to the horizontal signal line 12.

The output circuit 7 performs signal processing on the pixel signals sequentially supplied from each of the column signal processing circuits 5 through the horizontal signal line 12 and outputs resultant pixel signals. Examples of the signal processing which may be used include buffering, black level adjustment, column variation correction, and various types of digital signal processing.

The control circuit 8 generates a clock signal or a control signal as a reference for operations of the vertical drive circuit 4, the column signal processing circuit 5, the horizontal drive circuit 6, and the like on the basis of a vertical synchronization signal, a horizontal synchronization signal, and a master clock signal. In addition, the control circuit 8 outputs the generated clock signal or control signal to the vertical drive circuit 4, the column signal processing circuit 5, the horizontal drive circuit 6, and the like.

### <Pixel>

Fig. 3 is an equivalent circuit diagram showing a configuration example of the pixel 3. The pixel 3 includes a photoelectric conversion element PD, a charge accumulation region (floating diffusion) FD for accumulating (holding) signal charges photoelectrically converted by the photoelectric conversion element PD, and a transfer transistor TR for transferring the signal charges photoelectrically converted by the photoelectric conversion element PD to the charge accumulation region FD. In addition, the pixel 3 includes a readout circuit 15 electrically connected to the charge accumulation region FD.

The photoelectric conversion element PD generates signal charges according to the amount of light received. In addition, the photoelectric conversion element PD temporarily accumulates (holds) the generated signal charges. The photoelectric conversion element PD has a cathode side electrically connected to a source region of the transfer transistor TR and an anode side electrically connected to a reference potential line (for example, ground). A photodiode, for example, is used as the photoelectric conversion element PD.

A drain region of the transfer transistor TR is electrically connected to the charge accumulation region FD. A gate electrode of the transfer transistor TR is electrically connected to a transfer transistor drive line of the pixel drive lines 10 (see Fig. 2).

The charge accumulation region FD temporarily accumulates and holds the signal charges transferred from the photoelectric conversion element PD via the transfer transistor TR.

The readout circuit 15 reads the signal charges accumulated in the charge accumulation region FD and outputs the pixel signals based on the signal charges. The readout circuit 15 includes, but is not limited to, an amplification transistor AMP, a selection transistor SEL, and a reset transistor RST as a pixel transistor. The transistor (AMP, SEL, or RST) is constituted by a MOSFET having a gate insulating film made of, for example, a silicon oxide film (a SiO₂ film), a gate electrode, and a pair of main electrode regions functioning as a source region and a drain region. The transistor may be a metal insulator semiconductor FET (MISFET) whose gate insulating film is a silicon nitride film (a Si₃N₄ film) or a stacked film of the silicon nitride film and a silicon oxide film.

The amplification transistor AMP has a source region electrically connected to a drain region of the selection transistor SEL and a drain region electrically connected to a power supply line Vdd and a drain region of the reset transistor. A gate electrode of the amplification transistor AMP is electrically connected to the charge accumulation region FD and a source region of the reset transistor RST.

The selection transistor SEL has a source region electrically connected to the vertical signal line 11 (VSL) and a drain electrically connected to the source region of the amplification transistor AMP. A gate electrode of the selection transistor SEL is electrically connected to a selection transistor drive line of the pixel drive lines 10 (see Fig. 2).

The reset transistor RST has a source region electrically connected to the charge accumulation region FD and the gate electrode of the amplification transistor AMP and a drain region electrically connected to the power supply line Vdd and the drain region of the amplification transistor AMP. A gate electrode of the reset transistor RST is electrically connected to a reset transistor drive line of the pixel drive lines 10 (see Fig. 2).

### «Specific configuration of light detection device»

Next, a specific configuration of the light detection device 1 will be described with reference to Fig. 4.

### <Stacked structure of light detection device>

As shown in Fig. 4, the light detection device 1 includes a semiconductor layer 20 having a first surface S 1 and a second surface S2 located opposite to each other. The semiconductor layer 20 is constituted by a single-crystal silicon substrate of a first conductivity type, for example, a p-type. In addition, the light detection device 1 includes a multilayer wiring layer 30 including an interlayer insulating film 31 and a wiring layer 32 and a support substrate 33, which are sequentially stacked on a side of the first surface S1 of the semiconductor layer 20. In addition, the light detection device 1 includes members such as a pinning layer 41, an insulating film 42A, a light blocking layer 43, a planarization film 44, and a wire grid polarizer 60, which is an optical element, and a microlens (an on-chip lens) 45, which are sequentially stacked on a side of the second surface S2 of the semiconductor layer 20. In addition, the light detection device 1 has an uneven portion 50 provided in a photoelectric conversion region 20a, which will be described below. At least some of the incident light which has been incident on the light detection device 1 passes the microlens 45, the wire grid polarizer 60, the planarization film 44, the insulating film 42A, the pinning layer 41, and the semiconductor layer 20 of the constituent elements described above in that order. In addition, the first surface S 1 of the semiconductor layer 20 is sometimes called an element forming surface or a main surface, and the second surface S2 thereof is sometimes referred to as a light incidence surface or a back surface.

### <Photoelectric conversion region>

Fig. 5 is a horizontal cross-sectional view showing a cross-sectional structure along an A-A section line of Fig. 4, and Fig. 4 is a vertical cross-sectional view showing a cross-sectional structure along a C-C section line of Fig. 5. As shown in Figs. 4 and 5, the semiconductor layer 20 has an island-shaped photoelectric conversion region (element formation region) 20a partitioned by an isolation region 42. The photoelectric conversion region 20a is provided for each pixel 3. In addition, a region of the second surface S2 corresponding to the surface of the photoelectric conversion region 20a on a side of the wire grid polarizer 60 is referred to as a surface S2a. The number of pixels 3 is not limited to that shown in Fig. 5. The isolation region 42 has, but is not limited to, a trench structure in which, for example, an isolation trench 20b is formed in the semiconductor layer 20 and an insulating film is embedded in the isolation trench 20b.

As shown in Fig. 4, the photoelectric conversion region 20a includes a semiconductor region (a well region) 21 of a first conductivity type, for example, a p-type, and a semiconductor region (a photoelectric conversion unit) 22 of a second conductivity type, for example, an n-type, embedded in the well region 21. The photoelectric conversion element PD shown in Fig. 3 is formed in the photoelectric conversion region 20a. The photoelectric conversion region 20a photoelectrically converts incident light to generate signal charges.

### <Uneven portion>

As shown in Figs. 4 and 5, the photoelectric conversion region 20a on a side of the optical element (here, the wire grid polarizer 60) has the uneven portion 50. In other words, the uneven portion 50 is formed in the photoelectric conversion region 20a on a side of the optical element. More specifically, the surface S2a of the photoelectric conversion region 20a on a side of the wire grid polarizer 60 has the uneven portion 50. The uneven portion 50 has a plurality of concave portions 51. More specifically, the uneven portion 50 has a plurality of concave portions 51 provided in the surface S2a. That is, the surface S2a has an uneven shape due to the concave portions 51. Each of the concave portions 51 has a shape of a square pyramid turned upside or down and has four triangular slopes 52a, 52b, 52c, and 52d. Each of the slopes 52a, 52b, 52c, and 52d is a plane oblique to a thickness direction of the semiconductor layer 20. As shown in Figs. 10 and 11, such an uneven portion 50 reflects some of the light that is about to enter the photoelectric conversion region 20a in a direction intersecting with a traveling direction of some of the light. In addition, Fig. 5 shows an example in which the uneven portion 50 has a total of nine concave portions 51 arranged three each in the X direction and the Y direction. Further, in a case where there is no need to distinguish the slopes 52a, 52b, 52c, and 52d, the slopes 52a, 52b, 52c, and 52d are simply referred to as a slope 52 without distinction.

### <Pinning layer>

A pinning layer 41 is deposited on the surface (the second surface S2) of the semiconductor layer 20 on a side opposite to the surface of the semiconductor layer 20 on a side of the multilayer wiring layer 30. More specifically, the pinning layer 41 is deposited in a region including the surface S2a and the inner wall of the isolation trench 20b. The pinning layer 41 deposited on the surface S2a (the uneven portion 50) has a shape that follows the shape of the uneven portion 50. More specifically, the pinning layer 41 deposited on the uneven portion 50 has a shape that follows the shape of the concave portion 51.

The pinning layer 41 is formed using a high dielectric having a negative fixed charge such that a positive charge (hole) accumulation region is formed at the interface with the semiconductor layer 20 and the generation of a dark current is suppressed. When the pinning layer 41 is formed to have a negative fixed charge, an electric field is applied to the interface with the semiconductor layer 20 by the negative fixed charge, and thus the positive charge accumulation region is formed.

The pinning layer 41 is formed using hafnium oxide (HfOs), for example. In addition, the pinning layer 41 may be formed using zirconium dioxide (ZrOs), tantalum oxide (Ta₂O₅), or the like.

### <Insulating film>

The insulating film 42A is deposited on the surface of the pinning layer 41 on a side opposite to the surface of the pinning layer 41 on a side of the semiconductor layer 20 by, for example, a CVD method. The insulating film 42Ais, for example, a silicon oxide film. The insulating film 42A deposited on the uneven portion 50 via the pinning layer 41 is deposited to fill the depressions of the concave portions 51 of the uneven portion 50 and planarize the concave portions 51.

In addition, the insulating film 42A deposited in the isolation trench 20b via the pinning layer 41 is deposited to fill the isolation trench 20b and planarize the isolation trench 20b. A portion of the insulating film 42A deposited in the isolation trench 20b via the pinning layer 41 forms the isolation region 42 that partitions the adjacent photoelectric conversion regions 20a. The isolation region 42 has a deep trench isolation (DTI) structure in which an insulating film 42A is embedded in the isolation trench 20b.

### <Light blocking layer>

The light blocking layer 43 is stacked on the surface of the insulating film 42A on a side opposite to the surface of the insulating film 42A on a side of the pinning layer 41. More specifically, the light blocking layer 43 is provided in a region overlapping the isolation region 42 in a plan view. As a material of the light blocking layer 43, a material that blocks light may be used, and for example, tungsten (W), aluminum (Al), copper (Cu), or the like can be used.

### <Planarization film>

The planarization film 44 is formed to cover the surface of the insulating film 42A on a side opposite to the surface of the insulating film 42A on a side of the pinning layer 41 and the light blocking layer 43. For example, silicon oxide can be used as the material of the planarization film 44.

### <Wire grid polarizer>

Fig. 6A is a horizontal cross-sectional view showing a cross-sectional structure along a B-B section line of Fig. 4, and Fig. 4 is a vertical cross-sectional view showing a cross-sectional structure along a C-C section line of Fig. 6A. As shown in Fig. 6A, the wire grid polarizer 60 is an optical element that has a base material 61 and an aperture arrangement 62 formed in the base material 61, selects specific light, and supplies the selected light to the photoelectric conversion region 20a. More specifically, the wire grid polarizer 60 is an optical element that selects light having a specific plane of polarization according to an arrangement direction of apertures 63, which will be described below, of the aperture arrangement 62, and supplies the selected light to the photoelectric conversion region 20a. In addition, the wire grid polarizer 60 is disposed to overlap the photoelectric conversion region 20a in a plan view. More specifically, the wire grid polarizer 60 is disposed such that the aperture arrangement 62 overlaps the photoelectric conversion region 20a in a plan view. In a region of the wire grid polarizer 60, a region where the aperture arrangement 62 is provided is referred to as an aperture region 60a, and a region between the aperture regions 60a is referred to as a frame 60b.

The base material 61 includes a material forming a light reflection layer 64a, a material forming an insulating layer 64b, and a material forming a light absorption layer 64c, which will be described below. More specifically, the base material 61 includes a stacked material of films made of these materials. The material forming the light reflection layer 64a of these materials is provided closest to the photoelectric conversion region 20a. In addition, the material forming the light reflection layer 64a and the material forming for the light absorption layer 64c are made of a metal. In this way, the base material 61 has a metal film.

The aperture arrangement 62 has a plurality of apertures 63 arranged at equal pitches in the base material 61. The aperture 63 is a groove penetrating the base material 61 in the thickness direction of the semiconductor layer 20. The aperture arrangement 62 has a strip conductor 64 made of the base material 61 between two adjacent apertures 63. In other words, the aperture arrangement 62 forms a plurality of strip conductors 64 arranged at equal pitches.

The wire grid polarizer 60 has a plurality of types of aperture arrangements 62 in which arrangement directions of the apertures 63 (the strip conductors 64) are different from each other. Fig. 6A shows an example in which the wire grid polarizer 60 has four types of aperture arrangements 62 (aperture arrangements 62a, 62b, 62c, and 62d). The arrangement direction of the apertures 63 (the strip conductors 64) of the aperture arrangement 62a is the X direction. The arrangement direction of the apertures 63 (the strip conductors 64) of the aperture arrangement 62b is a direction 45 degrees to the X direction. The arrangement direction of the apertures 63 (the strip conductors 64) of the aperture arrangement 62c is a direction 90 degrees to the X direction. The arrangement direction of the apertures 63 (the strip conductors 64) of the aperture arrangement 62d is a direction 135 degrees to the X direction. In a case where it is not necessary to distinguish the arrangement directions of the apertures 63 (the strip conductors 64), the aperture arrangements 62a, 62b, 62c, and 62d are simply referred to as an aperture arrangement 62 without distinction.

As shown in Fig. 6C, an arrangement pitch P0 of the apertures 63 (the strip conductors 64) is set significantly smaller than the effective wavelength of the incident electromagnetic wave. The wire grid polarizer 60 reflects polarized light La (extinction axis light) parallel to the strip conductor 64 of the incident light and transmits polarized light Lb (transmission axis light) perpendicular to the strip conductor 64 of the incident light. Therefore, the wire grid polarizer 60 functions as a polarizer that transmits only light in a specific direction. In the four types of aperture arrangements 62a, 62b, 62c, and 62d described above, the apertures 63 are arranged in different directions, and the aperture arrangements 62a, 62b, 62c, and 62d transmit pieces of the polarized light in different directions. In addition, the wire grid polarizer 60 has features such as a high extinction ratio, high heat resistance, and compatibility with a wide wavelength range, compared to a resin polarizer. The wire grid polarizer 60 contains a highly reflective metallic material to reduce transmission polarization loss.

Further, as shown in Fig. 6B, the strip conductor 64 has a configuration in which the light reflection layer 64a, the insulating layer 64b, and the light absorption layer 64c are stacked in that order. The light reflection layer 64a is stacked on the surface of the planarization film 44 on a side opposite to the surface of the planarization film 44 on a side of the insulating film 42A. Further, the strip conductor 64 has a protective layer 64d at the outer periphery of the stacked light reflection layer 64a, insulating layer 64b, and light absorption layer 64c.

The light reflection layer 64a reflects the incident light. The light reflection layer 64a can be made of a conductive metal. Here, examples of a metal forming the light reflection layer 64a may include metal materials such as aluminum (Al), silver (Ag), gold (Au), copper (Cu), platinum (Pt), molybdenum (Mo), chromium (Cr), titanium (Ti), nickel (Ni), tungsten (W), iron (Fe), silicon (Si), germanium (Ge), tellurium (Te), and tantalum (Ta) and alloy materials containing these metals.

The light absorption layer 64c absorbs the incident light. Examples of a material forming for the light absorption layer 64c may include a metal material or an alloy material having an extinction coefficient k, which is not zero, that is, having a light absorption action. Specifically, examples thereof may include metal materials such as aluminum (Al), silver (Ag), gold (Au), copper (Cu), molybdenum (Mo), chromium (Cr), titanium (Ti), nickel (Ni), tungsten (W), iron (Fe), silicon (Si), germanium (Ge), tellurium (Te), and tin (Sn) and alloy materials containing these metals. In addition, examples of a material forming the light absorption layer 64c may include silicide-based materials such as FeSi₂ (especially β-FeSi₂), MgSi₂, NiSi₂, BaSi₂, CrSi₂, and CoSi₂. In particular, by using aluminum or an alloy thereof, or a semiconductor material containing β-FeSi₂, germanium, or tellurium as the material forming the light absorption layer 64c, a high contrast (an appropriate extinction ratio) can be obtained in a visible light region. In addition, in order to have polarization characteristics in a wavelength range other than visible light, for example, an infrared range, silver (Ag), copper (Cu), gold (Au), or the like is preferably used as the material forming the light absorption layer 64c. This is because the resonance wavelengths of these metals are in the vicinity of the infrared range.

The insulating layer 64b is an insulating material made of, for example, a silicon oxide film. The insulating layer 64b is disposed between the light reflection layer 64a and the light absorption layer 64c.

The protective layer 64d protects the light reflection layer 64a, the insulating layer 64b, and the light absorption layer 64c which are stacked in that order. This protective layer 64d can be formed of, for example, a silicon oxide film.

In addition, the wire grid polarizer 60 includes a planarization film 65 stacked on the end portion of the strip conductor 64 on a side opposite to the end portion of the strip conductor 64 on a side of the planarization film 44. This planarization film 65 can be formed of, for example, a silicon oxide film.

### <Interlayer insulating film>

Here, the insulating film 42A and the planarization film 44 described above are collectively referred to as an interlayer insulating film 46. The interlayer insulating film 46 is an insulating layer provided between the semiconductor layer 20 and the wire grid polarizer 60, which is an optical element. More specifically, the interlayer insulating film 46 is an insulating layer provided between the photoelectric conversion region 20a (the pinning layer 41) and the wire grid polarizer 60, which is an optical element. The insulating layer provided between the photoelectric conversion region 20a (the pinning layer 41) and the wire grid polarizer 60, which is an optical element, has a thickness of several ten nm to several pm (microns).

The light selected by the wire grid polarizer 60 passes through the interlayer insulating film 46 and is supplied to the photoelectric conversion region 20a. At that time, some of the light that is about to enter the photoelectric conversion region 20a is reflected by the uneven portion 50 in a direction different from the original direction.

### <<Method for manufacturing light detection device>>

A method for manufacturing the light detection device 1 will be described below with reference to Figs. 7A to 7K. First, as shown in Fig. 7A, the semiconductor layer 20 is prepared. More specifically, the n-type semiconductor region 22 is formed in the semiconductor layer 20. The n-type semiconductor region 22 is formed in the p-type semiconductor region 21 of the semiconductor layer 20.

Here, although the details of the manufacturing method are not shown, a transistor, a charge accumulation region FD, and the like for constituting the transfer transistor TR, the readout circuit 15, the logic circuit 13, and the like are formed in the region near the first surface S1 in the semiconductor layer 20 shown in Fig. 7A. The multilayer wiring layer 30 including the interlayer insulating film 31 and the wiring layer 32 is stacked on a side of the first surface S1 of the semiconductor layer 20. Furthermore, the support substrate 33 is bonded to the surface of the multilayer wiring layer 30 on a side opposite to the surface of the multilayer wiring layer 30 on a side of the semiconductor layer 20.

Next, as shown in Fig. 7B, a mask for forming the uneven portion 50 is stacked on a side of the second surface S2 of the semiconductor layer 20. More specifically, a film 71A for a hard mask is formed on a side of the second surface S2 of the semiconductor layer 20. The film 71Ais, for example, a silicon oxide film. Then, a resist pattern 72 is formed on the film 71A using known lithography technology and etching technology. After that, the film 71A is etched using the resist pattern 72 as a mask to form a hard mask 71 shown in Fig. 7C.

Then, as shown in Fig. 7C, the concave portions 51 are formed by etching the semiconductor layer 20 exposed from an aperture 71B of the hard mask 71. More specifically, crystalline anisotropic etching is performed to form the concave portions 51 in the semiconductor layer 20. Further, these concave portions 51 are formed in a portion of the semiconductor layer 20 which will later become the photoelectric conversion regions 20a. In other words, the concave portions 51 are formed in the semiconductor layer 20 at a portion corresponding to the photoelectric conversion region 20a. Through this process, the uneven portion 50 is formed on a side of the second surface S2 of the photoelectric conversion region 20a.

Next, as shown in Fig. 7D, the isolation trench 20b is formed in the p-type semiconductor regions 21 between the adjacent n-type semiconductor regions 22 using known lithography and etching technology. Through this process, the photoelectric conversion region 20a is partitioned into islands.

Then, as shown in Fig. 7E, the pinning layer 41 is deposited on the second surface S2 of the semiconductor layer 20, and heat treatment is performed. Before this process, the mask for etching is removed. After that, the insulating film 42A is deposited on the pinning layer 41, as shown in Fig. 7F. At this time, the concave portion 51 of the uneven portion 50 and the interior of the isolation trench 20b are also filled with the insulating film 42A. As a result, the isolation region 42 is formed.

Next, as shown in Fig. 7G, the light blocking layer 43 is formed on the insulating film 42A, and the planarization film 44 is deposited to cover the light blocking layer 43 and the insulating film 42A. Although not shown here, the light blocking layer 43 is formed by forming a film made of the material forming the light blocking layer 43 on the insulating film 42A and using known lithography and etching technology. In addition, the planarization film 44 is formed by depositing the material forming the planarization film 44 and then grinding and planarizing the surface of the deposited material by a chemical mechanical polishing (CMP) method or the like, although illustration is omitted here.

Then, as shown in Fig. 7H, a film 64aA made of the material forming the light reflection layer 64a, a film 64bA made of the material forming the insulating layer 64b, and a film 64cA made of the material forming the light absorption layer 64c are stacked on the planarization film 44 in that order.

Next, a mask for forming the strip conductors 64 of the wire grid polarizer 60 is formed on the film 64cA. More specifically, as shown in Fig. 7I, a film 73A for a hard mask is formed on the film 64cA, and a resist pattern 74 is formed thereon using known lithography and etching technology. Then, the film 73A is etched using the resist pattern 74 as a mask to form a hard mask 73 shown in Fig. 7J. The film 73A is, for example, a silicon oxide film.

Then, as shown in Fig. 7J, the film 64aA, the film 64bA, and the film 64cA are etched using the hard mask 73 to form the apertures 63, and the light reflection layer 64a, the insulating layer 64b, and the light absorption layer 64c are cut out for each strip conductor 64. After that, although not shown, the hard mask 73 is removed, and the protective layer 64d is formed to cover the light reflection layer 64a, the insulating layer 64b, and the light absorption layer 64c cut out. As a result, the formation of the strip conductor 64 is completed. After that, as shown in Fig. 7K, the planarization film 65 is formed on the strip conductor 64. As a result, the formation of the wire grid polarizer 60 is completed.

After the wire grid polarizer 60 is formed, although not shown, the microlens 45 is formed on the wire grid polarizer 60, and the light detection device 1 shown in Fig. 4 is almost completed. The light detection device 1 is formed in each of a plurality of chip forming regions partitioned by scribe lines (dicing lines) on a semiconductor substrate. By dividing the plurality of chip forming regions along scribe lines, the semiconductor chip 2 on each of which the light detection device 1 is mounted are formed.

### <<Main effects of first embodiment>>

Before describing the main effects of the first embodiment, first, the sensitivity of silicon shown in Fig. 8 will be described. The dashed line in Fig. 8 indicates the ideal value of the silicon sensitivity. The ideal silicon sensitivity is dependent on a wavelength as shown. The solid line in Fig. 8 indicates the value under the influence of light reflection occurring at the light incidence surface (the second surface S2) of the silicon. The solid line indicates a state in which reflected light interferes with light and causes the variation in silicon sensitivity. This sensitivity variation is referred to as a ripple. This light interference will be described in detail below with reference to Fig. 9.

Fig. 9 shows light interference in a light detection device 1' of the related art. The light detection device 1' of the related art includes a wire grid polarizer 60, a photoelectric conversion region 20a made of silicon, and an interlayer insulating film 46 provided between the wire grid polarizer 60 and the photoelectric conversion region 20a made of silicon, but does not include an uneven portion 50. Incident light L1 that has passed through the wire grid polarizer 60 and the interlayer insulating film 46 is about to enter silicon, but some of the incident light L1 is reflected by a second surface S2 of the silicon and becomes reflected light L2. Here, the interlayer insulating film 46 is made of silicon oxide, for example, and has a refractive index of n = 1.45, and silicon forming the photoelectric conversion region 20a has a refractive index of n = 4. Since there is such a large difference between the refractive index of the interlayer insulating film 46 and the refractive index of the silicon, according to Snell's law, some of the light that has passed through the wire grid polarizer 60 is reflected by an interface between the interlayer insulating film 46 and the silicon.

Furthermore, since the light reflection layer 64a of the wire grid polarizer 60 is made of a metal, the light reflection layer 64a easily reflects light. Therefore, in the light detection device provided with the wire grid polarizer 60, some of the reflected light L2 is reflected again by the light reflection layer 64a, and as a result, reflected light L3 returning from the light reflection layer 64a to the photoelectric conversion region 20a again is generated.

Further, since the light detection device 1' of the related art does not have the uneven portion 50, the second surface S2 of the photoelectric conversion region 20a is planar in the X-Y plane. Therefore, when the incident light L1 traveling in the Z direction is reflected by the second surface S2, the reflected light L2 also travels in the Z direction like the incident light L1. Furthermore, when the reflected light L2 traveling in the Z direction is reflected by the light reflection layer 64a, the reflected light L3 also travels in the Z direction like the incident light L1 and the reflected light L2. In this way, the incident light L1, the reflected light L2, and the reflected light L3 all travel in the Z direction, although travelling orientations thereof are different from each other. Therefore, at least two of the incident light L1, the reflected light L2, and the reflected light L3 may interfere with each other depending on the wavelength of the light and the film thickness d of the interlayer insulating film 46. Then, when light interference occurs and the light intensity is strengthened or weakened, a ripple occurs in the silicon sensitivity.

In the light detection device provided with such a wire grid polarizer 60, an interface is present between the light reflection layer 64a and the interlayer insulating film 46, and thus the reflected light L3 is generated. In addition, since the reflected light L3 is generated in the light detection device provided with the wire grid polarizer 60, light interference also occurs due to the reflected light L3. On the other hand, in a light detection device that does not include the wire grid polarizer 60, the light reflection layer 64a is not present in the first place, and thus there is no interface between the light reflection layer 64a and the interlayer insulating film 46, and the reflected light L3 is also less likely to occur. Therefore, in the light detection device provided with the wire grid polarizer 60, a ripple due to light interference is likely to occur in comparison with the light detection device not provided with the wire grid polarizer 60, and the amplitude of the occurring ripple can also be large in comparison with the light detection device not provided with the wire grid polarizer 60. Therefore, even if the ripple is negligible when the wire grid polarizer 60 is not provided, it may be affected by the addition of the wire grid polarizer 60. In this way, the light detection device 1' having an optical element such as the wire grid polarizer 60 is more affected by the light interference in comparison with the light detection device 1' having no optical element.

In addition, the occurrence of the ripple is dependent on the wavelength of light and the film thickness d of the interlayer insulating film 46 between the wire grid polarizer 60 and silicon. As a result, there are cases where the ripple becomes large at a specific film thickness or at a specific wavelength. For example, since the film thickness d of the interlayer insulating film 46 varies on the order of several tens of nm to 100 nm, the wavelength at which the ripple occurs varies depending on the variation in the film thickness d, which also affects the variation in product characteristics.

In contrast to such a light detection device 1' of the related art, the light detection device 1 according to the first example of the present technology is provided with the uneven portion 50 that reflects some of the incident light L1 that is about to enter the photoelectric conversion region 20a in a direction intersecting with a traveling direction of some of the light. As shown in Fig. 10, in the light detection device 1 according to the first example of the present technology, the incident light L1 is reflected by the slope 52 of the concave portion 51. At that time, the incidence angle of the incident light L1 with respect to the slope 52 is equal to the reflection angle of the reflected light L2 with respect to the slope 52. For example, in a case where the incident light L1 travels in the Z direction and comes into contact with the slope 52, the reflected light L2 is not reflected in the Z direction, but is reflected in a direction intersecting with the Z direction, that is, in an oblique direction. The reflected light L2 travels obliquely and is reflected by the interface between the light reflection layer 64a and the interlayer insulating film 46. More specifically, the reflected light L2 is reflected by a surface 64a1, which is an end surface of the light reflection layer 64a on a side of the photoelectric conversion region 20a. At this time, the reflected light L2 obliquely enters the surface 64a1, and the incidence angle of the reflected light L2 with respect to the surface 64a1 is equal to the reflection angle of the reflected light L3 with respect to the surface 64a1. Therefore, the reflected light L3 is reflected in a direction intersecting with the traveling direction of the reflected light L2.

In this way, in the light detection device 1 according to the first example of the present technology, the incident light L1, the reflected light L2, and the reflected light L3 are reflected not to return to their original directions. Therefore, interference between at least two of the incident light L1, the reflected light L2, and the reflected light L3 can be suppressed without depending on the wavelength of the light and the film thickness d of the interlayer insulating film 46. More specifically, by providing the uneven portion 50, the reflected light L2 is reflected in a direction that intersects the traveling direction of the incident light L1, and thus interference between the incident light L1 and the reflected light L2 can be suppressed. Furthermore, since the reflected light L2 is reflected obliquely by the uneven portion 50, even if an interface is present between the light reflection layer 64a and the interlayer insulating film 46, the reflected light L2 that has come into contact with the surface 64a1 of the light reflection layer 64a is reflected in a direction intersecting with the traveling direction of the reflected light L2. Therefore, it is possible to suppress interference between the reflected light L2 and the reflected light L3. In this way, although light is still reflected by the interface between the wire grid polarizer 60 and the interlayer insulating film 46 and by the interface between the interlayer insulating film 46 and the photoelectric conversion region 20a, as shown in Figs. 10 and 11, light is reflected in various directions by the uneven portion 50, and thus interference can be suppressed without depending on the wavelength of the light and the film thickness d of the interlayer insulating film 46. Therefore, even with the light detection device 1 having an optical element such as the wire grid polarizer 60, it is possible to suppress the occurrence of a ripple and suppress the variation in product characteristics.

Although the uneven portion 50 has a plurality of concave portions 51, it may have only one concave portion 51 as shown in Fig. 12. The size of the concave portion 51 in that case may be larger than that in a case where a plurality of concave portions 51 are provided. Even with such a configuration, since the concave portion 51 has the slopes 52a, 52b, 52c, and 52d, the same effect as that in the case of having a plurality of slopes can be obtained.

In addition, the strip conductor 64 has the light reflection layer 64a, the insulating layer 64b, the light absorption layer 64c, and the protective layer 64d, but the strip conductor 64 may have at least the light reflection layer 64a. Moreover, although the wire grid polarizer 60 has an air gap structure, the wire grid polarizer 60 may have a structure other than that. For example, an insulating film may be embedded in the aperture 63.

Further, in the manufacturing method described above, the isolation trench 20b is formed after the concave portion 51 has been formed, but the concave portion 51 may be formed after the isolation trench 20b has been formed.

### [Second embodiment]

A second embodiment of the present technology shown in Figs. 13 and 14 will be described below. A light detection device 1 according to the second embodiment differs from the light detection device 1 according to the first embodiment described above in that it has a groove 51A instead of the concave portion 51 having a shape of a square pyramid turned upside or down. Except for this point, the configuration of the light detection device 1 according to the second embodiment is basically the same as that of the light detection device 1 of the first embodiment described above. In addition, the same reference signs will be attached to the constituent elements already described, and the description thereof will be omitted.

### <Uneven portion>

The light detection device 1 has an uneven portion 50A instead of the uneven portion 50 of the first embodiment. In other words, the uneven portion 50A is formed in a photoelectric conversion region 20a on a side of an optical element. The uneven portion 50A has a plurality of grooves 51A recessed in a thickness direction of a semiconductor layer 20. More specifically, the groove 51Ais formed in the photoelectric conversion region 20a and recessed in the thickness direction of the semiconductor layer 20 from a side of a surface S2a of the photoelectric conversion region 20a. That is, the surface S2a has an uneven shape due to the grooves 51A. Figs. 13 and 14 show an example in which the uneven portion 50A has three grooves 51A, but the number of grooves is not limited to this. The plurality of grooves 51A are arranged at regular intervals in a first direction (for example, the X direction).

Even with the uneven portion 50A having such a configuration, incident light L1, reflected light L2, and reflected light L3 are reflected not to return to the original direction, as in the case of the uneven portion 50 of the first embodiment.

### <<Main effects of second embodiment>>

Even with the light detection device 1 according to the second embodiment, the same effects as those of the light detection device 1 according to the above-described first embodiment can be obtained.

Although the plurality of grooves 51A are arranged at equal intervals in the first direction, the grooves 51A may be disposed at different angles such that their central portions overlap each other. Fig. 15 shows an example in which four grooves 51A are disposed to form 0 degrees, 45 degrees, 90 degrees, and 135 degrees with respect to the X direction. In this way, the plurality of grooves 51A may be disposed in a star shape. In addition, Fig. 16 shows an example in which two grooves 51A are disposed to form 0 degrees and 90 degrees with respect to the X direction. In this way, the grooves 51A may be disposed crosswise.

In addition, the plurality of grooves 51A may be arranged in both the first direction and the second direction intersecting with the first direction. Fig. 17 shows an example in which three grooves 51A are arranged three each in the X direction and in the Y direction. In this case, the groove 51A may be square in a plan view.

### [Third embodiment]

A third embodiment of the present technology shown in Fig. 18 will be described below. A light detection device 1 according to the third embodiment differs from the light detection device 1 according to the first embodiment described above in that it has both a pixel 3 provided with a wire grid polarizer 60 and a pixel 3B not provided with a wire grid polarizer 60. Except for this point, the configuration of the light detection device 1 according to the third embodiment is basically the same as that of the light detection device 1 of the first embodiment described above. In addition, the same reference signs will be attached to the constituent elements already described, and the description thereof will be omitted.

### <Pixel>

The pixel 3B is not provided with the wire grid polarizer 60 as shown. The pixel not provided with such a wire grid polarizer 60 does not have an uneven portion 50. The pixel 3 provided with the wire grid polarizer 60 has the uneven portion 50.

### <<Main effects of third embodiment>>

Even with the light detection device 1 according to the third embodiment, the same effects as those of the light detection device 1 according to the above-described first embodiment can be obtained.

In the third embodiment, the pixel 3B not provided with the wire grid polarizer 60 does not have the uneven portion 50. However, as shown in Fig. 19, the pixel 3B not provided with the wire grid polarizer 60 may also be formed to have the uneven portion 50 as in the pixel 3 provided with the wire grid polarizer 60. In that case, a process of forming the uneven portion 50 can be the same step as in the first embodiment, and thus the cost for changing the process can be suppressed.

### [Fourth embodiment]

A fourth embodiment of the present technology shown in Figs. 20 to 22 will be described below. A light detection device 1 according to the fourth embodiment differs from the light detection device 1 according to the first embodiment described above in that it has a color filter and an uneven portion 50 is provided only in a photoelectric conversion region overlapping the color filter that color-separates a first color in a plan view. Except for this point, the configuration of the light detection device 1 according to the fourth embodiment is basically the same as that of the light detection device 1 of the first embodiment described above. In addition, the same reference signs will be attached to the constituent elements already described, and the description thereof will be omitted.

### <Color filter>

As shown in Fig. 20, the light detection device 1 is provided with a color filter layer 47. The color filter layer 47 is provided between a microlens 45 and a wire grid polarizer 60. More specifically, the color filter layer 47 is stacked on the surface of the wire grid polarizer 60 on a side opposite to the surface of the wire grid polarizer 60 on a side of an interlayer insulating film 46. For example, the color filter layer 47 color-separates incident light that is incident from a light incidence surface side of the light detection device 1 and has passed through the microlens 45 and supplies the color-separated incident light to the wire grid polarizer 60. The color filter layer 47 has a plurality of types of color filters 48 that separate different colors. Figs. 21 and 22 show an example in which the color filter layer 47 has four types of color filters 48 (color filters 48R, 48G, 48B, and 48Ir). The color filter 47R for red separates red, the color filter 47G for green separates green, the color filter 47B for blue separates blue, and the color filter 47Ir for near-infrared light separates near-infrared light. If there is no need to distinguish the colors separated by the color filters, the color filters 48R, 48G, 48B, and 48Ir are simply referred to as a color filter 48 without distinction. The color filter 48 is disposed to overlap an aperture arrangement 62 and a photoelectric conversion region 20a in a plan view.

The color filter 48 will be described in more detail below. As shown in Fig. 21, the color filters 48 are disposed to overlap a plurality of aperture arrangements 62 in a plan view. More specifically, the color filter 48 is disposed to overlap four aperture arrangements 62 (aperture arrangements 62a, 62b, 62c, and 62d) arranged in two rows and two columns in a plan view. Furthermore, as shown in Figs. 21 and 22, the color filter 48 is disposed to overlap a plurality of photoelectric conversion regions 20a in a plan view. More specifically, the color filter 48 is disposed to overlap four photoelectric conversion regions 20a arranged in two rows and two columns in a plan view.

Here, the interference of light depends on a wavelength and a film thickness d of the interlayer insulating film 46. Therefore, in the light detection device 1 having the color filter 48, some colors (a first color) of a plurality of colors of light may be affected by interference more strongly than other colors (a second color). The example shown in the fourth embodiment will be described on the assumption that near-infrared light is strongly affected by interference. More specifically, the example will be described on the assumption that near-infrared light is the first color, and each of red, green, and blue is the second color. Further, in order to distinguish the color filter 48 for color-separating the first color and the color filter 48 for color-separating the second color, the color filter 48 for color-separating the first color is referred to as a first color filter 481, and the color filter 48 for color-separating the second color is referred to as a second color filter 482. In the example shown in the fourth embodiment, the color filter 48Ir for near-infrared light is referred to as the first color filter 481, and each of the other color filters 48R, 48G, and 48B is referred to as a second color filter 482.

As shown in Fig. 22, the photoelectric conversion region 20a that overlaps the first color filter 481 in a plan view has the uneven portion 50. On the other hand, the photoelectric conversion region 20a that overlaps the second color filter 482 in a plan view does not have the uneven portion 50. That is, only the photoelectric conversion region 20a that overlaps the first color filter 481 in a plan view of the photoelectric conversion regions 20a that overlap either the first color filter 481 or the second color filter 482 in a plan view has the uneven portion 50.

### <<Main effects of fourth embodiment>>

Even with the light detection device 1 according to the fourth embodiment, the same effects as those of the light detection device 1 according to the above-described first embodiment can be obtained.

In addition, since only the photoelectric conversion region 20a that overlaps the first color filter 481 in a plan view has the uneven portion 50, even in a case where light with a specific color is strongly affected by interference, the affection of interference can be suppressed.

The color filter 48 of the light detection device 1 according to the fourth embodiment is disposed to overlap the plurality of aperture arrangements 62 and the plurality of photoelectric conversion regions 20a in a plan view, but the color filter 48 may be disposed to overlap a single aperture arrangement 62 and a single photoelectric conversion region 20a.

In addition, although it is described on the assumption that the near-infrared light is the first color, another color may be the first color. Furthermore, although the first color is only one color, it may include a plurality of colors.

### [Fifth embodiment]

A fifth embodiment of the present technology shown in Figs. 23A and 23B will be described below. A light detection device 1 according to the fifth embodiment differs from the light detection device 1 according to the first embodiment described above in that it has a plasmon filter as an optical element instead of the wire grid polarizer 60. Except for this point, the configuration of the light detection device 1 according to the fifth embodiment is basically the same as that of the light detection device 1 of the first embodiment described above. In addition, the same reference signs will be attached to the constituent elements already described, and the description thereof will be omitted.

### <Plasmon filter>

The light detection device 1 includes a plasmon filter 60D as an optical element. The plasmon filter 60D is a color filter using surface plasmon resonance. The plasmon filter 60D has a structure in which a periodic hole array with about half the light wavelength is formed in a metal thin film on an oxide film and covered with an oxide film and thus functions as a color filter that excites and propagates surface plasmons with specific frequency components determined by the period of the hole array at the interface between the metal and the oxide film. That is, the plasmon filter 60D is an optical element that selects specific light and supplies the selected light to a photoelectric conversion region 20a.

The plasmon filter 60D has a base material 61D and an aperture arrangement 62D formed in the base material 61D. In a region of the plasmon filter 60D, a region where the aperture arrangement 62D is provided is referred to as an aperture region 60Da, and a region between the aperture regions 60Da is referred to as a frame 60Db.

The base material 61D is a metal film. More specifically, the base material 61D is a metal thin film. Here, examples of a metal forming the base material 61D may include metal materials such as aluminum (Al), silver (Ag), gold (Au), copper (Cu), platinum (Pt), molybdenum (Mo), chromium (Cr), titanium (Ti), nickel (Ni), tungsten (W), iron (Fe), silicon (Si), germanium (Ge), tellurium (Te), and tantalum (Ta) and alloy materials containing these metals.

The aperture arrangement 62D has a plurality of apertures 63D arranged at equal pitches in the base material 61D. The aperture 63D is a circular hole in a plan view which penetrates the base material 61D in a thickness direction of a semiconductor layer 20.

The plasmon filter 60D has a plurality of types of aperture arrangements 62D with different diameters and arrangement pitches of the apertures 63D. The light to be selected by the plasmon filter 60D is determined according to at least one of the diameter and the arrangement pitch of the aperture 63D. Figs. 23A and 23B show two types of aperture arrangements 62D (aperture arrangements 62Da and 62Db). The types of aperture arrangements 62D that the plasmon filter 60D has are not limited to two types and may be one type or three or more types. The diameter of the aperture 63Da of the aperture arrangement 62Da is smaller than the diameter of the aperture 63Db of the aperture arrangement 62Db. In a case where it is not necessary to distinguish the types of aperture arrangements 62D, the aperture arrangements 62Da and 62Db are simply referred to as an aperture arrangement 62D without distinction.

Furthermore, as shown in Fig. 23B, the plasmon filter 60D includes an insulating layer 66D that fills the aperture 63D and covers the base material 61D. The insulating layer 66D is, for example, a silicon oxide film.

Each aperture 63D acts as a waveguide. Waveguides generally have a cutoff frequency and a cutoff wavelength determined by the shape such as the side length and the diameter thereof and have the property of not propagating light with a frequency equal to or lower than the cutoff frequency (or a wavelength equal to or higher than the cutoff wavelength). The cutoff wavelength of the aperture 63D mainly depends on the diameter of the aperture 63D, and the smaller the diameter, the shorter the cutoff wavelength. The diameter of the aperture 63D is set to a value smaller than the wavelength of light to be transmitted.

On the other hand, when light enters the base material 61D in which the apertures 63D are periodically formed at a short pitch equal to or shorter than the wavelength of the light, a phenomenon in which light having a wavelength longer than the cutoff wavelength of the aperture 63D is transmitted occurs. This phenomenon is called an anomalous transmission phenomenon of plasmons. This phenomenon occurs when surface plasmons are excited at the boundary between the base material 61D and the insulating layer 66D thereabove.

Here, the position of the plasmon filter 60D in the light detection device 1 is the same as that of the wire grid polarizer 60. That is, an interlayer insulating film 46 is provided between the plasmon filter 60D and the semiconductor layer 20. The plasmon filter 60D is disposed to overlap the photoelectric conversion region 20a in a plan view. More specifically, the plasmon filter 60D is disposed such that the aperture arrangement 62D overlaps the photoelectric conversion region 20a in a plan view.

Since the base material 61D of the plasmon filter 60D is made of a metal film, it easily reflects light. Since an interface is present between the plasmon filter 60D and the interlayer insulating film 46, reflected light L3 is generated as in the case of the wire grid polarizer 60. However, in the light detection device 1 according to the fifth example of the present technology, the photoelectric conversion region 20a is provided with an uneven portion 50 as in the case of the light detection device 1 according to the first example of the present technology, and thus light interference can be suppressed.

### <<Main effects of fifth embodiment>>

Even with the light detection device 1 according to the fifth embodiment, the same effects as those of the light detection device 1 according to the above-described first embodiment can be obtained.

### [Sixth embodiment]

A sixth embodiment of the present technology shown in Fig. 24 will be described below. A light detection device 1 according to the sixth embodiment differs from the light detection device 1 according to the first embodiment described above in that it has a guided mode resonance (GMR) color filter as an optical element instead of the wire grid polarizer 60. Except for this point, the configuration of the light detection device 1 according to the sixth embodiment is basically the same as that of the light detection device 1 of the first embodiment described above. In addition, the same reference signs will be attached to the constituent elements already described, and the description thereof will be omitted. Although a slit-shaped diffraction grating is illustrated in Fig. 24, a hole array-shaped diffraction grating may be used.

### <GMR color filter>

The light detection device 1 includes a GMR color filter 60E as an optical element. The GMR color filter 60E includes a diffraction grating 64E and a waveguide 65E and functions as a color filter that transmits only light having a wavelength that matches the diffraction angle of the diffraction grating 64E and the waveguide mode of the waveguide 65E. That is, the GMR color filter 60E is an optical element that selects specific light and supplies the selected light to a photoelectric conversion region 20a.

The GMR color filter 60E includes the waveguide 65E stacked on the surface of an interlayer insulating film 46 on a side opposite to the surface of the interlayer insulating film 46 on a side of a pinning layer 41 and a base material 61E stacked on the surface of the waveguide 65E on a side opposite to the surface of the waveguide 65E on a side of the interlayer insulating film 46. The diffraction grating 64E is formed in the base material 61E. More specifically, the diffraction grating 64E is an aperture arrangement 62E formed in the base material 61E. The aperture arrangement 62E has a plurality of apertures 63E arranged at equal pitches in the base material 61E. The aperture 63E is a groove penetrating the base material 61E in a thickness direction of a semiconductor layer 20. That is, the GMR color filter 60E has the base material 61E and the aperture arrangement 62E formed in the base material 61E.

The base material 61E is a metal film. More specifically, the base material 61 is a metal thin film. Here, examples of a metal forming the base material 61E may include metal materials such as aluminum (Al), silver (Ag), gold (Au), copper (Cu), platinum (Pt), molybdenum (Mo), chromium (Cr), titanium (Ti), nickel (Ni), tungsten (W), iron (Fe), silicon (Si), germanium (Ge), tellurium (Te), and tantalum (Ta) and alloy materials containing these metals.

Here, the position of the GMR color filter 60E in the light detection device 1 is the same as that of the wire grid polarizer 60. That is, the interlayer insulating film 46 is provided between the GMR color filter 60E and the semiconductor layer 20. The GMR color filter 60E is disposed to overlap the photoelectric conversion region 20a in a plan view. More specifically, the GMR color filter 60E is disposed such that the aperture arrangement 62E (the diffraction grating 64E) overlaps the photoelectric conversion region 20a in a plan view.

Since the base material 61E of the GMR color filter 60E is made of a metal film, it easily reflects light. Since an interface is present between the GMR color filter 60E and the interlayer insulating film 46, reflected light L3 is generated as in the case of the wire grid polarizer 60. However, in the light detection device 1 according to the sixth example of the present technology, the photoelectric conversion region 20a is provided with an uneven portion 50 as in the case of the light detection device 1 according to the first example of the present technology, and thus light interference can be suppressed.

### <<Main effects of sixth embodiment>>

Even with the light detection device 1 according to the sixth embodiment, the same effects as those of the light detection device 1 according to the above-described first embodiment can be obtained.

### [Seventh embodiment]

A seventh embodiment of the present technology shown in Fig. 25 will be described below. A light detection device 1 according to the seventh embodiment differs from the light detection device 1 according to the first embodiment described above in that it has a dielectric multilayer film color filter as an optical element instead of the wire grid polarizer 60. Except for this point, the configuration of the light detection device 1 according to the seventh embodiment is basically the same as that of the light detection device 1 of the first embodiment described above. In addition, the same reference signs will be attached to the constituent elements already described, and the description thereof will be omitted.

### <Color filter>

Fig. 25 shows a color filter 62F including a dielectric multilayer film color filter 60F and a waveguide mode resonance grating 61F. The light detection device 1 includes such a color filter 62F. The position of the color filter 62F in the light detection device 1 is the same as that of the wire grid polarizer 60. The color filter 62F is stacked on the surface of an interlayer insulating film 46 on a side opposite to the surface of the interlayer insulating film 46 on a side of a pinning layer 41. The interlayer insulating film 46 is provided between the color filter 62F and a semiconductor layer 20. The color filter 62F is disposed to overlap a photoelectric conversion region 20a in a plan view.

### <Waveguide mode resonance grating>

The waveguide mode resonance grating 61F is formed by stacking a lower clad layer 61F1, a waveguide diffraction layer 61F2, and an upper clad layer 61F3 in that order on the surface of the interlayer insulating film 46 on a side opposite to the surface of the interlayer insulating film 46 on a side of the pinning layer 41.

### <Dielectric multilayer film color filter>

The light detection device 1 includes the above dielectric multilayer film color filter 60F as an optical element. The dielectric multilayer film color filter 60F functions as a color filter that has a plurality of dielectric layers having different refractive indices and a control layer, selects light by forming the control layer to have different film thicknesses according to the wavelengths to be selected, and allows only the selected light to pass therethrough. That is, the dielectric multilayer film color filter 60F is an optical element that has a plurality of layers of dielectric materials having different refractive indices, selects specific light according to the film thickness of the dielectric material using light interference, and supplies the selected light to the photoelectric conversion region 20a. A region 62FB of the color filter 62F selects blue light B, a region 62FG of the color filter 62F selects green light G, and region 62FR of the color filter 62F selects red light R.

The dielectric multilayer film color filter 60F is a filter including a multilayer film 63F in which low refractive index layers and high refractive index layers are alternately stacked. As shown in Fig. 25, the multilayer film 63F is formed by stacking a lower mirror layer 64F, a control layer 65F, and an upper mirror layer 66F in that order on the surface of the waveguide mode resonance grating 61F on a side opposite to the surface of the waveguide mode resonance grating 61F on a side of the interlayer insulating film 46. In the lower mirror layer 64F, a high refractive index layer 64F1, a low refractive index layer 64F2, and a high refractive index layer 64F3 are stacked in that order from the surface of the waveguide diffraction layer 61F2 on a side opposite to the surface of the waveguide diffraction layer 61F2 on a side of the interlayer insulating film 46. Further, in the upper mirror layer 66F, a high refractive index layer 66F1, a low refractive index layer 66F2, and a high refractive index layer 66F3 are stacked in that order from a side of the control layer 65F. As a result, the lower mirror layer 64F and the upper mirror layer 66F function as mirrors whose reflecting surfaces face each other.

The control layer 65F is formed of a low refractive index layer and causes the interference of the light multiple-reflected by the reflecting surfaces of the lower mirror layer 64F and the upper mirror layer 66F. Thus, by changing the film thickness of the control layer 65F, the multilayer film 63F can constitute the dielectric multilayer film color filter 60F that transmits pieces of light having different wavelengths. A low refractive index material (for example, a silicon oxide (SiOs, refractive index 1.45)) can be adopted as the material of the low refractive index layers 64F2 and 66F2 and the control layer 65F. In addition, a high refractive index material (for example, a titanium oxide (TiOs, refractive index 2.5)) having a higher refractive index than the low refractive index layers 64F2, 65F, and 66F2 can be adopted as the material of the high refractive index layers 64F1, 64F3, 66F1, and 66F3. The low refractive index material and the high refractive index material may be either silicon nitride (SiₓN_{y}), silicon carbide (SiC), tantalum oxide (TaₓO_{y}), aluminum oxide (AlO₂), hafnium oxide (HfO₂), or amorphous silicon (a-Si).

The dielectric multilayer film color filter 60F utilizes the interference itself. Therefore, when the interference (the ripple) of light occurs in the interlayer insulating film 46, it is expected that the interference affects the transmission characteristics of the dielectric multilayer film color filter 60F.

However, in the light detection device 1 according to the seventh example of the present technology, the photoelectric conversion region 20a is provided with an uneven portion 50 as in the case of the light detection device 1 according to the first example of the present technology, and thus light interference can be suppressed. Therefore, it is possible to prevent the ripple from changing the transmission characteristics of the dielectric multilayer film color filter 60F.

### <<Main effects of seventh embodiment>>

Even with the light detection device 1 according to the seventh embodiment, the same effects as those of the light detection device 1 according to the above-described first embodiment can be obtained.

Although the light detection device 1 according to the seventh embodiment has both the dielectric multilayer film color filter 60F and the waveguide mode resonance grating 61F, the light detection device 1 may have only the dielectric multilayer film color filter 60F of these.

### [Eighth embodiment]

An eighth embodiment of the present technology shown in Fig. 26 will be described below. A light detection device 1 according to the eighth embodiment differs from the light detection device 1 according to the first embodiment described above in that it has a photonic crystal color filter as an optical element instead of the wire grid polarizer 60. Except for this point, the configuration of the light detection device 1 according to the eighth embodiment is basically the same as that of the light detection device 1 of the first embodiment described above. In addition, the same reference signs will be attached to the constituent elements already described, and the description thereof will be omitted.

### <Photonic crystal color filter>

The light detection device 1 includes a photonic crystal color filter 60G as an optical element. The photonic crystal color filter 60G uses the diffraction, scattering, and interference of light to control the transmission of light with a periodic structure. The photonic crystal color filter 60G is a structure whose refractive index periodically changes in the order of the wavelength of light. The photonic crystal color filter 60G is an optical element that has a plurality of layers of dielectric materials having different refractive indices, selects specific light according to the film thickness of the dielectric material using light interference, and supplies the selected light to the photoelectric conversion region 20a.

Here, while the dielectric multilayer film color filter 60F according to the seventh embodiment changes the refractive index difference one-dimensionally, the photonic crystal color filter 60G changes the refractive index two-dimensionally and three-dimensionally. In other words, the dielectric multilayer film color filter 60F according to the seventh embodiment can also be called a one-dimensional photonic crystal color filter 60G.

Fig. 26 shows a woodpile type three-dimensional photonic crystal color filter 60G as an example of the photonic crystal color filter 60G. The woodpile type three-dimensional photonic crystal color filter 60G has a structure in which a plurality of columnar high refractive media 61G are combined.

The photonic crystal color filter 60G utilizes the interference itself, like the dielectric multilayer film color filter 60F. Therefore, when the interference (the ripple) of light occurs in the interlayer insulating film 46, it is expected that the interference affects the transmission characteristics of the photonic crystal color filter 60G.

However, in the light detection device 1 according to the eighth example of the present technology, the photoelectric conversion region 20a is provided with an uneven portion 50 as in the case of the light detection device 1 according to the first example of the present technology, and thus light interference can be suppressed. Therefore, it is possible to prevent the ripple from changing the transmission characteristics of the photonic crystal color filter 60G.

### <<Main effects of eighth embodiment>>

Even with the light detection device 1 according to the eighth embodiment, the same effects as those of the light detection device 1 according to the above-described first embodiment can be obtained.

### [Ninth embodiment]

A ninth embodiment of the present technology shown in Fig. 27 will be described below. A light detection device 1 according to the ninth embodiment differs from the light detection device 1 according to the first embodiment described above in that it has a light blocking wall 49 that partitions photoelectric conversion regions and is made of a metal, and the light blocking wall 49 and a wire grid polarizer 60H are provided integrally with each other. Except for this point, the configuration of the light detection device 1 according to the ninth embodiment is basically the same as that of the light detection device 1 of the first embodiment described above. In addition, the same reference signs will be attached to the constituent elements already described, and the description thereof will be omitted. In addition, a cross-sectional structure along an A-A section line in Fig. 27 is the same as that of the horizontal cross-sectional view shown in Fig. 5, and a cross-sectional structure along a B-B section line in Fig. 27 is the same as that of the horizontal cross-sectional view shown in Fig. 6A. Therefore, the present embodiment will be described with reference to Figs. 5 and 6A. In that case, the reference sign indicating a wire grid polarizer should be read as "60H" instead of "60" described in Fig. 5 and Fig. 6A.

### <Stacked structure of light detection device>

As shown in Fig. 27, the light detection device 1 includes a multilayer wiring layer 30 including an interlayer insulating film 31 and a wiring layer 32 and a support substrate 33, which are sequentially stacked on a side of a first surface S1 of a semiconductor layer 20. In addition, the light detection device 1 includes members such as a pinning layer 41, an insulating film 42A, a wire grid polarizer 60H, which is an optical element, an insulating film 42B, and a microlens (an on-chip lens) 45, which are sequentially stacked on a side of a second surface S2 of the semiconductor layer 20. In addition, the light detection device 1 has an uneven portion 50 provided in a photoelectric conversion region 20a. At least some of the incident light which has been incident on the light detection device 1 passes the microlens 45, the insulating film 42B, the wire grid polarizer 60H, the insulating film 42A, the pinning layer 41, and the semiconductor layer 20 of the constituent elements described above in that order. The pinning layer 41 functions as an antireflection film on a side of the second surface S2 (a surface S2a which will be described below) of the semiconductor layer 20.

### <Stacked metal film>

As shown in Fig. 27, the light blocking wall 49 and the wire grid polarizer 60H, which will be described below, are provided integrally with each other using a stacked metal film 80 which is one stacked metal film. More specifically, a metal forming the light blocking wall 49 and a metal film of the wire grid polarizer 60H, which is an optical element, are different parts of the stacked metal film 80, which is one stacked metal film. This one stacked metal film is a metal film stacked in one film formation process, and even different parts are made of the same material (the same metal) and continuously connected to each other without a boundary. Therefore, the metal forming the light blocking wall 49 and a metal of the metal film of the wire grid polarizer 60H are the same, and the light blocking wall 49 and the wire grid polarizer 60H are continuously connected to each other without a boundary. The stacked metal film 80 is connected to the semiconductor layer 20 from a side of the second surface S2 in a peripheral region 2B. As a result, the potential of the stacked metal film 80, that is, the potential of the light blocking wall 49 and the wire grid polarizer 60H is fixed to the potential of the semiconductor layer 20 (a reference potential, for example, ground). Examples of a metal forming the stacked metal film 80 may include aluminum (Al), silver (Ag), tungsten (W), and the like. In the present embodiment, the stacked metal film 80 is assumed to be made of aluminum.

### <Wire grid polarizer>

As shown in Fig. 27, the wire grid polarizer 60H is provided closer to the microlens 45 than the light blocking wall 49. As shown in Fig. 6A, the wire grid polarizer 60H is an optical element that has a base material 61 and an aperture arrangement 62 formed in the base material 61, selects specific light, and supplies the selected light to the photoelectric conversion region 20a. The base material 61 of the wire grid polarizer 60H has aperture region 60a which is a region where the aperture arrangement 62 is provided and a frame 60b (a frame region) which is a region between the aperture regions 60a. The aperture region 60a is disposed at a position overlapping the photoelectric conversion region 20a in a plan view. In addition, the base material 61 has a metal film. In the present embodiment, the metal film of the base material 61 is a single layer, as shown in Fig. 27. The metal film of the base material 61 is a part of the stacked metal film 80. More specifically, the base material 61 is formed of the stacked metal film 80. The frame 60b is disposed at a position overlapping the light blocking wall 49 in the thickness direction, that is, at a position overlapping the light blocking wall 49 in a plan view. The frame 60b also functions as the light blocking layer 43 described in the first embodiment. The frame 60b has a function of blocking stray light leaking from adjacent pixels 3, for example. Therefore, in the present embodiment, there is no need to separately provide the light blocking layer 43 between the wire grid polarizer 60H and the photoelectric conversion region 20a, and it is possible to suppress an increase in the distance between the wire grid polarizer 60H and the photoelectric conversion region 20a.

### <Semiconductor layer>

As shown in Fig. 27, the semiconductor layer 20 has an island-shaped photoelectric conversion region (element formation region) 20a partitioned by an isolation region 42. The semiconductor layer 20 has a plurality of photoelectric conversion regions 20a disposed in an array in a plan view. The photoelectric conversion region 20a is provided for each pixel 3. The number of pixels 3 is not limited to that shown in Fig. 27. In addition, it is sufficient for at least a part of the photoelectric conversion region 20a to have a function of photoelectrically converting incident light. A region of the second surface S2 corresponding to the surface of the photoelectric conversion region 20a on a side of the wire grid polarizer 60H is referred to as a surface S2a. The isolation region 42 has a trench structure in which an isolation trench 20b is formed in the semiconductor layer 20 and a part of the insulating film 42A and the light blocking wall 49 made of a metal are embedded in the isolation trench 20b. In addition, the semiconductor layer 20 is provided with a shallow trench ST at a position overlapping the isolation region 42 in a plan view. The shallow trench ST faces the first surface S1. The photoelectric conversion region 20a has the uneven portion 50, as shown in Figs. 27 and 6. The uneven portion 50 has a concave portion 51 in a shape of a square pyramid turned upside or down. Since the uneven portion 50 has already been described in the first embodiment, detailed description thereof will be omitted. The light blocking wall 49 will be described below.

### <Light blocking wall>

As shown in Fig. 27, the insulating film 42A is provided between the light blocking wall 49 and the semiconductor layer 20 in the isolation trench 20b. The light blocking wall 49 and the semiconductor layer 20 are insulated by the insulating film 42A. The light blocking wall 49 has a portion extending in the Z direction and the X direction and a portion extending in the Z direction and the Y direction. Fig. 27 shows a configuration of a cut surface of the light detection device 1 perpendicular to the Y direction and shows a cross section of a portion of the light blocking wall 49 extending in the Z direction and the Y direction. Although the portion of the light blocking wall 49 extending in the Z direction and the X direction is not shown in the drawing, a configuration of a cut surface of the light detection device 1 perpendicular to the X direction will have the same shape as the cross section of the light blocking wall 49 shown in Fig. 27. With such a configuration, the light blocking wall 49 partitions the photoelectric conversion regions 20a. The photoelectric conversion region 20a is continuously surrounded from the sides. With such a configuration, the light blocking wall 49 blocks a portion between the photoelectric conversion regions 20a and optically isolates the photoelectric conversion regions 20a from each other. The light blocking wall 49 is desirably formed of a metal having a low light absorption rate, such as aluminum (Al) or silver (Ag). By forming the light blocking wall 49 using a metal having a low light absorption rate, the light absorbed by the light blocking wall 49 can be reduced, and the reflected light can be increased. As a result, the amount of light reflected by the light blocking wall 49 and returning to the semiconductor region (the photoelectric conversion unit) 22 can be increased.

The light blocking wall 49 is continuously connected to the frame 60b of the wire grid polarizer 60H without a boundary. More specifically, an end portion of the light blocking wall 49 on a side of the wire grid polarizer 60H of end portions of the light blocking wall 49 in the Z direction is continuously connected to the surface of the frame 60b on a side of the semiconductor layer 20 without a boundary. In this way, the light blocking wall 49 is continuously connected to the frame 60b without a boundary, and thus even if the light passing through the wire grid polarizer 60H obliquely travels, it is difficult for the light to enter the adjacent pixels. As a result, it is possible to suppress an increase in color mixture.

### <Insulating film>

The insulating film 42A is provided between the wire grid polarizer 60H and the photoelectric conversion region 20a and extends in a horizontal direction. The insulating film 42A planarizes the uneven portion 50 of the photoelectric conversion region 20a. The insulating film 42A is divided into regions corresponding to two adjacent photoelectric conversion regions 20a by the light blocking wall 49 extending toward the wire grid polarizer 60H. More specifically, a portion of the light blocking wall 49 extending in the Z direction and the Y direction divides the insulating film 42A into regions corresponding to two photoelectric conversion regions 20a adjacent in the X direction. Further, a portion of the light blocking wall 49 extending in the Z direction and the X direction divides the insulating film 42A into regions corresponding to two photoelectric conversion regions 20a adjacent in the Y direction. As a result, it is possible to prevent the insulating film 42Afrom becoming a path for color mixture (crosstalk).

A film thickness d1 of a portion of the insulating film 42A deposited along the surface S2a, that is, a portion positioned between the surface S2a and the wire grid polarizer 60H is equal to or more than a film thickness d2 of a portion of the insulating film 42A embedded in the isolation trench 20b (d1 ≥ d2). The portion of the insulating film 42A deposited along the surface S2a is made to be thick in order to planarize the unevenness of the uneven portion 50 using a CMP method. The insulating film 42A is formed of, but is not limited to, silicon oxide, for example. The insulating film 42B is also formed of, but is not limited to, silicon oxide, for example.

### <<Method for manufacturing light detection device>>

A method for manufacturing the light detection device 1 will be described below with reference to Figs. 28A to 28E. The detailed description of the forming method is omitted for the processes that have already been described in the first embodiment and the like.

First, a semiconductor substrate is prepared up to the state shown in Fig. 28A. More specifically, a semiconductor layer 20 in which a photoelectric conversion region 20a and an isolation trench 20b that opens toward a second surface S2 are formed is prepared. Next, as shown in Fig. 28B, crystalline anisotropic etching is performed to form an uneven portion 50 in the semiconductor layer 20 on a side of the second surface S2. After that, as shown in Fig. 28C, a pinning layer 41 and an insulating film 42A are deposited on an exposed surface (the second surface S2) of the semiconductor layer 20. In the state shown in Fig. 28C, the pinning layer 41 and the insulating film 42A are deposited on a wall surface of the isolation trench 20b and do not completely fill the isolation trench 20b. After that, an exposed surface of the insulating film 42A is planarized by the CMP method. Further, an opening h is formed in the peripheral region using known lithography technology and etching technology. The opening h penetrates the insulating film 42A and the pinning layer 41 and reaches the semiconductor layer 20.

Next, as shown in Fig. 28D, a stacked metal film 80 is deposited on the exposed surface of the insulating film 42A using a known method. Through this process, the inside of the isolation trench 20b is filled with the stacked metal film 80, and at the same time, the stacked metal film 80 is deposited on the planarized exposed surface of the insulating film 42A and in the opening h.

Then, as shown in Fig. 28E, an aperture arrangement 62 is formed in a portion of the stacked metal film 80 deposited on the planarized exposed surface of the insulating film 42A using the known lithography technology and etching technology. For example, the aperture arrangement 62 is formed by known lithography technology and dry etching. At this time, the charges accumulated in the stacked metal film 80 flow to the semiconductor layer 20 through a portion of the stacked metal film 80 deposited in the opening h. As a result, it is possible to suppress the influence of arcing. Thus, a wire grid polarizer 60H having an aperture region 60a and a frame 60b is obtained. Since the subsequent processes may be performed by a known method, description thereof is omitted here.

### <<Main effects of ninth embodiment>>

Before describing the main effects of the ninth embodiment, first, a light detection device of the related art will be described below. In the light detection device of the related art, light passing through the wire grid polarizer travels obliquely through an insulating film provided between the wire grid polarizer and the photoelectric conversion region, which may cause color mixture in adjacent pixels. In addition, when a large amount of light traveling obliquely through the semiconductor layer 20 passes through the isolation region 42, there is a possibility that color mixture in adjacent pixels will increase. As a result, there is a possibility that the extinction ratio of the wire grid polarizer 60H deteriorates. In addition, there is a possibility that a modulation transfer function (MTF), which is an index representing the resolution performance of the light detection device, deteriorates. In particular, near-infrared light has a smaller absorption coefficient with respect to silicon and travels longer in the silicon than other wavelengths (visible light) and thus has a tendency that color mixture in adjacent pixels occurs more easily than other wavelengths.

On the other hand, in the light detection device 1 according to the ninth embodiment of the present technology, a metal forming the light blocking wall 49 and a metal film of the wire grid polarizer 60H are different parts of the stacked metal film 80, which is one stacked metal film. Therefore, the light blocking wall 49 and the wire grid polarizer 60H are provided integrally with each other, and the light blocking wall 49 is continuously connected to the frame 60b without a boundary. Thus, even if the light passing through the wire grid polarizer 60H obliquely travels, the light is reflected by the light blocking wall 49 or the frame 60b, making it difficult for the light to enter adjacent pixels. Even near-infrared light is less likely to enter adjacent pixels. As a result, it is possible to suppress an increase in color mixture. As a result, deterioration of the extinction ratio of the wire grid polarizer 60H can be suppressed, and deterioration of the MTF of the light detection device 1 can be suppressed.

Further, in the light detection device 1 according to the ninth embodiment of the present technology, the insulating film 42A is divided into regions corresponding to two adjacent photoelectric conversion regions 20a by the light blocking wall 49. As a result, it is possible to prevent the insulating film 42Afrom becoming a path for color mixture and to prevent the color mixture from increasing. As a result, deterioration of the extinction ratio of the wire grid polarizer 60H can be suppressed, and deterioration of the MTF of the light detection device 1 can be suppressed.

Further, in the light detection device 1 according to the ninth embodiment of the present technology, the frame 60b also functions as the light blocking layer 43 described in the first embodiment. Therefore, there is no need to separately provide the light blocking layer 43 between the wire grid polarizer 60H and the photoelectric conversion region 20a, and it is possible to suppress an increase in the distance between the wire grid polarizer 60H and the photoelectric conversion region 20a. As a result, even in a case where light is obliquely incident, it becomes difficult for the light to enter adjacent pixels, and an increase in color mixture can be suppressed. As a result, deterioration of the extinction ratio of the wire grid polarizer 60H can be suppressed, and deterioration of the MTF of the light detection device 1 can be suppressed.

Further, in the light detection device 1 according to the ninth embodiment of the present technology, the light blocking wall 49 is formed of a metal having a low light absorption rate. Therefore, the light absorbed by the light blocking wall 49 can be reduced, and the reflected light can be increased. As a result, the amount of light reflected by the light blocking wall 49 and returning to the semiconductor region (the photoelectric conversion unit) 22 can be increased. As a result, deterioration of the quantum efficiency (QE) of the semiconductor region (the photoelectric conversion unit) 22 can be suppressed.

Further, in the light detection device 1 according to the ninth embodiment of the present technology, the stacked metal film 80 is connected to the semiconductor layer 20 in the peripheral region 2B. Therefore, the influence of arcing can be suppressed when the aperture arrangement 62 is formed in the stacked metal film 80.

Further, in the light detection device 1 according to the ninth embodiment of the present technology, the light blocking wall 49 and the wire grid polarizer 60H are formed together, and thus the number of processes can be reduced compared to the case of forming them separately.

### «Modification example of ninth embodiment»

Modification examples of the ninth embodiment will be described below. The drawings such as Fig. 5 and Fig. 6A may be used for explanation in each of the following modified examples. In this case, as for the reference sign indicating the wire grid polarizer, "60" described in the drawings such as Fig. 5 and Fig. 6A should be read as the reference sign of the wire grid polarizer described in each modification example.

### <Modification Example 1>

In the light detection device 1 according to the ninth embodiment, the light blocking wall 49 and the wire grid polarizer 60H are integrally formed of the same metal using the stacked metal film 80, which is one stacked metal film, but the present technology is not limited to this. In a light detection device 1 according to Modification Example 1 of the ninth embodiment shown in Fig. 29, a metal forming a light blocking wall 49 and a metal of a metal film of a wire grid polarizer 60I may be different.

The light detection device 1 according to Modification Example 1 of the ninth embodiment has the wire grid polarizer 60I instead of the wire grid polarizer 60H. A metal of the metal film of a base material 61 of the wire grid polarizer 60I is different from the metal forming the light blocking wall 49. More specifically, the light blocking wall 49 is formed of a stacked metal film 80, and the metal film of the wire grid polarizer 60I is formed of a stacked metal film 81 formed of a metal different from the metal forming the stacked metal film 80. The stacked metal film 81 is one stacked metal film different from the stacked metal film 80, and the stacked metal film 81 and the stacked metal film 80 are stacked in different processes. More specifically, the stacked metal film 81 is stacked after the stacked metal film 80 has been stacked. Further, the stacked metal film 81 is connected to a semiconductor layer 20 from a side of a second surface S2 in a peripheral region 2B.

As already explained, the light blocking wall 49 is desirably formed of a metal having a low light absorption rate, such as aluminum or silver. On the other hand, the wire grid polarizer 60I is desirably formed of a material (a metal) with many free electrons in consideration of polarization characteristics. Example of the material (the metal) with many free electrons include, but are not limited to, tungsten. In addition, aluminum and silver have a lower light absorption rate than tungsten. When the light blocking wall 49 and the wire grid polarizer 60I are formed of different metals, materials can be selected according to their characteristics. In the present modification example, it is described on the assumption that the metal forming the light blocking wall 49 (the metal forming the stacked metal film 80) is aluminum and the metal forming the metal film of the wire grid polarizer 60I (the metal forming the stacked metal film 81) is tungsten.

The light blocking wall 49 is continuously connected to a frame 60b of the wire grid polarizer 601. More specifically, an end portion of the light blocking wall 49 on a side of the wire grid polarizer 60I of end portions of the light blocking wall 49 in the Z direction is continuously connected to the surface of the frame 60b on a side of the semiconductor layer 20. Even if there is a gap between the light blocking wall 49 and the frame 60b, it is very small.

Even with the light detection device 1 according to Modification Example 1 of the ninth embodiment, the same effects as those of the light detection device 1 according to the above-described ninth embodiment can be obtained.

Further, in the light detection device 1 according to Modification Example 1 of the ninth embodiment, the wire grid polarizer 60I and the light blocking wall 49 are formed of different metals. Therefore, according to the characteristics required for the wire grid polarizer 60I and the light blocking wall 49, metals as materials can be individually selected. As a result, the characteristics of the wire grid polarizer 60I and the light blocking wall 49 can be improved independently.

### <Modification Example 2>

In the light detection device 1 according to Modification Example 1 of the ninth embodiment, a metal of the stacked metal film 80 forming the light blocking wall 49 and a metal of the stacked metal film 81 forming the wire grid polarizer 60I are different, but the present technology is not limited to this. In a light detection device 1 according to Modification Example 2 of the ninth embodiment, a metal of a stacked metal film 80 forming a light blocking wall 49 and a metal of a stacked metal film 81 forming a wire grid polarizer 60I may be the same. Fig. 29 will be used for explanation in the present modification example.

In the present modification example, the light blocking wall 49 is formed of the stacked metal film 80, and a metal film of the wire grid polarizer 60I is formed of the stacked metal film 81 formed of the same metal as the metal forming the stacked metal film 80. In the present modification example, it is described on the assumption that both the metal forming the light blocking wall 49 (the metal forming the stacked metal film 80) and the metal forming the metal film of the wire grid polarizer 60I (the metal forming the stacked metal film 81) are aluminum, but another metal (for example, tungsten or silver) may be used. The metal may be appropriately selected according to the performance required of the light detection device 1. The light blocking wall 49 is continuously connected to a frame 60b of the wire grid polarizer 601. More specifically, an end portion of the light blocking wall 49 on a side of the wire grid polarizer 60I of end portions of the light blocking wall 49 in the Z direction is continuously connected to the surface of the frame 60b on a side of the semiconductor layer 20. Even if there is a gap between the light blocking wall 49 and the frame 60b, it is very small.

Even with the light detection device 1 according to Modification Example 2 of the ninth embodiment, the same effects as those of the light detection device 1 according to the above-described ninth embodiment can be obtained. The configuration of the stacked metal film 80 of the present modification example may be applied to a stacked metal film 80 of a light detection device 1 according to any one of Modification Examples 3 to 5 of the ninth embodiment, which will be described below.

### <Modification Example 3>

In the light detection device 1 according to the ninth embodiment, the metal film of the wire grid polarizer 60H is one layer, but the present technology is not limited to this. In a light detection device 1 according to Modification Example 3 of the ninth embodiment shown in Fig. 30, a metal film of a wire grid polarizer 60J has a stacked structure of films of two layers.

Abase material 61 of the wire grid polarizer 60J has a stacked structure of a stacked metal film 82 (a first metal film) and a stacked metal film 80 (a second metal film) which is formed of a metal different from a metal forming the stacked metal film 82 and is located at a position closer to a semiconductor layer 20 than the stacked metal film 82 as metal films. On the other hand, the light blocking wall 49 is formed of a single film, more specifically, the stacked metal film 80 (the second metal film). The stacked metal film 80 is used for both the light blocking wall 49 and the wire grid polarizer 60J. That is, the metal forming the light blocking wall 49 and a metal of the stacked metal film 80 are the same. The stacked metal film 80 is formed of a metal having a low absorption rate, emphasizing the characteristics required for the light blocking wall 49 out of the light blocking wall 49 and the wire grid polarizer 60J. The stacked metal film 82 is used only for the wire grid polarizer 60J out of the light blocking wall 49 and the wire grid polarizer 60J and is formed of a material (a metal) with many free electrons, emphasizing the characteristics required for the wire grid polarizer 60J. That is, the wire grid polarizer 60J has a stacked metal film 82 for adjusting parameters of polarization characteristics. In the present modification example, it is described on the assumption that the stacked metal film 80 is formed of aluminum and the stacked metal film 82 is formed of tungsten, as an example.

Each of the stacked metal film 80 and the stacked metal film 82 is one stacked metal film. The stacked metal film 80 and the stacked metal film 82 are stacked in different processes. More specifically, first, the stacked metal film 80 is stacked, and then the stacked metal film 82 is stacked on the exposed surface of the stacked metal film 80. The stacked metal film 80 and the stacked metal film 82 are continuously connected to each other. Further, the stacked metal film 82 is connected to the semiconductor layer 20 from a side of a second surface S2 via the stacked metal film 80 in a peripheral region 2B.

Even with the light detection device 1 according to Modification Example 3 of the ninth embodiment, the same effects as those of the light detection device 1 according to the above-described ninth embodiment can be obtained.

Further, in the light detection device 1 according to Modification Example 3 of the ninth embodiment, the wire grid polarizer 60J has the stacked metal film 82 formed of a metal with many free electrons. Therefore, the polarization characteristics of the wire grid polarizer 60J can be improved independently.

### <Modification Example 4>

A wire grid polarizer 60K of a light detection device 1 according to Modification Example 4 of the ninth embodiment shown in Fig. 31 has an insulating film 42C between a stacked metal film 80 and a stacked metal film 82. That is, the stacked metal film 82 is stacked on the stacked metal film 80 via the insulating film 42C. The insulating film 42C is provided between the stacked metal film 80 and the stacked metal film 82, and thus the adhesion between dissimilar metals, that is, the adhesion between the stacked metal film 80 and the stacked metal film 82 is improved. In addition, the insulating film 42C is provided between the stacked metal film 80 and the stacked metal film 82, and thus the processing controllability of the aperture 63 and the strip conductor 64 of the aperture arrangement 62 (see Fig. 6A) is improved. More specifically, in the etching process for forming the aperture arrangement 62, first, the stacked metal film 82 is etched using the insulating film 42C as an etching stopper layer. At that time, even if the insulating film 42C is etched, it is slightly etched. As a result, even if an etching speed of the stacked metal film 82 differs depending on a position in a wafer plane, the etching stopper layer can make the progress of the etching of the stacked metal film 82 uniform within the wafer plane. After that, the insulating film 42C and the stacked metal film 80 can be etched. As a result, the shape controllability of the aperture 63 and the strip conductor 64 of the aperture arrangement 62 is improved.

Even with the light detection device 1 according to Modification Example 4 of the ninth embodiment, the same effects as those of the light detection device 1 according to the above-described ninth embodiment can be obtained. In addition, even with the light detection device 1 according to Modification Example 4 of the ninth embodiment, the same effects as those of the light detection device 1 according to the above-described Modification Example 3 of the ninth embodiment can be obtained.

In addition, in the light detection device 1 according to Modification Example 4 of the ninth embodiment, the insulating film 42C is provided between the stacked metal film 80 and the stacked metal film 82, and thus the adhesion between dissimilar metals and the shape controllability of the aperture 63 and the strip conductor 64 of the aperture arrangement 62 is improved.

### <Modification Example 5>

A wire grid polarizer 60J of the light detection device 1 according to Modification Example 5 of the ninth embodiment shown in Fig. 32 has the same configuration as the wire grid polarizer 60J of the light detection device 1 according to Modification Example 3 of the ninth embodiment shown in Fig. 30, but does not have the aperture arrangement 62 in an optical black region.

A pixel 3a is a pixel disposed in the optical black region of the light detection device 1. The pixel 3a is a part of the plurality of pixels 3 and is a pixel for obtaining a black level signal. The aperture arrangement 62 is not provided in a portion of the wire grid polarizer 60J which is disposed at a position overlapping the optical black region in a plan view, more specifically, in a portion of the wire grid polarizer 60J which is disposed at a position overlapping the pixel 3a in a plan view. Such a portion is called a light blocking region of the wire grid polarizer 60J. Since light is blocked by the portion of the wire grid polarizer 60J which covers the pixel 3a, even if light enters the pixel 3a, it is very small.

Even with the light detection device 1 according to Modification Example 5 of the ninth embodiment, the same effects as those of the light detection device 1 according to the above-described ninth embodiment can be obtained. In addition, even with the light detection device 1 according to Modification Example 5 of the ninth embodiment, the same effects as those of the light detection device 1 according to the above-described Modification Example 3 of the ninth embodiment can be obtained.

Further, in the light detection device 1 according to Modification Example 5 of the ninth embodiment, a base material 61 of the wire grid polarizer 60J has a stacked structure of a stacked metal film 82 (a first metal film) and a stacked metal film 80 (a second metal film) which is formed of a metal different from a metal forming the stacked metal film 82 and is located at a position closer to a semiconductor layer 20 than the stacked metal film 82 as metal films. Therefore, a thickness of the portion of the wire grid polarizer 60J which covers the pixel 3a in the Z direction is large, and the light blocking region can further block light that is about to enter the pixels 3a compared to the case with only the stacked metal film 80. In addition, since a thickness of the frame 60b in the Z direction is also large, a function for blocking light as the light blocking layer 43 is enhanced. Moreover, such a configuration can also be applied to the light detection device 1 according to Modification Example 4 of the ninth embodiment shown in Fig. 31, and the same effects as those of the present modification example can be obtained.

### <Modification Example 6>

The light detection device 1 according to the ninth embodiment has the uneven portion 50, but the present embodiment is not limited to this. Alight detection device 1 according to Modification Example 6 of the ninth embodiment shown in Fig. 33 has an uneven portion 50A (see Figs. 13 and 14), which is different in shape from the uneven portion 50. The uneven portion 50A has a plurality of grooves 51A recessed in a thickness direction of a semiconductor layer 20. Since the uneven portion 50A has already been described in the other embodiment, detailed description thereof will be omitted.

Even with the light detection device 1 according to Modification Example 6 of the ninth embodiment, the same effects as those of the light detection device 1 according to the above-described ninth embodiment can be obtained. The uneven portion may have a shape other than that of the uneven portion 50A. The uneven portion may have, for example, any one of the shapes described in the first to eighth embodiments of the present technology.

### <Modification Example 7>

The light detection device 1 according to the ninth embodiment has the uneven portion 50, but the present embodiment is not limited to this. Alight detection device 1 according to Modification Example 7 of the ninth embodiment shown in Fig. 34 does not have the uneven portion 50. More specifically, a photoelectric conversion region 20a is not provided with the uneven portion 50, and a second surface S2 of the photoelectric conversion region 20a is substantially planar.

Even with the light detection device 1 according to Modification Example 6 of the ninth embodiment, the same effects as those of the light detection device 1 according to the above-described ninth embodiment can be obtained.

### [Tenth embodiment]

### <1. Application example to electronic device>

Next, an electronic device according to a tenth embodiment of the present technology shown in Fig. 35 will be described. An electronic device 100 according to the tenth embodiment includes a light detection device (a solid-state imaging device) 101, an optical lens 102, a shutter device 103, a drive circuit 104, and a signal processing circuit 105. The electronic device 100 of the tenth embodiment shows an embodiment in which as the light detection device 101, the light detection device 1 described above is used for an electronic device (for example, a camera).

The optical lens (the optical system) 102 forms an image based on the image light (the incident light 106) from the subject on the imaging surface of the light detection device 101. As a result, signal charges are accumulated for a fixed time period in the light detection device 101. The shutter device 103 controls a light irradiation period and a light blocking period for the light detection device 101. The drive circuit 104 supplies a drive signal for controlling the transfer operation of the light detection device 101 and the shutter operation of the shutter device 103. The drive signal (the timing signal) supplied from the drive circuit 104 controls the signal transfer of the light detection device 101. The signal processing circuit 105 performs various kinds of signal processing on the signal (the pixel signal) output from the light detection device 101. An image signal having been subjected to the signal processing is stored in a storage medium such as a memory or output to a monitor.

With such a configuration, in the electronic device 100 of the tenth embodiment, it is possible to suppress light interference in the light detection device 101, and thus it is possible to improve the image quality of the image signal. In addition, it is possible to suppress color mixture of light, and thus it is possible to improve the image quality of the image signal.

The electronic device 100 to which the light detection device 1 according to each of the first to ninth embodiments and the modification examples thereof can be applied is not limited to the camera, and the light detection device 1 can also be applied to other electronic devices. For example, the light detection device 1 may be applied to an imaging device such as a camera module for a mobile device such as a mobile phone.

Further, in the tenth embodiment, as the light detection device 101, the light detection device 1 according to a combination of at least two of the embodiments from the first to ninth embodiment and the modification examples thereof can be used for an electronic device.

### <2. Application example to moving body>

The technology according to the present disclosure (the present technology) can be applied to various products. For example, the technology according to the present disclosure may be realized as a device equipped in any type of moving body such as an automobile, an electric vehicle, a hybrid electric vehicle, a motorcycle, a bicycle, a personal mobility device, an airplane, a drone, a ship, and a robot.

Fig. 36 is a block diagram illustrating a schematic configuration example of a vehicle control system which is an example of a moving body control system to which the technology according to the present disclosure can be applied.

The vehicle control system 12000 includes a plurality of electronic control units connected thereto via a communication network 12001. In the example illustrated in Fig. 36, the vehicle control system 12000 includes a drive system control unit 12010, a body system control unit 12020, a vehicle exterior information detection unit 12030, a vehicle interior information detection unit 12040, and an integrated control unit 12050. In addition, as a functional configuration of the integrated control unit 12050, a microcomputer 12051, an audio and image output unit 12052, and an in-vehicle network interface (I/F) 12053 are shown.

The drive system control unit 12010 controls operations of devices related to a drive system of a vehicle according to various programs. For example, the drive system control unit 12010 functions as a control device such as a driving force generation device for generating a driving force of a vehicle such as an internal combustion engine or a driving motor, a driving force transmission mechanism for transmitting a driving force to wheels, a steering mechanism for adjusting a turning angle of a vehicle, and a braking device for generating a braking force of a vehicle.

The body system control unit 12020 controls operations of various devices mounted in the vehicle body according to various programs. For example, the body system control unit 12020 functions as a control device of a keyless entry system, a smart key system, a power window device, or various lamps such as a headlamp, a back lamp, a brake lamp, a turn signal, and a fog lamp. In this case, radio waves transmitted from a portable device that substitutes for a key or signals of various switches may be input to the body system control unit 12020. The body system control unit 12020 receives inputs of the radio waves or signals and controls a door lock device, a power window device, and a lamp of the vehicle.

The vehicle exterior information detection unit 12030 detects information on the outside of the vehicle equipped with the vehicle control system 12000. For example, an imaging unit 12031 is connected to the vehicle exterior information detection unit 12030. The vehicle exterior information detection unit 12030 causes the imaging unit 12031 to capture an image of the outside of the vehicle and receives the captured image. The vehicle exterior information detection unit 12030 may perform object detection processing or distance detection processing for peoples, cars, obstacles, signs, and letters on the road on the basis of the received image.

The imaging unit 12031 is an optical sensor that receives light and outputs an electrical signal according to the amount of the received light. The imaging unit 12031 can also output the electrical signal as an image or distance measurement information. In addition, the light received by the imaging unit 12031 may be visible light or invisible light such as infrared light.

The vehicle interior information detection unit 12040 detects information on the inside of the vehicle. For example, a driver state detection unit 12041 that detects a driver's state is connected to the vehicle interior information detection unit 12040. The driver state detection unit 12041 includes, for example, a camera that captures an image of a driver, and the vehicle interior information detection unit 12040 may calculate a degree of fatigue or concentration of the driver or may determine whether or not the driver is dozing on the basis of detection information input from the driver state detection unit 12041.

The microcomputer 12051 can calculate a control target value of the driving force generation device, the steering mechanism, or the braking device on the basis of the information on the outside or the inside of the vehicle acquired by the vehicle exterior information detection unit 12030 or the vehicle interior information detection unit 12040 and output a control command to the drive system control unit 12010. For example, the microcomputer 12051 can perform cooperative control for the purpose of realizing functions of an advanced driver assistance system (ADAS) including collision avoidance or impact mitigation of a vehicle, following traveling based on inter-vehicle distance, vehicle speed maintenance driving, vehicle collision warning, vehicle lane deviation warning, or the like.

Further, the microcomputer 12051 can perform cooperative control for the purpose of automated driving or the like in which autonomous travel is performed without depending on operations of the driver by controlling the driving force generation device, the steering mechanism, the braking device, or the like on the basis of information on the surroundings of the vehicle acquired by the vehicle exterior information detection unit 12030 or the vehicle interior information detection unit 12040.

In addition, the microcomputer 12051 can output a control command to the body system control unit 12020 on the basis of the information on the outside of the vehicle acquired by the vehicle exterior information detection unit 12030. For example, the microcomputer 12051 can perform cooperative control for the purpose of preventing glare, such as switching from a high beam to a low beam, by controlling the headlamp according to the position of a preceding vehicle or an oncoming vehicle detected by the vehicle exterior information detection unit 12030.

The audio and image output unit 12052 transmits an output signal of at least one of an audio and an image to an output device capable of visually or audibly notifying an occupant of a vehicle or the outside of the vehicle of information. In the example of Fig. 36, an audio speaker 12061, a display unit 12062, and an instrument panel 12063 are illustrated as the output device. The display unit 12062 may include, for example, at least one of an onboard display and a head-up display.

Fig. 37 is a diagram illustrating an example of an installation position of the imaging unit 12031.

In Fig. 37, a vehicle 12100 includes imaging units 12101, 12102, 12103, 12104, and 12105 as the imaging unit 12031.

The imaging units 12101, 12102, 12103, 12104, and 12105 are provided at positions such as a front nose, side-view mirrors, a rear bumper, a back door, and an upper portion of a windshield in a vehicle interior of the vehicle 12100, for example. The imaging unit 12101 provided on the front nose and the imaging unit 12105 provided in the upper portion of the windshield in the vehicle interior mainly acquire images of a side in front of the vehicle 12100. The imaging units 12102 and 12103 provided on the side-view mirrors mainly acquire images of lateral sides from the vehicle 12100. The imaging unit 12104 provided on the rear bumper or the back door mainly acquires images of a side behind the vehicle 12100. The images of a side in front of the vehicle which are acquired by the imaging units 12101 and 12105 are mainly used for detection of preceding vehicles, pedestrians, obstacles, traffic signals, traffic signs, lanes, and the like.

Fig. 37 illustrates an example of imaging ranges of the imaging units 12101 to 12104. An imaging range 12111 indicates the imaging range of the imaging unit 12101 provided at the front nose, imaging ranges 12112 and 12113 respectively indicate the imaging ranges of the imaging units 12102 and 12103 provided at the side-view mirrors, and an imaging range 12114 indicates the imaging range of the imaging unit 12104 provided at the rear bumper or the back door. For example, a bird's-eye view image of the vehicle 12100 as viewed from above can be obtained by superimposition of image data captured by the imaging units 12101 to 12104.

At least one of the imaging units 12101 to 12104 may have a function for obtaining distance information. For example, at least one of the imaging units 12101 to 12104 may be a stereo camera constituted by a plurality of imaging elements or may be an imaging element that has pixels for phase difference detection.

For example, the microcomputer 12051 can extract, particularly, a closest three-dimensional object on a path along which the vehicle 12100 is traveling, which is a three-dimensional object traveling at a predetermined speed (for example, 0 km/h or higher) in the substantially same direction as the vehicle 12100, as a preceding vehicle by acquiring a distance to each of three-dimensional objects in the imaging ranges 12111 to 12114 and temporal change in the distance (a relative speed with respect to the vehicle 12100) on the basis of the distance information obtained from the imaging units 12101 to 12104. Further, the microcomputer 12051 can set an inter-vehicle distance which should be secured in front of the vehicle in advance with respect to the preceding vehicle and can perform automated brake control (also including following stop control) or automated acceleration control (also including following start control). In this way, it is possible to perform cooperative control for the purpose of automated driving or the like in which a vehicle autonomously travels without depending on operations of the driver.

For example, the microcomputer 12051 can classify and extract three-dimensional object data regarding three-dimensional objects into two-wheeled vehicles, ordinary vehicles, large vehicles, pedestrians, and other three-dimensional objects such as utility poles on the basis of the distance information obtained from the imaging units 12101 to 12104 and can use the three-dimensional object data for automatic avoidance of obstacles. For example, the microcomputer 12051 identifies obstacles in the vicinity of the vehicle 12100 into obstacles that can be visually recognized by the driver of the vehicle 12100 and obstacles that are difficult to be visually recognized by the driver. Then, the microcomputer 12051 can determine a risk of collision indicating the degree of risk of collision with each obstacle and can perform driving assistance for collision avoidance by outputting a warning to the driver through the audio speaker 12061 or the display unit 12062 and performing forced deceleration or avoidance steering through the drive system control unit 12010 when the risk of collision has a value equal to or greater than a set value and there is a possibility of collision.

At least one of the imaging units 12101 to 12104 may be an infrared camera that detects infrared rays. For example, the microcomputer 12051 can recognize a pedestrian by determining whether there is a pedestrian in the captured images of the imaging units 12101 to 12104. Such pedestrian recognition is performed by, for example, a procedure in which feature points in the captured images of the imaging units 12101 to 12104 as infrared cameras are extracted and a procedure in which pattern matching processing is performed on a series of feature points indicating the outline of the object and it is determined whether the object is a pedestrian. When the microcomputer 12051 determines that there is a pedestrian in the captured images of the imaging units 12101 to 12104, and the pedestrian is recognized, the audio and image output unit 12052 controls the display unit 12062 such that the recognized pedestrian is superimposed and displayed with a square contour line for emphasis. In addition, the audio and image output unit 12052 may control the display unit 12062 such that an icon or the like indicating a pedestrian is displayed at a desired position.

An example of the vehicle control system to which the technology according to the present disclosure can be applied has been described above. The technology according to the present disclosure may be applied, for example, to the imaging unit 12031 or the like among the configurations described above. Specifically, the light detection device 1 described in any one of the first to ninth embodiments can be applied to the imaging unit 12031. By applying the technology according to the present disclosure to the imaging unit 12031, a clearer captured image can be obtained, and thus it is possible to reduce a driver's fatigue.

### <3. Application example to endoscopic surgery system>

The technology according to the present disclosure (the present technology) can be applied to various products. For example, the technology according to the present disclosure may be applied to an endoscopic surgery system.

Fig. 38 is a diagram showing an example of a schematic configuration of an endoscopic surgery system to which the technology according to the present disclosure (the present technology) can be applied.

Fig. 38 shows a state where a surgeon (a doctor) 11131 is performing a surgical operation on a patient 11132 on a patient bed 11133 using an endoscopic surgery system 11000. As shown in the drawing, the endoscopic surgery system 11000 includes an endoscope 11100, other surgical instruments 11110 such as a pneumoperitoneum tube 11111 and an energized treatment tool 11112, a support arm device 11120 that supports the endoscope 11100, and a cart 11200 equipped with various devices for endoscopic surgery.

The endoscope 11100 includes a lens barrel 11101, a region of which having a predetermined length from a distal end is inserted into a body cavity of the patient 11132 and a camera head 11102 connected to a proximal end of the lens barrel 11101. Although the endoscope 11100 configured as a so-called rigid mirror having the rigid lens barrel 11101 is shown in the shown example, the endoscope 11100 may be configured as a so-called flexible mirror having a flexible lens barrel.

An opening in which an objective lens is fitted is provided at the distal end of the lens barrel 11101. A light source device 11203 is connected to the endoscope 11100, and light generated by the light source device 11203 is guided to the distal end of the lens barrel by a light guide extending inside the lens barrel 11101 and is radiated toward the observation target in the body cavity of the patient 11132 via the objective lens. The endoscope 11100 may be a direct-viewing endoscope or may be a perspective endoscope or a side-viewing endoscope.

An optical system and an imaging element are provided inside the camera head 11102, and the reflected light (observation light) from the observation target converges on the imaging element by the optical system. The observation light is photoelectrically converted by the imaging element, and an electrical signal corresponding to the observation light, that is, an image signal corresponding to an observation image is generated. The image signal is transmitted to a camera control unit (CCU) 11201 as RAW data.

The CCU 11201 is constituted by a central processing unit (CPU), a graphics processing unit (GPU), and the like and comprehensively controls the operation of the endoscope 11100 and a display device 11202. In addition, the CCU 11201 receives an image signal from the camera head 11102 and performs various types of image processing for displaying an image based on the image signal, for example, development processing (demosaic processing) on the image signal.

The display device 11202 displays an image based on an image signal having been subjected to image processing by the CCU 11201 under the control of the CCU 11201.

The light source device 11203 is constituted by, for example, a light source such as a light emitting diode (LED) and supplies radiation light at the time of imaging a surgical site or the like to the endoscope 11100.

An input device 11204 is an input interface for the endoscopic surgery system 11000. The user can input various types of information or instructions to the endoscopic surgery system 11000 via the input device 11204. For example, the user inputs an instruction to change imaging conditions (a type of radiation light, a magnification, a focal length, or the like) of the endoscope 11100.

A treatment tool control device 11205 controls the driving of the energized treatment tool 11112 for cauterizing or incising tissue, sealing a blood vessel, or the like. In order to secure a field of view of the endoscope 11100 and secure an operation space of the surgeon, a pneumoperitoneum device 11206 sends gas into the body cavity of the patient 11132 via the pneumoperitoneum tube 11111 in order to inflate the body cavity. A recorder 11207 is a device that can record various types of information related to surgery. A printer 11208 is a device that can print various types of information related to surgery in various formats such as text, images and graphs.

The light source device 11203 that supplies the endoscope 11100 with the radiation light for imaging the surgical site can be configured of, for example, an LED, a laser light source, or a white light source configured of a combination thereof. When a white light source is formed by a combination of RGB laser light sources, it is possible to control an output intensity and an output timing of each color (each wavelength) with high accuracy, and thus the light source device 11203 can adjust white balance of the captured image. Further, in this case, laser light from each of the respective RGB laser light sources is radiated to the observation target in a time division manner, and driving of the imaging element of the camera head 11102 is controlled in synchronization with radiation timing such that images corresponding to respective RGB can be captured in a time division manner. According to this method, it is possible to obtain a color image without providing a color filter to the imaging element.

Further, the driving of the light source device 11203 may be controlled to change the intensity of output light at predetermined time intervals. The driving of the imaging element of the camera head 11102 is controlled in synchronization with the timing of the change in the light intensity to acquire an image in a time division manner, and the image is synthesized, whereby it is possible to generate a so-called image in a high dynamic range without underexposure or overexposure.

In addition, the light source device 11203 may have a configuration in which light in a predetermined wavelength band corresponding to special light observation can be supplied. In the special light observation, for example, by emitting light in a band narrower than that of radiation light (that is, white light) during normal observation using wavelength dependence of light absorption in a body tissue, so-called narrow band light observation (narrow band imaging) in which a predetermined tissue such as a blood vessel in a mucous membrane surface layer is imaged with a high contrast is performed. Alternatively, in the special light observation, fluorescence observation in which an image is obtained by fluorescence generated by emitting excitation light may be performed. The fluorescence observation can be performed by emitting excitation light to a body tissue and observing fluorescence from the body tissue (autofluorescence observation), or locally injecting a reagent such as indocyanine green (ICG) to a body tissue and emitting excitation light corresponding to a fluorescence wavelength of the reagent to the body tissue to obtain a fluorescence image. The light source device 11203 may have a configuration in which narrow band light and/or excitation light corresponding to such special light observation can be supplied.

Fig. 39 is a block diagram showing an example of a functional configuration of the camera head 11102 and the CCU 11201 shown in Fig. 38.

The camera head 11102 includes a lens unit 11401, an imaging unit 11402, a drive unit 11403, a communication unit 11404, and a camera head control unit 11405. The CCU 11201 includes a communication unit 11411, an image processing unit 11412, and a control unit 11413. The camera head 11102 and the CCU 11201 are connected to each other such that they can communicate with each other via a transmission cable 11400.

The lens unit 11401 is an optical system provided at a portion for connection to the lens barrel 11101. Observation light taken from the tip of the lens barrel 11101 is guided to the camera head 11102 and is incident on the lens unit 11401. The lens unit 11401 is constituted by a combination of a plurality of lenses including a zoom lens and a focus lens.

The imaging unit 11402 is constituted by an imaging element. The imaging element constituting the imaging unit 11402 may be one element (a so-called single plate type) or a plurality of elements (a so-called multi-plate type). When the imaging unit 11402 is configured as a multi-plate type, for example, image signals corresponding to RGB are generated by the imaging elements, and a color image may be obtained by synthesizing the image signals. Alternatively, the imaging unit 11402 may be configured to include a pair of imaging elements for acquiring image signals for the right eye and the left eye corresponding to three-dimensional (3D) display. When 3D display is performed, the surgeon 11131 can ascertain the depth of biological tissues in the surgical site more accurately. Here, when the imaging unit 11402 is configured as a multi-plate type, a plurality of systems of lens units 11401 may be provided according to the imaging elements.

Further, the imaging unit 11402 may not necessarily be provided in the camera head 11102. For example, the imaging unit 11402 may be provided immediately after the objective lens inside the lens barrel 11101.

The drive unit 11403 is constituted by an actuator and moves the zoom lens and the focus lens of the lens unit 11401 by a predetermined distance along an optical axis under the control of the camera head control unit 11405. Thereby, the magnification and the focus of the image captured by the imaging unit 11402 can be appropriately adjusted.

The communication unit 11404 is constituted by a communication device for transmitting or receiving various types of information to or from the CCU 11201. The communication unit 11404 transmits the image signal obtained from the imaging unit 11402 as RAW data to the CCU 11201 via the transmission cable 11400.

In addition, the communication unit 11404 receives a control signal for controlling driving of the camera head 11102 from the CCU 11201 and supplies the control signal to the camera head control unit 11405. The control signal includes, for example, information on the imaging conditions such as information indicating that the frame rate of the captured image is designated, information indicating that the exposure value at the time of imaging is designated, and/or information indicating that the magnification and the focus of the captured image are designated.

The imaging conditions such as the frame rate, the exposure value, the magnification, and the focus may be appropriately designated by the user, or may be automatically set by the control unit 11413 of the CCU 11201 on the basis of the acquired image signal. In the latter case, a so-called auto exposure (AE) function, a so-called auto focus (AF) function, and a so-called auto white balance (AWB) function are provided in the endoscope 11100.

The camera head control unit 11405 controls the driving of the camera head 11102 on the basis of the control signal from the CCU 11201 received via the communication unit 11404.

The communication unit 11411 is constituted by a communication device for transmitting and receiving various types of information to and from the camera head 11102. The communication unit 11411 receives the image signal transmitted from the camera head 11102 via the transmission cable 11400.

In addition, the communication unit 11411 transmits a control signal for controlling the driving of the camera head 11102 to the camera head 11102. The image signal or the control signal can be transmitted through electric communication, optical communication, or the like.

The image processing unit 11412 performs various types of image processing on the image signal which is the RAW data transmitted from the camera head 11102.

The control unit 11413 performs various kinds of control regarding the imaging of the surgical site or the like using the endoscope 11100 and a display of a captured image obtained by imaging the surgical site or the like. For example, the control unit 11413 generates the control signal for controlling the driving of the camera head 11102.

Further, the control unit 11413 causes the display device 11202 to display the captured image obtained by imaging the surgical site or the like on the basis of the image signal having subjected to the image processing by the image processing unit 11412. In this case, the control unit 11413 may recognize various objects in the captured image using various image recognition technologies. For example, the control unit 11413 can recognize surgical instruments such as forceps, a specific biological part, bleeding, mist when the energized treatment tool 11112 is used, and the like by detecting the edge shape and color of the object included in the captured image. When the control unit 11413 causes the display device 11202 to display the captured image, it may cause various types of surgical support information to be superimposed and displayed with the image of the surgical site using the recognition result. When the surgical support information is superimposed and displayed and is presented to the surgeon 11131, it is possible to reduce the burden on the surgeon 11131, and the surgeon 11131 can reliably proceed the surgery.

The transmission cable 11400 connecting the camera head 11102 and the CCU 11201 to each other is an electric signal cable that deals with electric signal communication, an optical fiber that deals with optical communication, or a composite cable thereof.

Here, in the example shown in the drawing, communication is performed in a wired manner using the transmission cable 11400, but communication between the camera head 11102 and the CCU 11201 may be performed in a wireless manner.

The example of the endoscopic surgery system to which the technology according to the present disclosure can be applied has been described above. The technology according to the present disclosure may be applied, for example, to the imaging unit 11402 among the configurations described above. Specifically, the light detection device 1 described in any one of the first to ninth embodiments can be applied to the imaging unit 11402. By applying the technology according to the present disclosure to the imaging unit 11402, a clearer image of the surgical site can be obtained, and thus it is possible for the surgeon to reliably check the surgical site.

While the endoscopic surgery system has been described here as an example, the technology according to the present disclosure may be applied to other systems, for example, a microscopic surgery system.

### [Other embodiments]

As described above, the present technology has been described through the first to tenth embodiments, but the description and the drawings that form a part of this disclosure should not be understood to limit the present technology. Various alternative embodiments, examples, and operable techniques will be apparent to those skilled in the art from the present disclosure.

For example, it is possible to combine the technical ideas described in the first to tenth embodiments with each other. For example, in the light detection device 1 according to the above-described second embodiment, the uneven portion 50A is provided with the groove 51A instead of the concave portion 51, but such technical ideas may be applied to the light detection device 1 described in each of the third to eighth embodiments.

Further, for example, in the light detection device 1 according to the above-described fourth embodiment, only the photoelectric conversion region overlapping the color filter that color-separates the first color has the uneven portion 50, but such a technical idea may be applied to the light detection device 1 described in each of the fifth to eighth embodiments. Further, various combinations are possible according to the technical ideas, such as employing the plasmon filter or the GMR color filter as the optical element of the light detection device 1 of the ninth embodiment.

In addition, the light detection device 1 may be a stacked CIS (CMOS image sensor) in which two or more semiconductor substrates are superimposed and stacked. In that case, at least one of the logic circuit 13 and the readout circuit 15 may be provided on a substrate different from the semiconductor substrate on which the photoelectric conversion region 20a is provided among these semiconductor substrates.
Further, the present technology can be applied not only to the solid-state imaging device as the image sensor, but also to light detection devices in general, including a distance measuring sensor that measures a distance, also called a time of flight (ToF) sensor. The distance measuring sensor is a sensor that emits irradiation light toward an object, detects the reflected light which is reflected by the surface of the object and returns thereto, and calculates the distance to the object on the basis of the flight time from the emission of the irradiation light to the reception of the reflected light. As a light reception pixel structure of this distance measuring sensor, the structure of the pixel 3 described above can be adopted.

In this way, it is of course that the present technology includes various embodiments and the like that are not described herein. Therefore, the technical scope of the present technology is to be determined only by the matters specifying the invention described in the claims that are reasonable from the above description.

Furthermore, the effects described in the present specification are merely exemplary and not intended to be limited, and other effects may be provided as well.

The present technology may have the following configurations.
(1) A light detection device including:
   a semiconductor layer that has a photoelectric conversion region which photoelectrically converts incident light; and
   an optical element that has a metal film and an aperture arrangement formed in the metal film, selects specific light, supplies the selected light to the photoelectric conversion region, and is disposed to overlap the photoelectric conversion region in a plan view,
   wherein the photoelectric conversion region on a side of the optical element has an uneven portion.
(2) The light detection device according to (1), wherein the uneven portion has a surface oblique to a thickness direction of the semiconductor layer.
(3) The light detection device according to (1), wherein the uneven portion has one concave portion having a surface oblique to a thickness direction of the semiconductor layer.
(4) The light detection device according to (1), wherein the uneven portion has a plurality of concave portions each having a surface oblique to a thickness direction of the semiconductor layer.
(5) The light detection device according to (1), wherein the uneven portion has a groove recessed in a thickness direction of the semiconductor layer.
(6) The light detection device according to any one of (1) to (5), further including an interlayer insulating film provided between the semiconductor layer and the optical element.
(7) The light detection device according to any one of (1) to (6), wherein the optical element is a wire grid polarizer.
(8) The light detection device according to (7), further including a color filter that color-separates incident light and supplies the color-separated incident light to the wire grid polarizer,
   wherein the color filter includes a first color filter that separates light with a first color and a second color filter that separates light with a second color, and only the photoelectric conversion region that overlaps the first color filter of the photoelectric conversion regions that overlap either the first color filter or the second color filter in a plan view has the uneven portion.
(9) The light detection device according to any one of (1) to (6), wherein the optical element is a color filter using surface plasmon resonance.
(10) The light detection device according to any one of (1) to (6), wherein the optical element is a GMR color filter.
(11) The light detection device according to any one of (1) to (10), wherein a plurality of the photoelectric conversion regions disposed in an array in a plan view are provided,
   a light blocking wall partitioning the photoelectric conversion regions and made of a metal is provided,
   the metal film of the optical element has an aperture region where the aperture arrangement is provided and a frame region between the aperture regions,
   the aperture region is disposed at a position overlapping the photoelectric conversion region in a plan view,
   the frame region is disposed at a position overlapping the light blocking wall in a plan view, and
   the light blocking wall is connected to a surface of the frame region on a side of the semiconductor layer.
(12) The light detection device according to (11), wherein the metal forming the light blocking wall and a metal of the metal film of the optical element are the same.
(13) The light detection device according to (12), wherein the metal forming the light blocking wall and the metal film of the optical element are different parts of one stacked metal film.
(14) The light detection device according to (11), wherein the metal forming the light blocking wall and a metal of the metal film of the optical element are different.
(15) The light detection device according to any one of (11) to (13), wherein the metal film of the optical element has a stacked structure of a first metal film and a second metal film which is formed of a metal different from a metal forming the first metal film and is located at a position closer to the semiconductor layer than the first metal film, and
   the metal forming the light blocking wall and a metal of the second metal film are the same.
(16) The light detection device according to (15), wherein the first metal film is stacked on the second metal film via an insulating film.
(17) The light detection device according to (15) or (16), wherein the metal film of the optical element has a light blocking region which is disposed at a position overlapping some pixels of the plurality of photoelectric conversion regions in a plan view and does not have the aperture arrangement.
(18) An electronic device including a light detection device and an optical system that forms an image based on image light from a subject on the light detection device, wherein the light detection device includes:
   a semiconductor layer that has a photoelectric conversion region which photoelectrically converts incident light; and
   an optical element that has a metal film and an aperture arrangement formed in the metal film, selects specific light, supplies the selected light to the photoelectric conversion region, and is disposed to overlap the photoelectric conversion region in a plan view, and
   the photoelectric conversion region on a side of the optical element has an uneven portion.
(19) A light detection device including:
   a semiconductor layer that has a photoelectric conversion region which converts incident light into signal charges; and
   an optical element that has a plurality of layers of dielectric materials having different refractive indices, selects specific light according to a film thickness of the dielectric material, supplies the selected light to the photoelectric conversion region, and is disposed to overlap the photoelectric conversion region in a plan view,
   wherein the photoelectric conversion region on a side of the optical element has an uneven portion.
(20) The light detection device according to (19), wherein the optical element is a dielectric multilayer film color filter.
(21) The light detection device according to (19), wherein the optical element is a photonic crystal color filter.
(22) An electronic device including a light detection device and an optical system that forms an image based on image light from a subject on the light detection device, wherein the light detection device includes:
   a semiconductor layer that has a photoelectric conversion region which converts incident light into signal charges; and
   an optical element that has a plurality of layers of dielectric materials having different refractive indices, selects specific light according to a film thickness of the dielectric material, supplies the selected light to the photoelectric conversion region, and is disposed to overlap the photoelectric conversion region in a plan view, and
   the photoelectric conversion region on a side of the optical element has an uneven portion.

The scope of the present technology is not limited to the illustrated and described exemplary embodiments, but includes all embodiments that provide equivalent effects sought after with the present technology. In addition, the scope of the present technology is not limited to combinations of features of the invention defined by the claims, but can be defined by any desired combination of specific features among all disclosed features.

### [Reference Signs List]

1 Light detection device
2 Semiconductor chip
2A Pixel region
2B Peripheral region
3 Pixel
4 Vertical drive circuit
5 Column signal processing circuit
6 Horizontal drive circuit
7 Output circuit
8 Control circuit
10 Pixel drive line
11 Vertical signal line
12 Horizontal signal line
13 Logic circuit
15 Readout circuit
20 Semiconductor layer
20a Photoelectric conversion region
20b Isolation trench
21 Well region
22 Photoelectric conversion unit
24 Color filter
30 Multilayer wiring layer
31 Interlayer insulating film
32 Wiring layer
33 Support substrate
41 Pinning layer
42 Isolation region
42A, 42B, 42C Insulating film
43 Light blocking layer
44 Planarization film
45 Microlens
46 Interlayer insulating film
47 Color filter layer
47R, 47G, 47B, 47Ir Color filter
49 Light blocking wall
50, 50A Uneven portion
51 Concave portion
52a, 52b, 52c, 52d Slope
51A Groove
60, 60H, 60I, 60J, 60K Wire grid polarizer
60a, 60Da Aperture region
60b, 60Db Frame
60D Plasmon filter
60E GMR color filter
60F Dielectric multilayer film color filter
60G Photonic crystal color filter
61, 61D, 61E Base material
61F Waveguide mode resonance grating
61F1 Lower clad layer
61F2 Waveguide diffraction layer
61F3 Upper clad layer
61G High refractive medium
62, 62a, 62b, 62c, 62d, 62D, 62Da, 62Db, 62E Aperture arrangement
62F Color filter
63, 63D, 63Da, 63Db, 63E Aperture
63F Multilayer film
64 Strip conductor
64a Light reflection layer
64b Insulating layer
64c Light absorption layer
64d Protective layer
64E Diffraction grating
64F Lower mirror layer
65E Waveguide
65F Control layer
66F Upper mirror layer
80, 81, 82 Stacked metal film
100 Electronic device
101 Light detection device
102 Optical system
103 Shutter device
104 Drive circuit
105 Signal processing circuit
106 Incident light
481 First color filter
482 Second color filter
L1 Incident light
L2, L3 Reflected light

## Claims

1. A light detection device comprising:
a semiconductor layer that has a photoelectric conversion region which photoelectrically converts incident light; and
an optical element that has a metal film and an aperture arrangement formed in the metal film, selects specific light, supplies the selected light to the photoelectric conversion region, and is disposed to overlap the photoelectric conversion region in a plan view,
wherein the photoelectric conversion region on a side of the optical element has an uneven portion.

2. The light detection device according to claim 1, wherein the uneven portion has a surface oblique to a thickness direction of the semiconductor layer.

3. The light detection device according to claim 1, wherein the uneven portion has one concave portion having a surface oblique to a thickness direction of the semiconductor layer.

4. The light detection device according to claim 1, wherein the uneven portion has a plurality of concave portions each having a surface oblique to a thickness direction of the semiconductor layer.

5. The light detection device according to claim 1, wherein the uneven portion has a groove recessed in a thickness direction of the semiconductor layer.

6. The light detection device according to claim 1, further comprising an interlayer insulating film provided between the semiconductor layer and the optical element.

7. The light detection device according to claim 1, wherein the optical element is a wire grid polarizer.

8. The light detection device according to claim 7, further comprising a color filter that color-separates incident light and supplies the color-separated incident light to the wire grid polarizer,
wherein the color filter includes a first color filter that separates light with a first color and a second color filter that separates light with a second color, and
only the photoelectric conversion region that overlaps the first color filter of the photoelectric conversion regions that overlap either the first color filter or the second color filter in a plan view has the uneven portion.

9. The light detection device according to claim 1, wherein the optical element is a color filter using surface plasmon resonance.

10. The light detection device according to claim 1, wherein the optical element is a GMR color filter.

11. The light detection device according to claim 1, wherein a plurality of the photoelectric conversion regions disposed in an array in a plan view are provided, a light blocking wall partitioning the photoelectric conversion regions and made of a metal is provided,
the metal film of the optical element has an aperture region where the aperture arrangement is provided and a frame region between the aperture regions,
the aperture region is disposed at a position overlapping the photoelectric conversion region in a plan view,
the frame region is disposed at a position overlapping the light blocking wall in a plan view, and
the light blocking wall is connected to a surface of the frame region on a side of the semiconductor layer.

12. The light detection device according to claim 11, wherein the metal forming the light blocking wall and a metal of the metal film of the optical element are the same.

13. The light detection device according to claim 12, wherein the metal forming the light blocking wall and the metal film of the optical element are different parts of one stacked metal film.

14. The light detection device according to claim 11, wherein the metal forming the light blocking wall and a metal of the metal film of the optical element are different.

15. The light detection device according to claim 11, wherein the metal film of the optical element has a stacked structure of a first metal film and a second metal film which is formed of a metal different from a metal forming the first metal film and is located at a position closer to the semiconductor layer than the first metal film, and
the metal forming the light blocking wall and a metal of the second metal film are the same.

16. The light detection device according to claim 15, wherein the first metal film is stacked on the second metal film via an insulating film.

17. The light detection device according to claim 15, wherein the metal film of the optical element has a light blocking region which is disposed at a position overlapping some pixels of the plurality of photoelectric conversion regions in a plan view and does not have the aperture arrangement.

18. An electronic device comprising a light detection device and an optical system that forms an image based on image light from a subject on the light detection device,
wherein the light detection device includes:
a semiconductor layer that has a photoelectric conversion region which photoelectrically converts incident light; and
an optical element that has a metal film and an aperture arrangement formed in the metal film, selects specific light, supplies the selected light to the photoelectric conversion region, and is disposed to overlap the photoelectric conversion region in a plan view, and
the photoelectric conversion region on a side of the optical element has an uneven portion.

19. A light detection device comprising:
a semiconductor layer that has a photoelectric conversion region which converts incident light into signal charges; and
an optical element that has a plurality of layers of dielectric materials having different refractive indices, selects specific light according to a film thickness of the dielectric material, supplies the selected light to the photoelectric conversion region, and is disposed to overlap the photoelectric conversion region in a plan view,
wherein the photoelectric conversion region on a side of the optical element has an uneven portion.

20. The light detection device according to claim 19, wherein the optical element is a dielectric multilayer film color filter.

21. The light detection device according to claim 19, wherein the optical element is a photonic crystal color filter.

22. An electronic device comprising a light detection device and an optical system that forms an image based on image light from a subject on the light detection device,
wherein the light detection device includes:
a semiconductor layer that has a photoelectric conversion region which converts incident light into signal charges; and
an optical element that has a plurality of layers of dielectric materials having different refractive indices, selects specific light according to a film thickness of the dielectric material, supplies the selected light to the photoelectric conversion region, and is disposed to overlap the photoelectric conversion region in a plan view, and
the photoelectric conversion region on a side of the optical element has an uneven portion.
